# EUROPÄISCHE PATENTSCHRIFT

(11) **EP 3 174 890 B1**
(45) Veröffentlichungstag und Bekanntmachung des Hinweises auf die Patenterteilung: **13.03.2019**
(21) Anmeldenummer: 15734299.9
(22) Anmeldetag: 03.07.2015
(51) Int. Cl.: C07F 15/00, C09K 11/06, H01L 51/00, H01L 51/50, H05B 33/10

(54) **METALLKOMPLEXE**
METAL COMPLEXES
COMPLEXES MÉTALLIQUES

(30) Priorität: 28.07.2014 EP 14002623
(43) Veröffentlichungstag der Anmeldung: 07.06.2017
(73) Patentinhaber: Merck Patent GmbH, 64293 Darmstadt (DE)
(72) Erfinder: KOENEN, Nils, 64347 Griesheim (DE); STOESSEL, Philipp, 60389 Frankfurt am Main (DE); HAYER, Anna, 64293 Darmstadt (DE); HEIL, Holger, 60389 Frankfurt am Main (DE); HARBACH, Philipp, 64367 Muehltal (DE)
(86) Internationale Anmeldenummer: PCT/EP2015/001358
(87) Internationale Veröffentlichungsnummer: WO 2016/015815

(56) Entgegenhaltungen:
- EP-A1- 2 128 168
- WO-A2-2014/023377

## Beschreibung

Die vorliegende Erfindung betrifft Metallkomplexe sowie elektronische Vorrichtungen, insbesondere organische Elektrolumineszenzvorrichtungen, enthaltend diese Metallkomplexe.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Dabei werden als emittierende Materialien zunehmend metallorganische Komplexe eingesetzt, die Phosphoreszenz statt Fluoreszenz zeigen. Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, jedoch immer noch Verbesserungsbedarf, insbesondere im Hinblick auf Effizienz, Betriebsspannung und Lebensdauer.

Gemäß dem Stand der Technik werden in phosphoreszierenden OLEDs als Triplettemitter insbesondere Iridiumkomplexe eingesetzt, wie zum Beispiel Iridiumkomplexe, welche als Liganden Phenylpyridin-Derivate enthalten. Aus der WO 2008/078800 sind Phenylpyridin-Iridium-Komplexe, welche am Pyridinring mit einer Triazin- oder Pyrimidingruppe substituiert sind, bekannt. Mit derartigen Komplexen kann gelbe bis rote Emission erzielt werden. Es sind jedoch noch weitere Verbesserungen, insbesondere hinsichtlich Photolumineszenzquanteneffizienz, EQE in der Elektrolumineszenzvorrichtung, Löslichkeit der Komplexe und/oder der Emissionsfarbe und der Breite der Emissionsbande, wünschenswert. WO 2014/023377 betrifft Metallkomplexe sowie elektronische Vorrichtungen, insbesondere organische Elektrolumineszenzvorrichtungen, enthaltend diese Metallkomplexe.

Aufgabe der vorliegenden Erfindung ist daher die Bereitstellung neuer Metallkomplexe, welche sich als Emitter für die Verwendung in OLEDs eignen und dabei zu verbesserten Eigenschaften der OLED, insbesondere hinsichtlich Quanteneffizienz, Löslichkeit der Komplexe und/oder der Emissionsfarbe und der Breite der Emissionsbande führen.

Überraschend wurde gefunden, dass bestimmte, unten näher beschriebene Metallchelatkomplexe diese Aufgabe lösen und verbesserte Eigenschaften in organischen Elektrolumineszenzvorrichtung zeigen. Insbesondere zeigen diese Metallkomplexe höhere Photo- und Elektrolumineszenzquanteneffizienzen, bessere Löslichkeit und eine schmalere Emissionsbande und somit eine reinere Emissionsfarbe gegenüber den analogen Metallkomplexen, die keinen ankondensierten aliphatischen Cyclus enthalten. Diese Metallkomplexe und elektronische Vorrichtungen, insbesondere organische Elektrolumineszenzvorrichtungen, welche diese Komplexe enthalten, sind daher der Gegenstand der vorliegenden Erfindung. Gegenstand der Erfindung ist somit eine Verbindung gemäß Formel (1),

[Ir(L)ₙ(L')ₘ] Formel (1)

wobei die Verbindung der allgemeinen Formel (1) eine Teilstruktur Ir(L)ₙ der Formel (2) enthält: 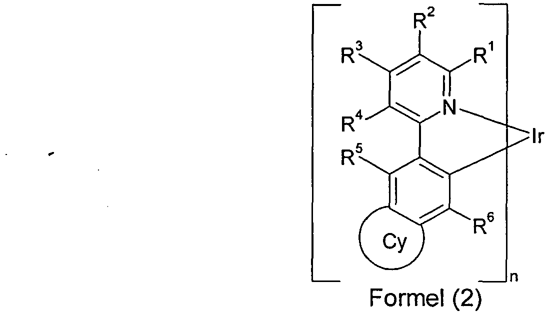 wobei für die verwendeten Symbole und Indizes gilt:
R² ist eine Gruppe der Formel -(Ar)ₚ-HetAr;
- HetAr: ist eine Gruppe der folgenden Formel (3), 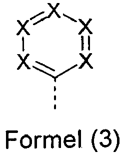 wobei die gestrichelte Bindung die Bindung an Ar bzw. für p = 0 die Bindung an die Pyridingruppe des Liganden andeutet;
- X: ist bei jedem Auftreten gleich oder verschieden CR oder N, mit der Maßgabe, dass mindestens eine und höchstens drei Gruppen X in Formel (3) für N stehen;
- Ar: ist bei jedem Auftreten gleich oder verschieden ein aromatisches oder heteroaromatisches Ringsystem mit 5 bis 30 aromatischen Ringatomen, das mit einem oder mehreren Resten R substituiert sein kann;
- p: ist bei jedem Auftreten gleich oder verschieden 0 oder 1;
- Cy: steht bei jedem Auftreten gleich oder verschieden für eine Gruppe der folgenden Formeln (4), (5), (6), (7), (8), (9) oder (10), 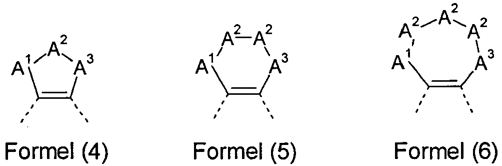 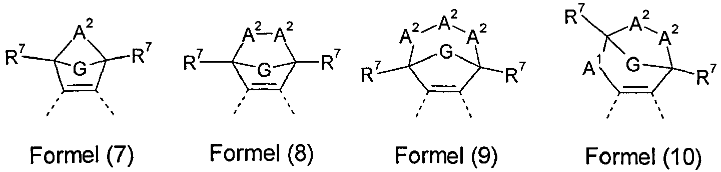 wobei die gestrichelten Bindungen die Verknüpfung der beiden Kohlenstoffatome im Liganden andeuten und weiterhin gilt:
A¹, A³ ist gleich oder verschieden bei jedem Auftreten C(R⁸)₂, O, S, NR⁸ oder C(=O);
A² ist C(R⁷)₂, O, S, NR⁸ oder C(=O);
G ist eine Alkylengruppe mit 1, 2 oder 3 C-Atomen, welche mit einem oder mehreren Resten R⁹ substituiert sein kann, -CR⁹=CR⁹- oder eine ortho-verknüpfte Arylen- oder Heteroarylengruppe mit 5 bis 14 aromatischen Ringatomen, welche durch einen oder mehrere Reste R⁹ substituiert sein kann;
mit der Maßgabe, dass in diesen Gruppen nicht zwei Heteroatome direkt aneinander gebunden sind und nicht zwei Gruppen C=O direkt aneinander gebunden sind;
- R, R¹, R³, R⁴, R⁵, R⁶, R⁷: ist bei jedem Auftreten gleich oder verschieden H, D, F, Cl, Br, I, N(R⁹)₂, CN, Si(R⁹)₃, B(OR⁹)₂, C(=O)R⁹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere nicht benachbarte CH₂-Gruppen durch R⁹C=CR⁹, Si(R⁹)₂, C=O, NR⁹, O, S oder CONR⁹ ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann; dabei können zwei benachbarte Reste R auch miteinander ein aliphatisches, aromatisches oder heteroaromatisches Ringsystem bilden; weiterhin können die Reste R⁴ und R⁵ auch miteinander ein aliphatisches, aromatisches oder heteroaromatisches Ringsystem bilden; weiterhin können die Reste R³ und R⁴ miteinander ein aliphatisches, aromatisches oder heteroaromatisches Ringsystem bilden, wenn die Gruppe R² für eine Gruppe der Formel -(Ar)ₚ-HetAr steht;
- R⁸: ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils mit einem oder mehreren Resten R⁹ substituiert sein kann, wobei eine oder mehrere nicht benachbarte CH₂-Gruppen durch R⁹C=CR⁹, C=C, Si(R⁹)₂, C=O, NR⁹, O, S oder CONR⁹ ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R⁹ substituiert sein kann, oder eine Aryloxy- oder Heteroaryloxygruppe mit 5 bis 24 aromatischen Ringatomen, die durch einen oder mehrere Reste R⁹ substituiert sein kann, oder eine Aralkyl- oder Heteroaralkylgruppe mit 5 bis 24 aromatischen Ringatomen, die durch einen oder mehrere Reste R⁹ substituiert sein kann; dabei können zwei Reste R⁸, welche an dasselbe Kohlenstoffatom gebunden sind, miteinander ein aliphatisches oder aromatisches Ringsystem bilden und so ein Spirosystem aufspannen; weiterhin kann R⁸ mit einem benachbarten Rest R⁷ ein aliphatisches Ringsystem bilden;
- R⁹: ist bei jedem Auftreten gleich oder verschieden H, D, F oder ein aliphatischer, aromatischer und/oder heteroaromatischer organischer Rest mit 1 bis 20 C-Atomen, insbesondere ein Kohlenwasserstoffrest, in dem auch ein oder mehrere H-Atome durch D oder F ersetzt sein können; dabei können zwei oder mehrere Substituenten R⁹ auch miteinander ein aliphatisches oder aromatisches Ringsystem bilden;
- L': ist gleich oder verschieden bei jedem Auftreten ein mono- oder bidentater Ligand;

- n: ist 1, 2 oder 3;
- m: ist 0, 1, 2, 3 oder 4.

Dabei werden die Indizes n und m so gewählt, dass die Koordinationszahl am Iridium insgesamt 6 entspricht. Dies ist insbesondere davon abhängig, wie viele Liganden L vorhanden sind und ob es sich bei den Liganden L' um mono- oder bidentate Liganden handelt.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N- oder O-Atom oder eine Carbonylgruppe, verbunden sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylengruppe oder durch eine Silylengruppe verbunden sind.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, tert-Pentyl, 2-Pentyl, neo-Pentyl, Cyclopentyl, n-Hexyl, s-Hexyl, tert-Hexyl, 2-Hexyl, 3-Hexyl, Cyclohexyl, 2-Methylpentyl, neo-Hexyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Die erfindungsgemäßen Komplexe können facial bzw. pseudofacial sein, oder sie können meridional bzw. pseudomeridional sein.

In einer bevorzugten Ausführungsform ist der Index n = 3, d. h. es handelt sich um einen homoleptischen Metallkomplex und der Index m = 0.

In einer weiteren bevorzugten Ausführungsform ist der Index n = 2 und m = 1, der erfindungsgemäße Komplex enthält zwei Liganden L und einen bidentaten Liganden L'. Dabei ist bevorzugt, wenn der Ligand L' ein Ligand ist, der über ein Kohlenstoffatom und ein Stickstoffatom, ein Kohlenstoffatom und ein Sauerstoffatom, zwei Sauerstoffatome, zwei Stickstoffatome oder ein Sauerstoff- und ein Stickstoffatom an das Iridium koordinieren.

In einer weiteren bevorzugten Ausführungsform ist der Index n = 1 und m = 2, und der erfindungsgemäße Komplex enthält einen Liganden L und zwei bidentate Liganden L'. Dies ist inbesondere dann bevorzugt, wenn der Ligand L' ein ortho-metallierter Ligand ist, der über ein Kohlenstoffatom und ein Stickstoffatom oder ein Kohlenstoffatom und ein Sauerstoffatom an das Iridium koordiniert.

Besonders bevorzugt sind homoleptische Metallkomplexe.

Bei den erfindungsgemäßen Verbindungen handelt es sich um Verbindungen, welche eine Teilstruktur der folgenden Formel (2a) enthalten, 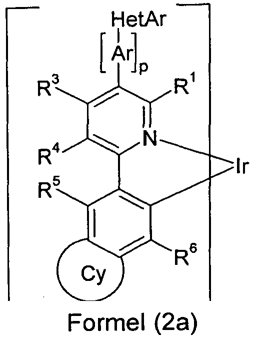 wobei die verwendeten Symbole und Indizes die oben genannten Bedeutungen aufweisen.

Bevorzugt ist die Teilstruktur der Formel (2a), welche die Gruppe -(Ar)ₚ-HetAr in meta-Position zum koordinierenden Stickstoffatom des Pyridinrings gebunden enthält.

Wenn p = 1 ist und die erfindungsgemäße Verbindung eine Gruppe Ar enthält, ist diese Gruppe Ar gleich oder verschieden bei jedem Auftreten bevorzugt ausgewählt aus einem aromatischen oder heteroaromatischen Ringsystem mit 5 bis 24 aromatischen Ringatomen, bevorzugt mit 6 bis 18 aromatischen Ringatomen, besonders bevorzugt Phenyl oder Biphenyl, wobei Ar jeweils mit einem oder mehreren Resten R substituiert sein kann bevorzugt aber unsubstituiert ist.

Bevorzugt ist der Index p = 0, und die Gruppe HetAr ist direkt an den Pyridinring gebunden.

Im Folgenden werden bevorzugte Gruppen HetAr beschrieben.

Bevorzugte Ausführungsformen der Gruppe HetAr sind die Gruppen der folgenden Formeln (3-1) bis (3-10), 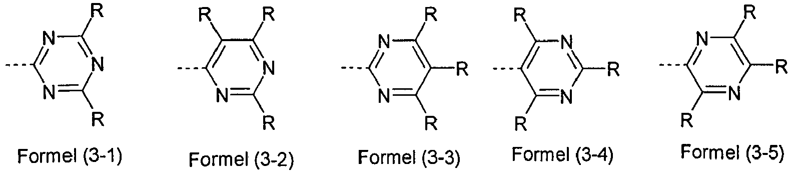 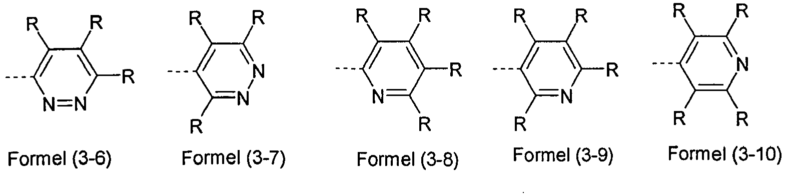 wobei die gestrichelte Bindung die Bindung dieser Gruppen an Ar oder für p = 0 an den Pyridinring darstellt und R die oben genannten Bedeutungen aufweist.

Bevorzugt sind die Gruppen der Formeln (3-1) bis (3-3) und besonders bevorzugt ist die Gruppe der Formel (3-1).

Bevorzugte Ausführungsformen der oben genannten Gruppen sind die Gruppen der folgenden Formeln (3-1a) bis (3-10a), 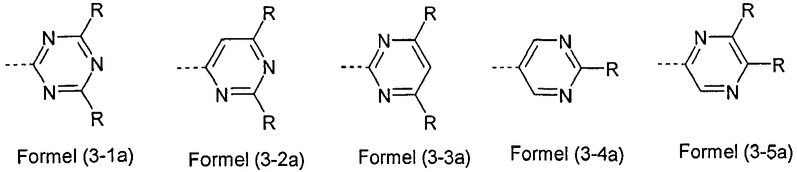 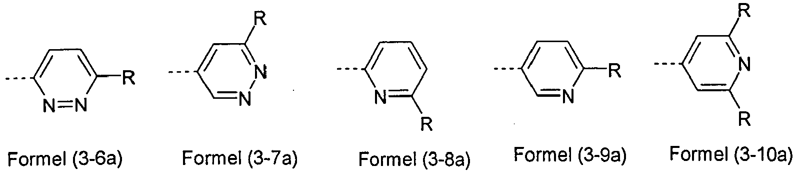 wobei die gestrichelte Bindung die Bindung dieser Gruppen an Ar oder für p = 0 an den Pyridinring darstellt und R einen Substituenten gemäß der oben genannten Definition ungleich Wasserstoff darstellt.

Der Substituent R an der Gruppe HetAr ist bevorzugt gleich oder verschieden bei jedem Auftreten H oder ein aromatisches oder heteroaromatisches Ringsystem mit 6 bis 24 aromatischen Ringatomen, das durch einen oder mehrere Reste R⁹ substituiert sein kann. Dabei ist R in den Gruppen der Formeln (3-1a) bis (3-10a) ungleich Wasserstoff. Das aromatische oder heteroaromatische Ringsystem hat bevorzugt 6 bis 18 aromatische Ringatome. Besonders bevorzugt handelt es sich um ein aromatisches Ringsystem mit 6 bis 12 aromatischen Ringatomen bzw. ein heteroaromatisches Ringsystem mit 6 bis 13 aromatischen Ringatomen, das jeweils durch einen oder mehrere Reste R⁹ substituiert sein kann, bevorzugt aber unsubstituiert ist. Beispiele für geeignete Gruppen R sind ausgewählt aus der Gruppe bestehend aus Phenyl, Biphenyl, insbesondere ortho-, meta- oder para-Biphenyl, Terphenyl, insbesondere verzweigtes Terphenyl, Quaterphenyl, insbesondere verzweigtes Quaterphenyl, 1-, 2-, 3- oder 4-Fluorenyl, 1-, 2-, 3- oder 4-Spirobifluorenyl, Pyridyl, Pyrimidinyl, 1-, 2-, 3- oder 4-Dibenzofuranyl, 1-, 2-, 3- oder 4-Dibenzothienyl und 1-, 2-, 3- oder 4-Carbazolyl, die jeweils durch einen oder mehrere Reste R⁹ substituiert sein können, bevorzugt aber unsubstituiert sind.

Beispiele für geeignete Gruppen R sind die im Folgenden aufgeführten Strukturen R-1 bis R-15, 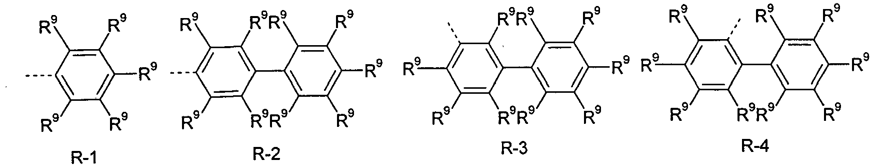 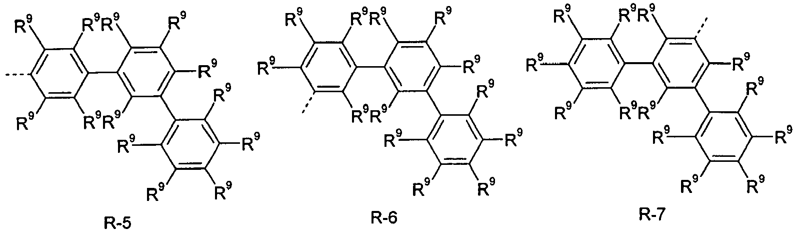 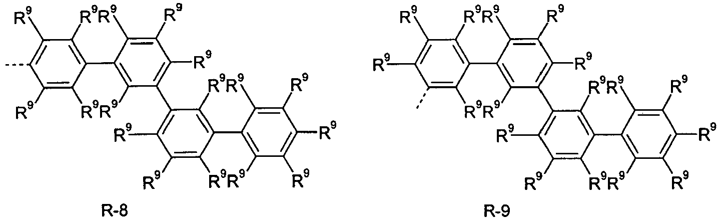 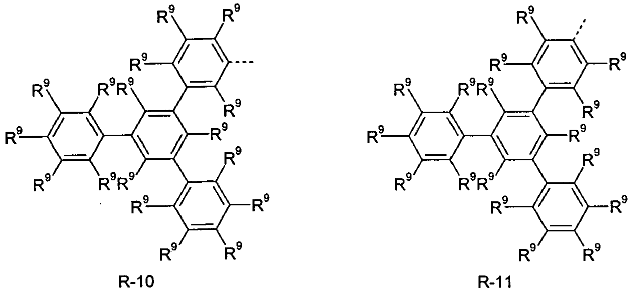 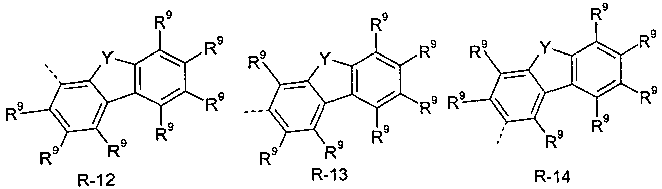 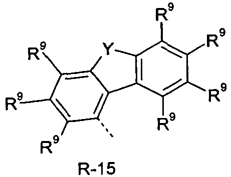 wobei Y für C(R⁹)₂, NR⁹, O oder S steht, R⁹ die oben genannten Bedeutungen aufweist und die gestrichelte Bindung die Bindung an HetAr darstellt.

Im Folgenden werden bevorzugte Ausführungsformen der Gruppe Cy beschrieben. Wie oben bereits beschrieben, stellt die Gruppe Cy eine Gruppe gemäß einer der Formeln (4) bis (10) dar. In den oben abgebildeten Strukturen der Formeln (4) bis (10) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, da diese beiden Kohlenstoffatome in ein aromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wesentlich bei den Gruppen der Formeln (4) bis (10) ist, dass diese keine aziden benzylischen Protonen aufweisen. Unter benzylischen Protonen werden Protonen verstanden, die an ein Kohlenstoffatom binden, welches direkt an den Liganden gebunden ist. Die Abwesenheit von aziden benzylischen Protonen wird in den Formeln (4) bis (6) dadurch erreicht, dass A¹ und A³, wenn diese für C(R⁸)₂ stehen, so definiert sind, dass R⁸ ungleich Wasserstoff ist. Die Abwesenheit von aziden benzylischen Protonen ist in Formeln (7) bis (10) dadurch erreicht, dass es sich dabei um eine bicyclische Struktur handelt. Aufgrund der starren räumlichen Anordnung ist R⁷, wenn es für H steht, deutlich weniger azide als benzylische Protonen, da das korrespondierende Anion der bicyclischen Struktur nicht mesomeriestabilisiert ist. Auch wenn R⁷ in Formeln (7) bis (10) für H steht, handelt es sich dabei daher um ein nicht-azides Proton im Sinne der vorliegenden Anmeldung.

In einer bevorzugten Ausführungsform der Struktur gemäß Formel (4) bis (10) steht maximal eine der Gruppen A¹, A² und A³ für ein Heteroatom, insbesondere für O oder NR⁸, und die anderen Gruppen stehen für C(R⁸)₂ bzw. C(R⁷)₂ oder A¹ und A³ stehen gleich oder verschieden bei jedem Auftreten für O oder NR⁸ und A² steht für C(R⁷)₂. In einer besonders bevorzugten Ausführungsform der Erfindung stehen A¹ und A³ gleich oder verschieden bei jedem Auftreten für C(R⁸)₂ und A² steht für C(R⁷)₂ und besonders bevorzugt für C(R⁸)₂ oder CH₂.

Bevorzugte Ausführungsformen der Formel (4) sind somit die Strukturen der Formel (4-A), (4-B), (4-C) und (4-D), und eine besonders bevorzugte Ausführungsform der Formel (4-A) sind die Strukturen der Formel (4-E) und (4-F), 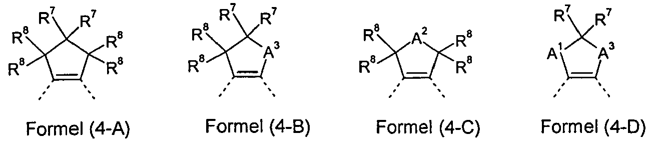 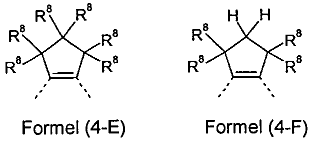 wobei R⁷ und R⁸ die oben genannten Bedeutungen aufweisen und A¹, A² und A³ gleich oder verschieden bei jedem Auftreten für O oder NR⁸ steht.

Bevorzugte Ausführungsformen der Formel (5) sind die Strukturen der folgenden Formeln (5-A) bis (5-F), 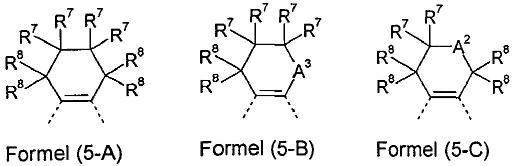 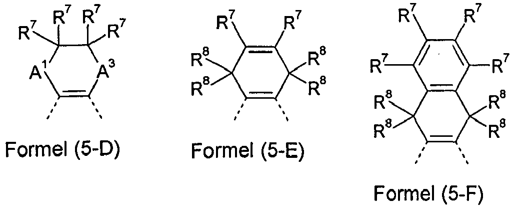 wobei R⁷ und R⁸ die oben genannten Bedeutungen aufweisen und A¹, A² und A³ gleich oder verschieden bei jedem Auftreten für O oder NR⁸ steht.

Bevorzugte Ausführungsformen der Formel (6) sind die Strukturen der folgenden Formeln (6-A) bis (6-E), 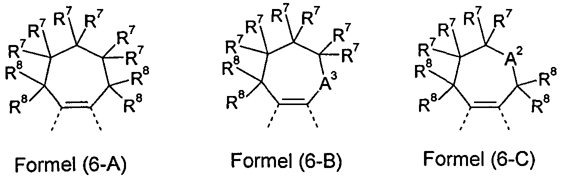 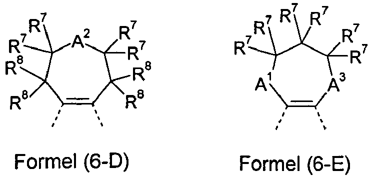 wobei R⁷ und R⁸ die oben genannten Bedeutungen aufweisen und A¹, A² und A³ gleich oder verschieden bei jedem Auftreten für O oder NR⁸ steht.

In einer bevorzugten Ausführungsform der Struktur gemäß Formel (7) stehen die Reste R⁷, die an den Brückenkopf gebunden sind, für H, D, F oder CH₃. Weiterhin bevorzugt steht A² für C(R⁷)₂ oder O, und besonders bevorzugt für C(R⁸)₂. Bevorzugte Ausführungsformen der Formel (7) sind somit eine Strukturen der Formel (7-A) und (7-B), und eine besonders bevorzugte Ausführungsform der Formel (7-A) ist eine Struktur der Formel (7-C), 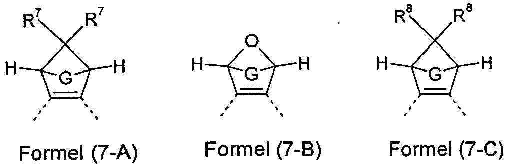 wobei die verwendeten Symbole die oben genannten Bedeutungen aufweisen.

In einer bevorzugten Ausführungsform der Struktur gemäß Formel (8), (9) und (10) stehen die Reste R⁷, die an den Brückenkopf gebunden sind, für H, D, F oder CH₃. Weiterhin bevorzugt steht A² für C(R⁷)₂. Bevorzugte Ausführungsformen der Formel (8), (9) und (10) sind somit die Strukturen der Formeln (8-A), (9-A) und (10-A), 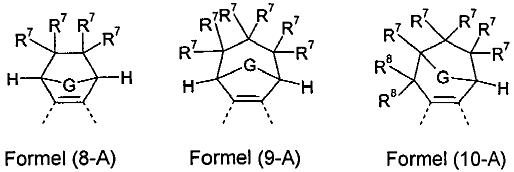 wobei die verwendeten Symbole die oben genannten Bedeutungen aufweisen.

Weiterhin bevorzugt steht die Gruppe G in den Formeln (7), (7-A), (7-B), (7-C), (8), (8-A), (9), (9-A), (10) und (10-A) für eine 1,2-Ethylengruppe, welche mit einem oder mehreren Resten R⁹ substituiert sein kann, wobei R⁹ bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R⁹ substituiert sein kann, bevorzugt aber unsubstituiert ist, insbesondere eine ortho-Phenylengruppe, welche mit einem oder mehreren Resten R⁹ substituiert sein kann, bevorzugt aber unsubstituiert ist.

In einer weiteren bevorzugten Ausführungsform der Erfindung steht R⁸ in den Gruppen der Formel (4) bis (10) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 10 C-Atomen, wobei jeweils eine oder mehrere nicht benachbarte CH₂-Gruppen durch R⁹C=CR⁹ ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R⁹ substituiert sein kann; dabei können zwei Reste R⁸, welche an dasselbe Kohlenstoffatom gebunden sind, miteinander ein aliphatisches oder aromatisches Ringsystem bilden und so ein Spirosystem aufspannen; weiterhin kann R⁸ mit einem benachbarten Rest R⁷ ein aliphatisches Ringsystem bilden.

In einer besonders bevorzugten Ausführungsform der Erfindung steht R⁸ in den Gruppen der Formeln (4) bis (10) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R⁹ substituiert sein kann, bevorzugt aber unsubstituiert ist; dabei können zwei Reste R⁸, welche an dasselbe Kohlenstoffatom gebunden sind, miteinander ein aliphatisches oder aromatisches Ringsystem bilden und so ein Spirosystem aufspannen; weiterhin kann R⁸ mit einem benachbarten Rest R⁷ ein aliphatisches Ringsystem bilden.

Beispiele für besonders geeignete Gruppen der Formel (4) sind die im Folgenden aufgeführten Gruppen (4-1) bis (4-70):

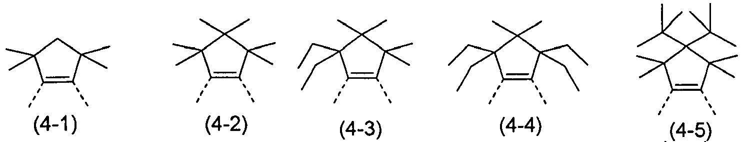

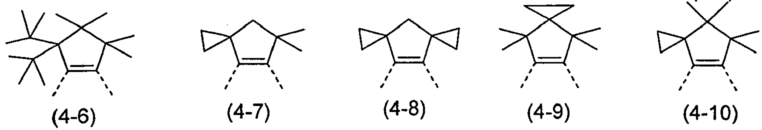

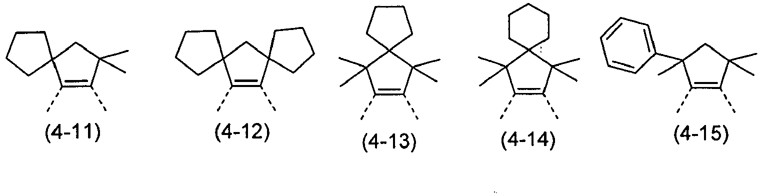

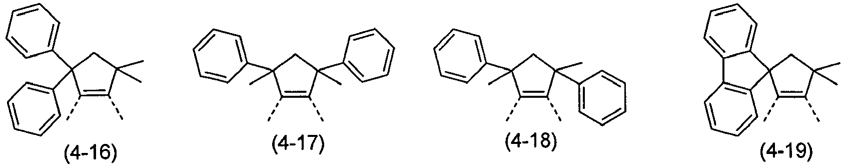

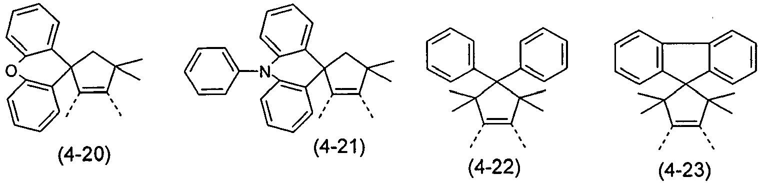

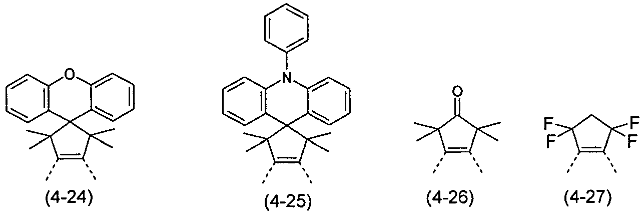

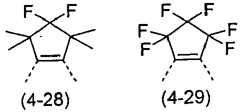

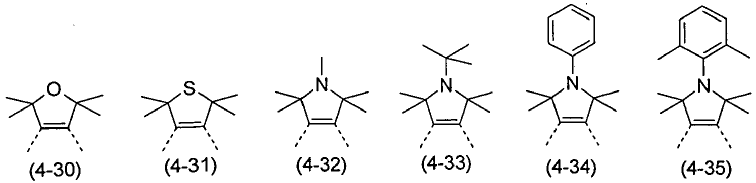

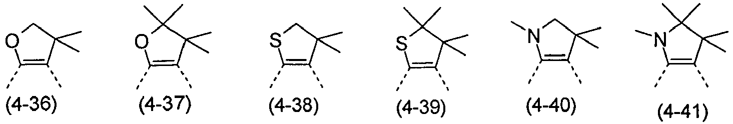

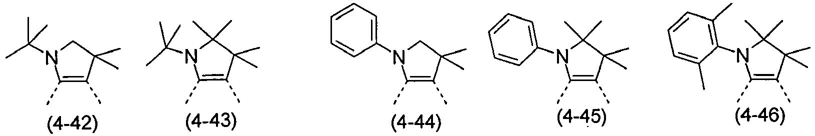

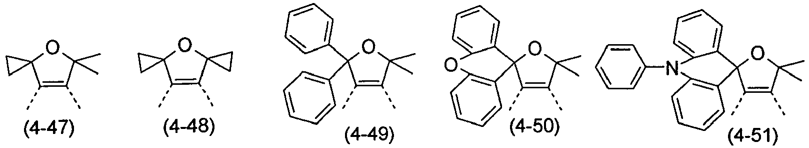

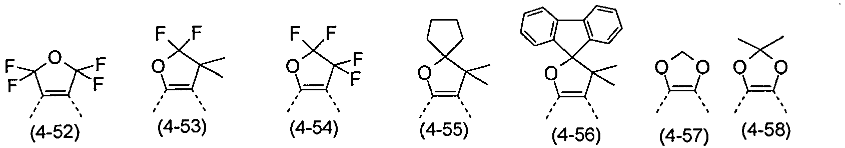

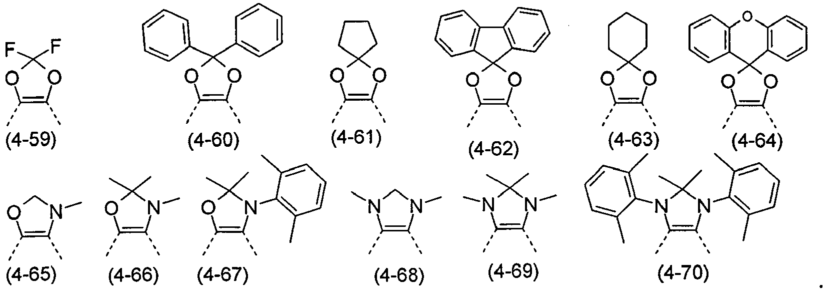

Beispiele für besonders geeignete Gruppen der Formel (5) sind die im Folgenden aufgeführten Gruppen (5-1) bis (5-14):

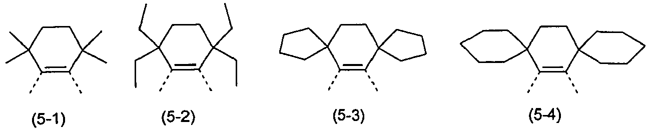

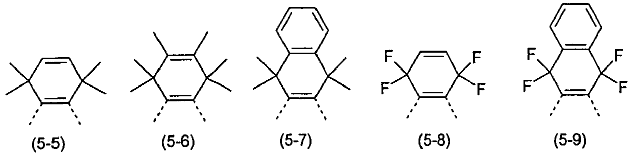

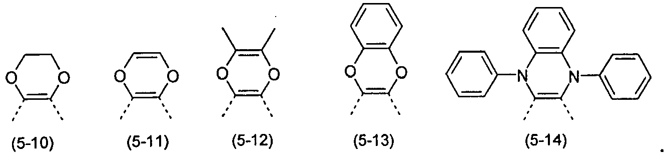

Beispiele für besonders geeignete Gruppen der Formel (6), (9) und (10) sind die im Folgenden aufgeführten Gruppen (6-1), (9-1) und (10-1):

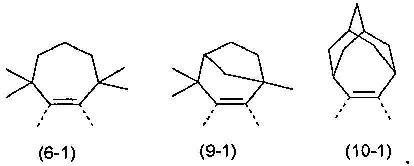

Beispiele für besonders geeignete Gruppen der Formel (7) sind die im Folgenden aufgeführten Gruppen (7-1) bis (7-22):

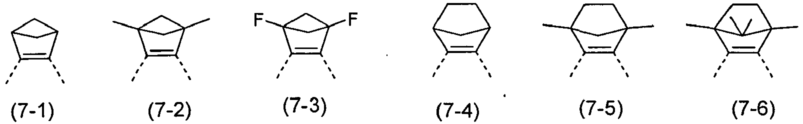

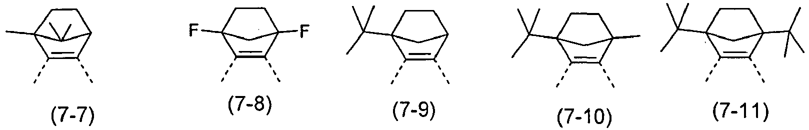

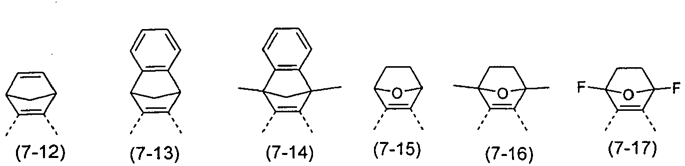

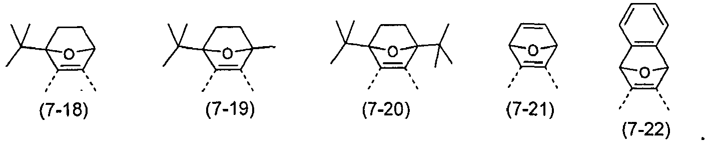

Beispiele für besonders geeignete Gruppen der Formel (8) sind die im Folgenden aufgeführten Gruppen (8-1) bis (8-6):

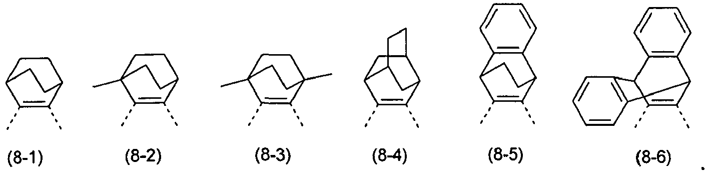

Insbesondere die Verwendung derartiger ankondensierter bicyclischer Strukturen kann aufgrund der Chiralität der Strukturen auch zu chiralen Liganden L führen. Hier kann sowohl die Verwendung enantiomerenreiner Liganden wie auch die Verwendung des Racemats geeignet sein. Es kann auch insbesondere geeignet sein, im erfindungsgemäßen Metallkomplex nicht nur ein Enantiomer von einem Liganden zu verwenden, sondern gezielt beide Enantiomere, so dass beispielsweise ein Komplex (+L)₂(-L)M oder ein Komplex (+L)(-L)₂M entsteht, wobei +L bzw. -L jeweils das entsprechende + bzw - Enantiomer des Liganden kennzeichnen. Dies kann Vorteile bezüglich der Löslichkeit des entsprechenden Komplexes gegenüber Komplexen, die nur +L oder nur -L als Ligand enthalten, haben. Wenn in der Teilstruktur der Fornel (2) noch Reste R¹ und R³ bis R⁶ gebunden sind, so sind diese Reste bei jedem Auftreten gleich oder verschieden bevorzugt ausgewählt aus der Gruppe bestehend aus H, D, F, N(R⁹)₂, CN, Si(R⁹)₃, C(=O)R⁹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R⁹ substituiert sein kann, wobei ein oder mehrere

H-Atome durch D oder F ersetzt sein können, oder einem aromatischen oder heteroaromatischen Ringsystem mit 5 bis 24 aromatischen Ringatomen, das jeweils durch einen oder mehrere Reste R⁹ substituiert sein kann; dabei können die Reste R⁴ und R⁵ bis auch miteinander ein aliphatisches oder aromatisches Ringsystem bilden. Besonders bevorzugt sind diese Reste R¹ und R³ bis R⁶ bei jedem Auftreten gleich oder verschieden ausgewählt aus der Gruppe bestehend aus H, D, F, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch F ersetzt sein können, oder einem aromatischen oder heteroaromatischen Ringsystem mit 5 bis 18 aromatischen Ringatomen, das jeweils durch einen oder mehrere Reste R⁹ substituiert sein kann; dabei können die Reste R⁴ und R⁵ bis auch miteinander ein aliphatisches oder aromatisches Ringsystem bilden. Wenn es sich bei den Resten R¹ und R³ bis R⁶ um ein aromatisches oder heteroaromatisches Ringsystem handelt, ist es bevorzugt, wenn dieses nicht mehr als zwei direkt aneinander ankondensierte aromatische 6-Ringe aufweist, insbesondere überhaupt keine direkt aneinander ankondensierten aromatischen 6-Ringe.

In einer bevorzugten Ausführungsform der Erfindung stehen die Substituenten R¹ und R³ und R⁶ gleich oder verschieden bei jedem Auftreten für H, D, F oder Methyl, insbesondere für H. Dies gilt insbesondere, wenn es sich um faciale, homoleptische Komplexe handelt, während bei meridionalen oder heteroleptischen Komplexen auch andere Reste R¹ bzw. R⁶ bevorzugt sein können.

In einer besonders bevorzugten Ausführungsform der Erfindung stehen alle Substituenten R¹ und R³ bis R⁶ in Formel (2), für H. Im Folgenden werden bevorzugte Liganden L' beschrieben, wie sie Verbindungen der Formel (1) vorkommen können. Die Liganden L' sind definitionsgemäß mono- oder bidentate Liganden. Die Liganden L' sind bevorzugt neutrale, monoanionische, dianionische oder trianionische Liganden, besonders bevorzugt neutrale oder monoanionische Liganden. Bevorzugt sind bidentate monoanionische Liganden L'.

Bevorzugte neutrale, monodentate Liganden L' sind ausgewählt aus Kohlenmonoxid, Stickstoffmonoxid, Alkylcyaniden, wie z. B. Acetonitril, Arylcyaniden, wie z. B. Benzonitril, Alkylisocyaniden, wie z. B. Methylisonitril, Arylisocyaniden, wie z. B. Benzoisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden L'sind ausgewählt aus Hydrid, Deuterid, den Halogeniden F⁻, Cl⁻, Br⁻ und I⁻, Alkylacetyliden, wie z. B. Methyl-C≡C⁻, tert-Butyl-C≡C⁻, Arylacetyliden, wie z. B. Phenyl-C≡C⁻, Cyanid, Cyanat, Isocyanat, Thiocyanat, Isothiocyanat, aliphatischen oder aromatischen Alkoholaten, wie z. B. Methanolat, Ethanolat, Propanolat, iso-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert.

Bevorzugte di- bzw. trianionische Liganden sind O²⁻, S²⁻, Carbide, welche zu einer Koordination der Form R-C≡M führen, und Nitrene, welche zu einer Koordination der Form R-N=M führen, wobei R allgemein für einen Substituenten steht, und N³⁻.

Bevorzugte neutrale oder mono- oder dianionische, bidentate oder höherdentate Liganden L' sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[1-(Phenylimino)ethyl]pyridin, 2-[1-(2-Methylphenylimino)ethyl]pyridin, 2-[1-(2,6-Di-*iso*-propylphenylimino)ethyl]pyridin, 2-[1-(Methylimino)ethyl]pyridin, 2-[1-(ethylimino)ethyl]pyridin, 2-[1-(*Iso*-Propylimino)ethyl]pyridin, 2-[1-(*Tert-*Butylimino)ethyl]pyridin, Diminen, wie z. B. 1,2-Bis(methylimino)ethan, 1,2-Bis(ethylimino)ethan, 1,2-Bis(*iso*-propylimino)ethan, 1,2-Bis(*tert*-butyl-imino)ethan, 2,3-Bis(methylimino)butan, 2,3-Bis(ethylimino)butan, 2,3-Bis-(*iso*-propylimino)butan, 2,3-Bis(*tert*-butylimino)butan, 1,2-Bis(phenylimino)-ethan, 1,2-Bis(2-methylphenylimino)ethan, 1,2-Bis(2,6-di-*iso*-propylphenyl-imino)ethan, 1,2-Bis(2,6-di-*tert*-butylphenylimino)ethan, 2,3-Bis(phenyl-imino)butan, 2,3-Bis(2-methylphenylimino)butan, 2,3-Bis(2,6-di-*iso*-propyl-phenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenylphosphino)ethan, Bis(diphenylphosphino)propan, Bis(diphenyl-phosphino)butan, Bis(dimethylphosphino)methan, Bis(dimethylphosphino)-ethan, Bis(dimethylphosphino)propan, Bis(diethylphosphino)methan, Bis-(diethylphosphino)ethan, Bis(diethylphosphino)propan, Bis(di-*tert*-butyl-phosphino)methan, Bis(di-*tert*-butylphosphino)ethan, Bis(*tert*-butyl-phosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 2,2,6,6-Tetramethyl-3,5-heptandion, 3-Ketonaten abgeleitet von 3-Ketoestern, wie z. B. Acetylacetat, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

In einer weiteren bevorzugten Ausführungsform der Erfindung handelt es sich bei den Liganden L' um bidentate monoanionische Liganden, welche mit dem Iridium einen cyclometallierten Fünfring oder Sechsring mit mindestens einer Iridium-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (11) bis (38) dargestellt sind, wobei eine Gruppe über ein neutrales Atom und die andere Gruppe über ein negativ geladenes Atom bindet. Dabei ist das neutrale Atom insbesondere ein neutrales Stickstoffatom oder ein Carben-Kohlenstoffatom und das negativ geladene Atom insbesondere ein negativ geladenes Kohlenstoffatom, ein negativ geladenes Stickstoffatom oder ein negativ geladenes Sauerstoffatom. Der Ligand L' kann dann aus den Gruppen der Formeln (11) bis (38) gebildet werden, indem diese Gruppen jeweils an der durch # gekennzeichneten Position aneinander binden. Die Position, an der die Gruppen an das Metall koordinieren, sind durch * gekennzeichnet. Weiterhin können hier auch zwei benachbarte Reste R, die jeweils an den beiden Gruppen der Formeln (11) bis (38) gebunden sind, miteinander ein aliphatisches oder aromatisches Ringsystem bilden.

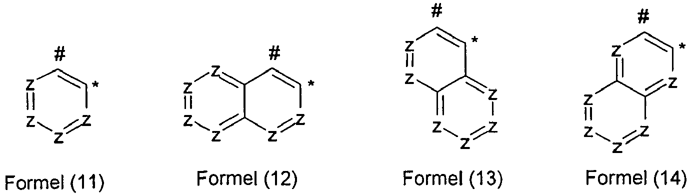

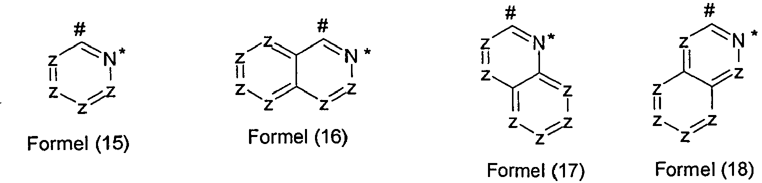

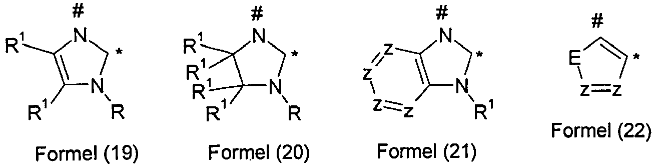

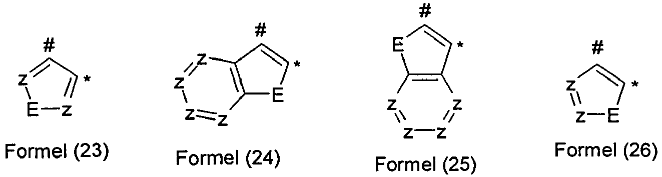

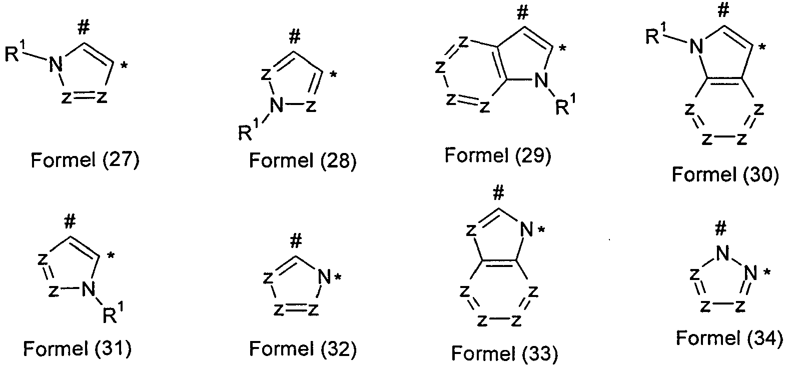

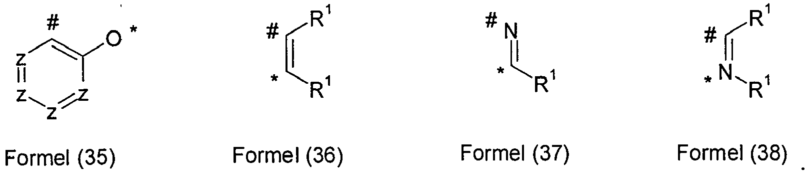

Dabei hat R¹ dieselbe Bedeutung wie oben beschrieben, Z steht gleich oder verschieden bei jedem Auftreten für CR¹ oder N, E steht für O, S oder CR₂, und bevorzugt stehen maximal zwei Symbole Z in jeder Gruppe für N, besonders bevorzugt steht maximal ein Symbol Z in jeder Gruppe für N. Ganz besonders bevorzugt stehen alle Symbole Z gleich oder verschieden bei jedem Auftreten für CR¹.

In einer ganz besonders bevorzugten Ausführungsform der Erfindung handelt es sich bei dem Liganden L' um einen monoanionischen bidentaten Liganden, der aus zwei der Gruppen der Formel (11) bis (38) gebildet wird, wobei eine dieser Gruppen über ein negativ geladenes Kohlenstoffatom und die andere dieser Gruppen über ein neutrales Stickstoffatom an das Iridium koordiniert.

Ebenfalls kann es bevorzugt sein, wenn zwei benachbarte Symbole Z in diesen Liganden für eine Gruppe gemäß einer der oben genannten Formeln (4) bis (10) stehen.

Die weiteren bevorzugten Reste R¹ in den oben aufgeführten Strukturen sind definiert wie die Reste R¹ bis R⁶ des Liganden L.

Beispiele für geeignete Co-Liganden sind in der folgenden Tabelle abgebildet:

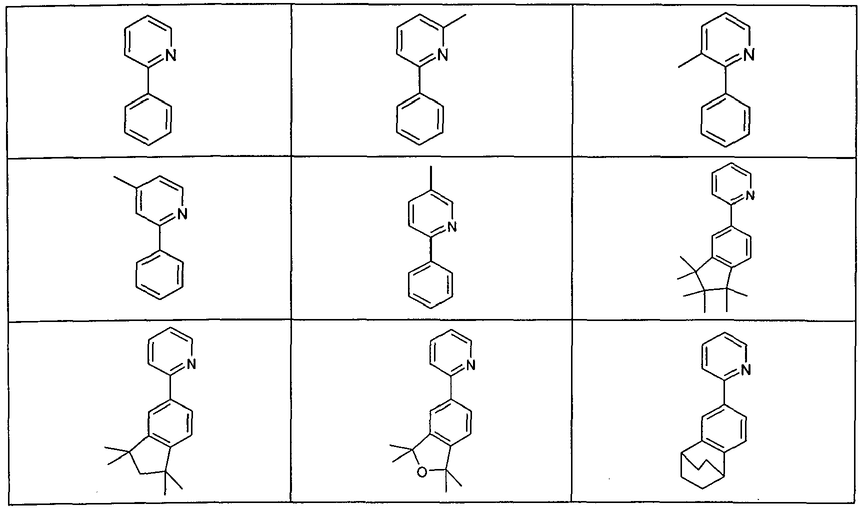

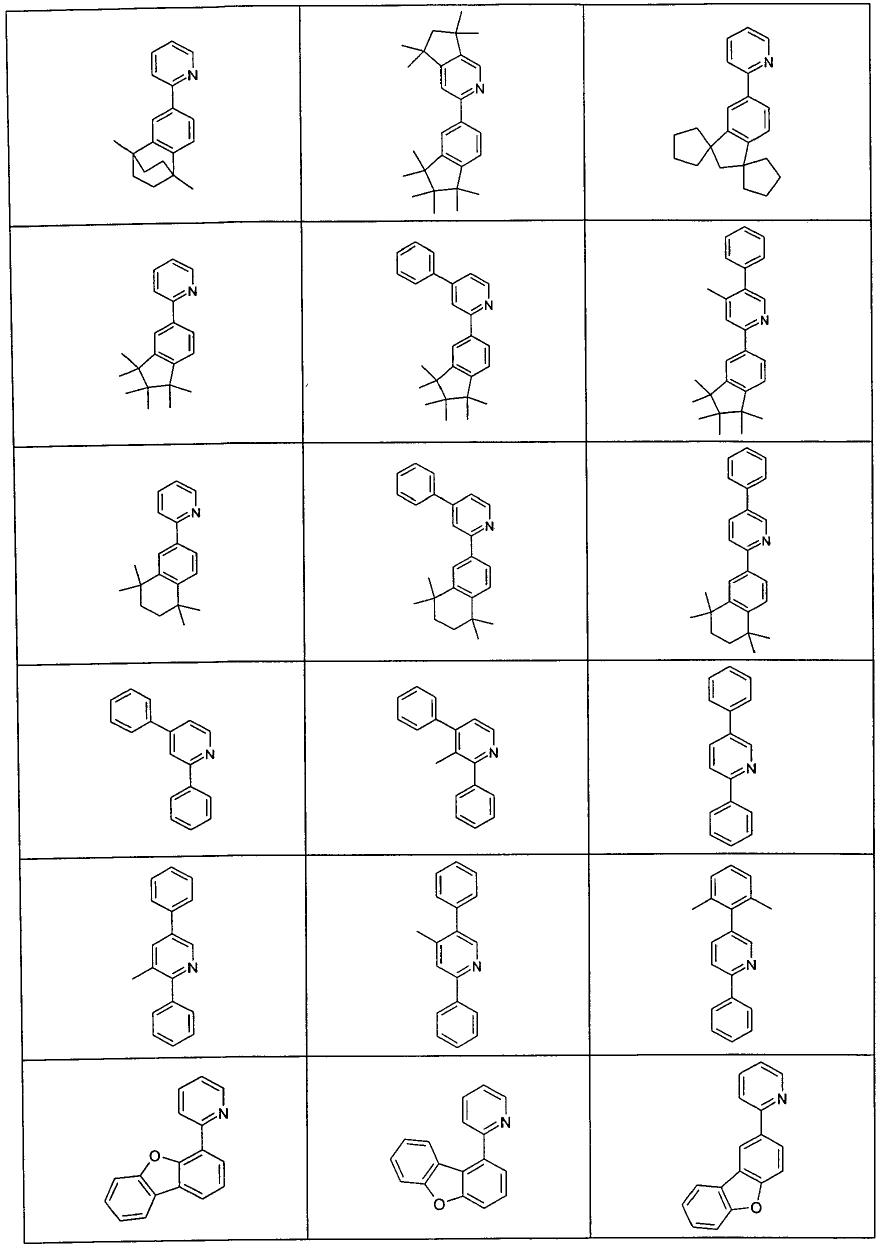

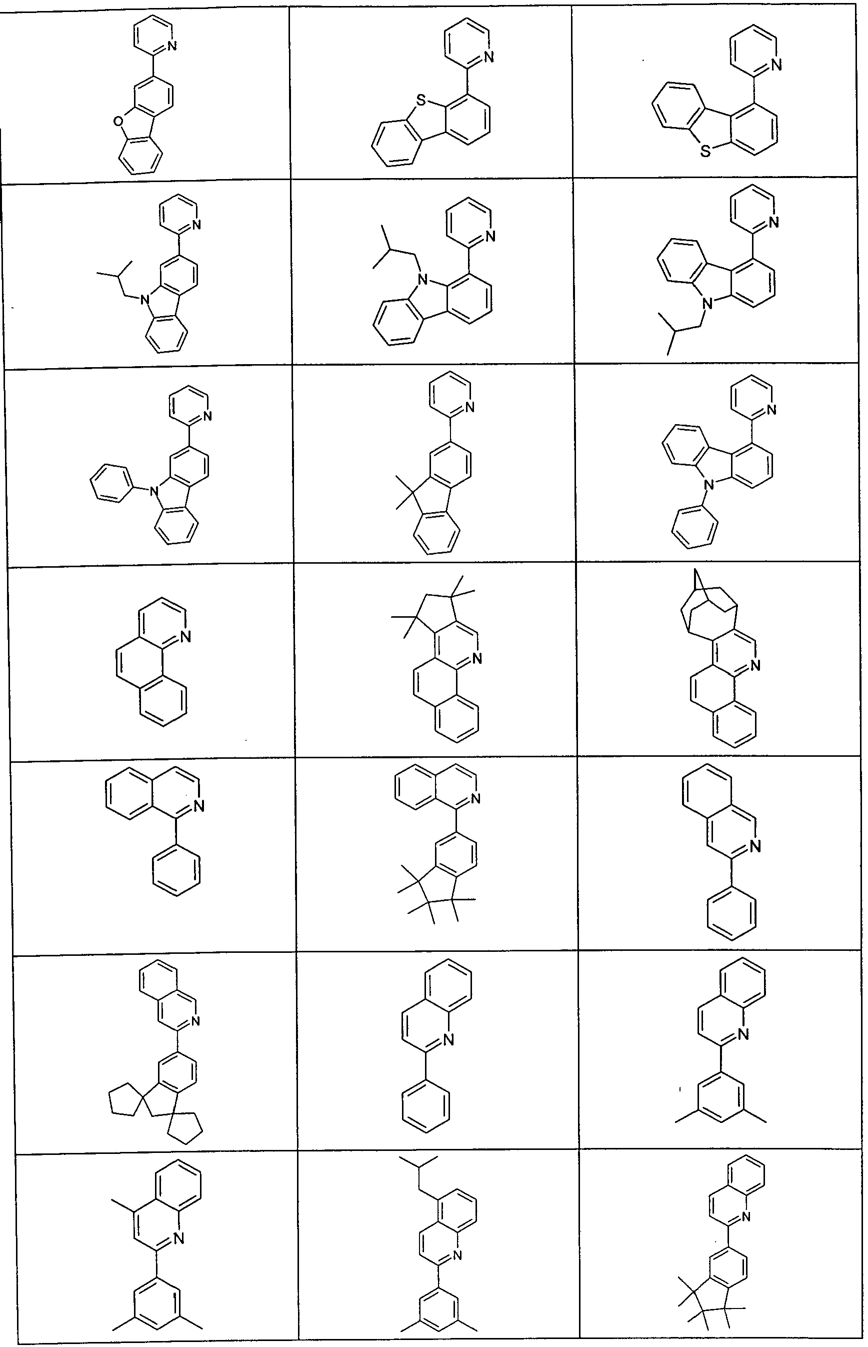

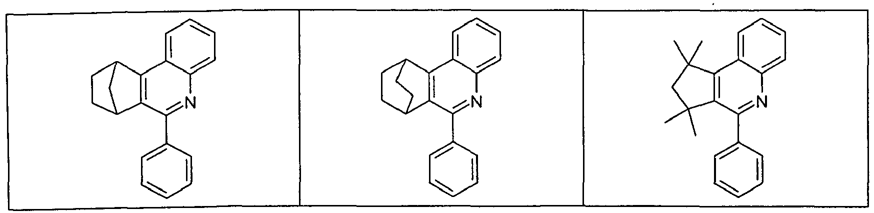

Die Liganden L und L' können je nach Struktur auch chiral sein. Dies ist insbesondere dann der Fall, wenn sie eine bicyclische Gruppe der Formel (7) bis (10) enthalten oder wenn sie Substituenten enthalten, beispielsweise Alkyl-, Alkoxy, Dialkylamino- oder Aralkylgruppen, welche ein oder mehrere Stereozentren aufweisen. Da es sich bei der Grundstruktur des Komplexes auch um eine chirale Struktur handeln kann, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte'Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln bei Raumtemperatur in ausreichender Konzentration löslich, um die Komplexe aus Lösung verarbeiten zu können, beispielsweise durch Druckverfahren.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die Verbindungen können auch als chirale, enantiomerenreine Komplexe eingesetzt werden, welche circular polarisiertes Licht emittieren können. Dies kann Vorteile aufweisen, da dadurch der Polarisationsfilter auf dem Device eingespart werden kann. Außerdem eignen sich solche Komplexe auch zur Verwendung in Sicherheitslabeln, da sie neben der Emission auch die Polarisation des Lichts als einfach auslesbares Merkmal aufweisen.

Beispiele für erfindungsgemäße Verbindungen sind die in der folgenden Tabelle aufgeführten Strukturen.

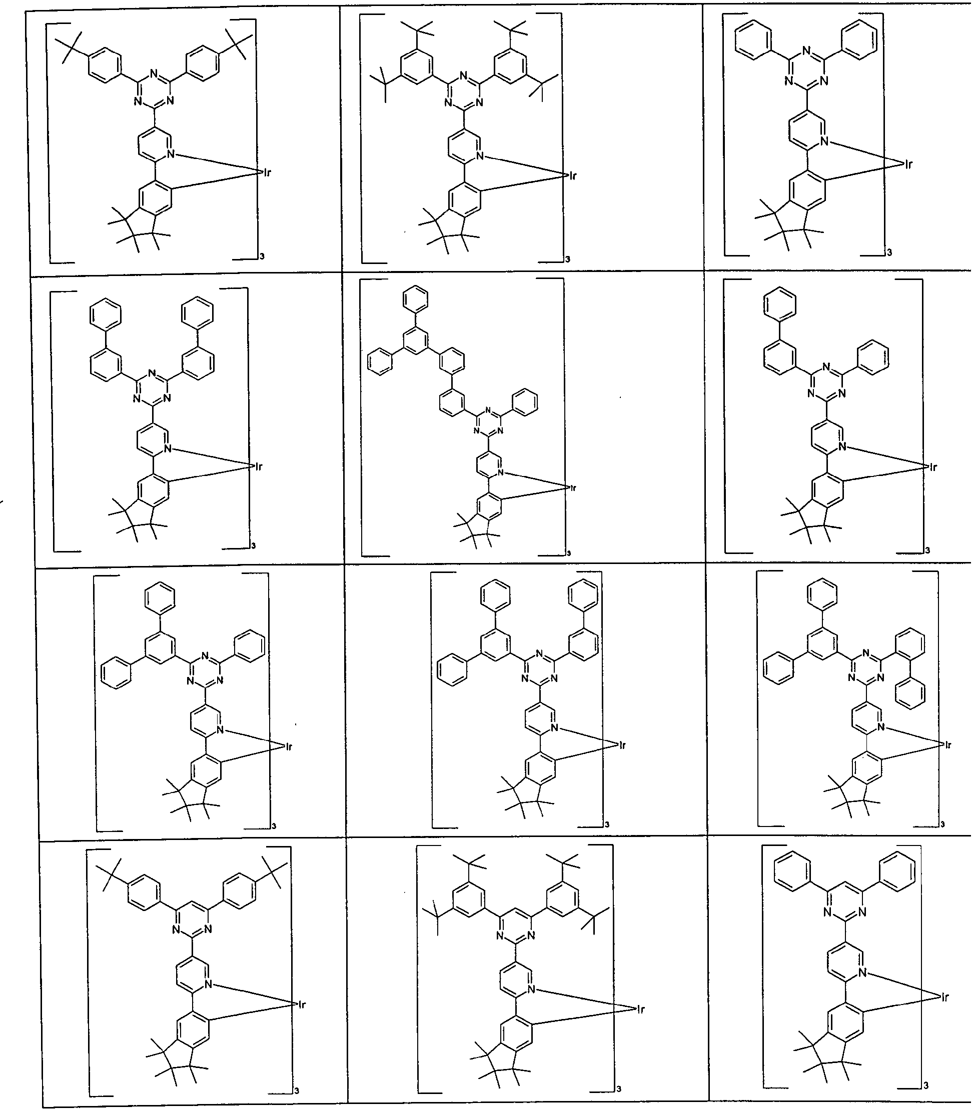

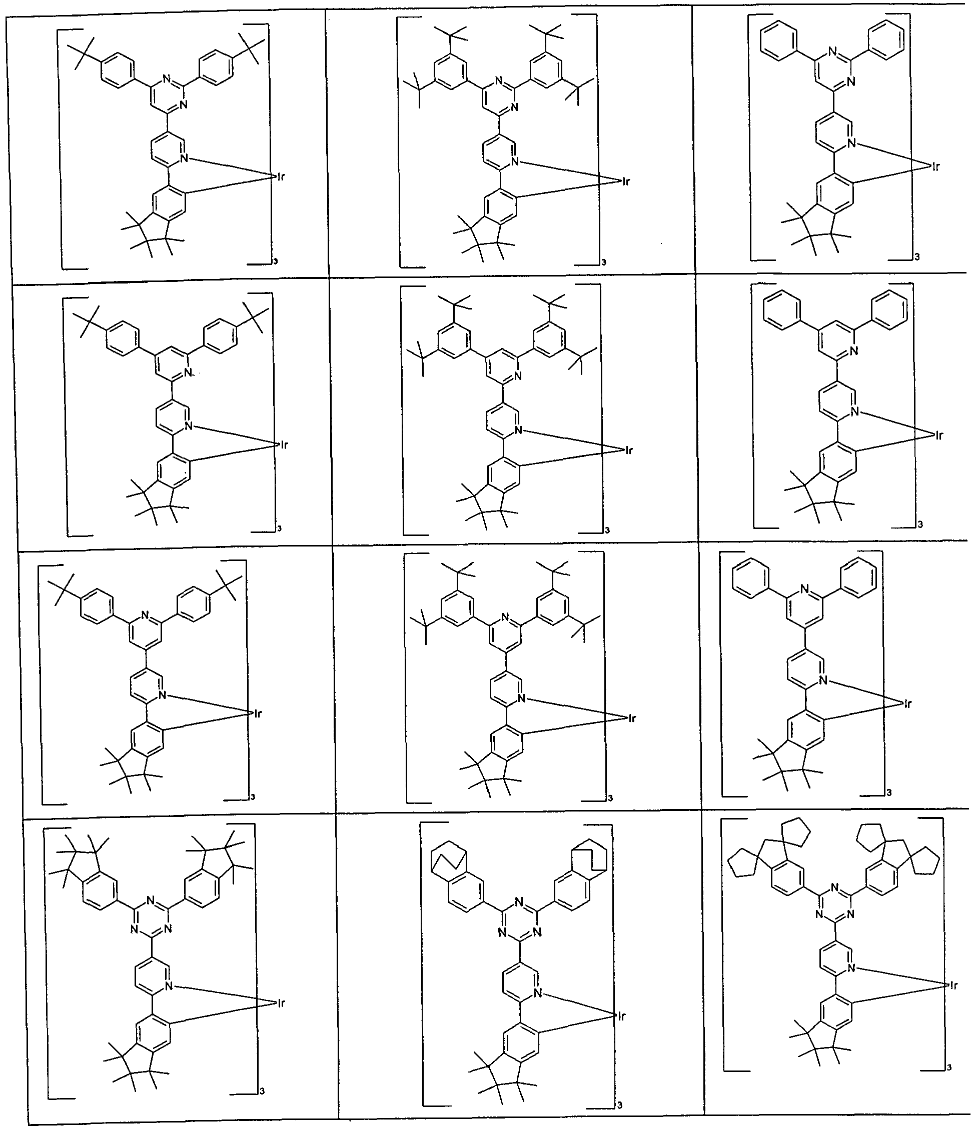

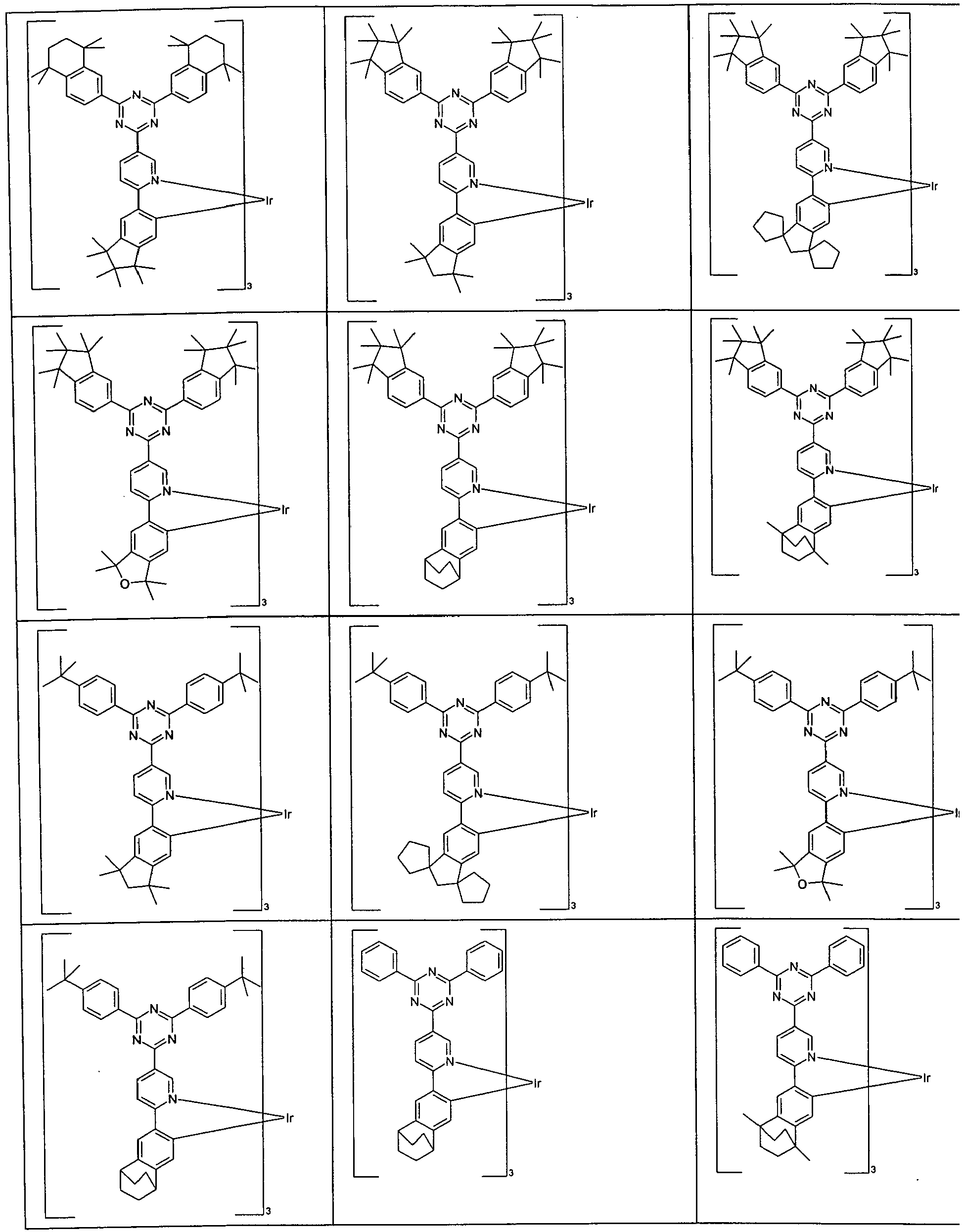

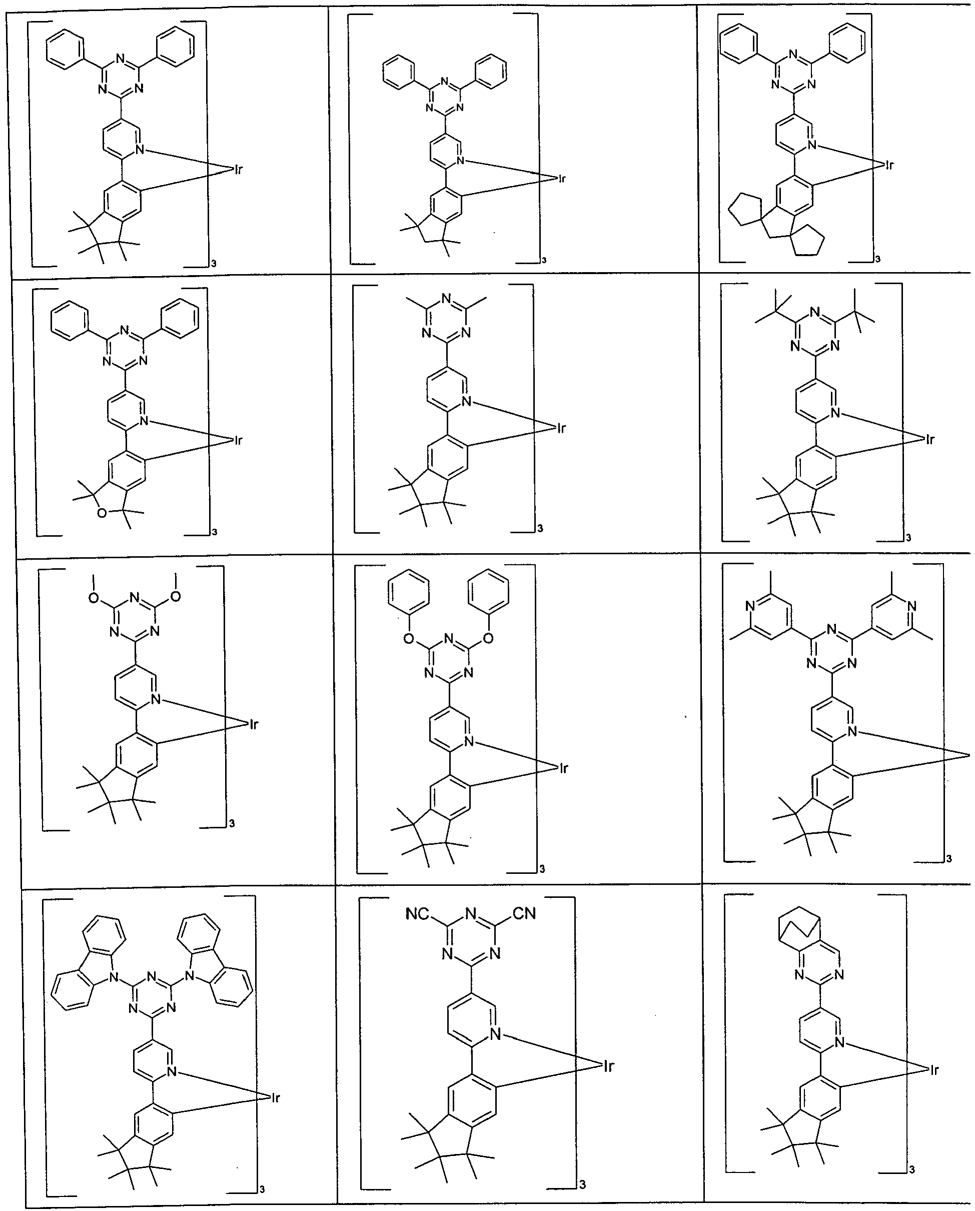

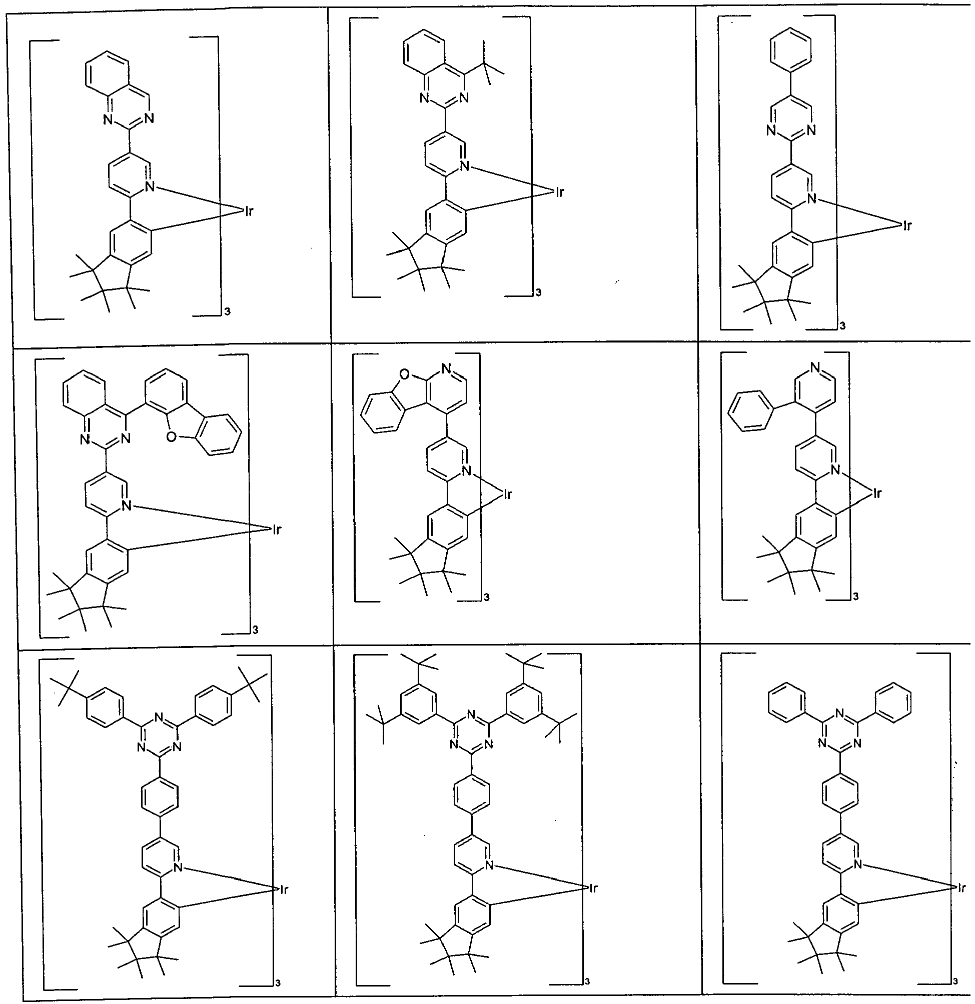

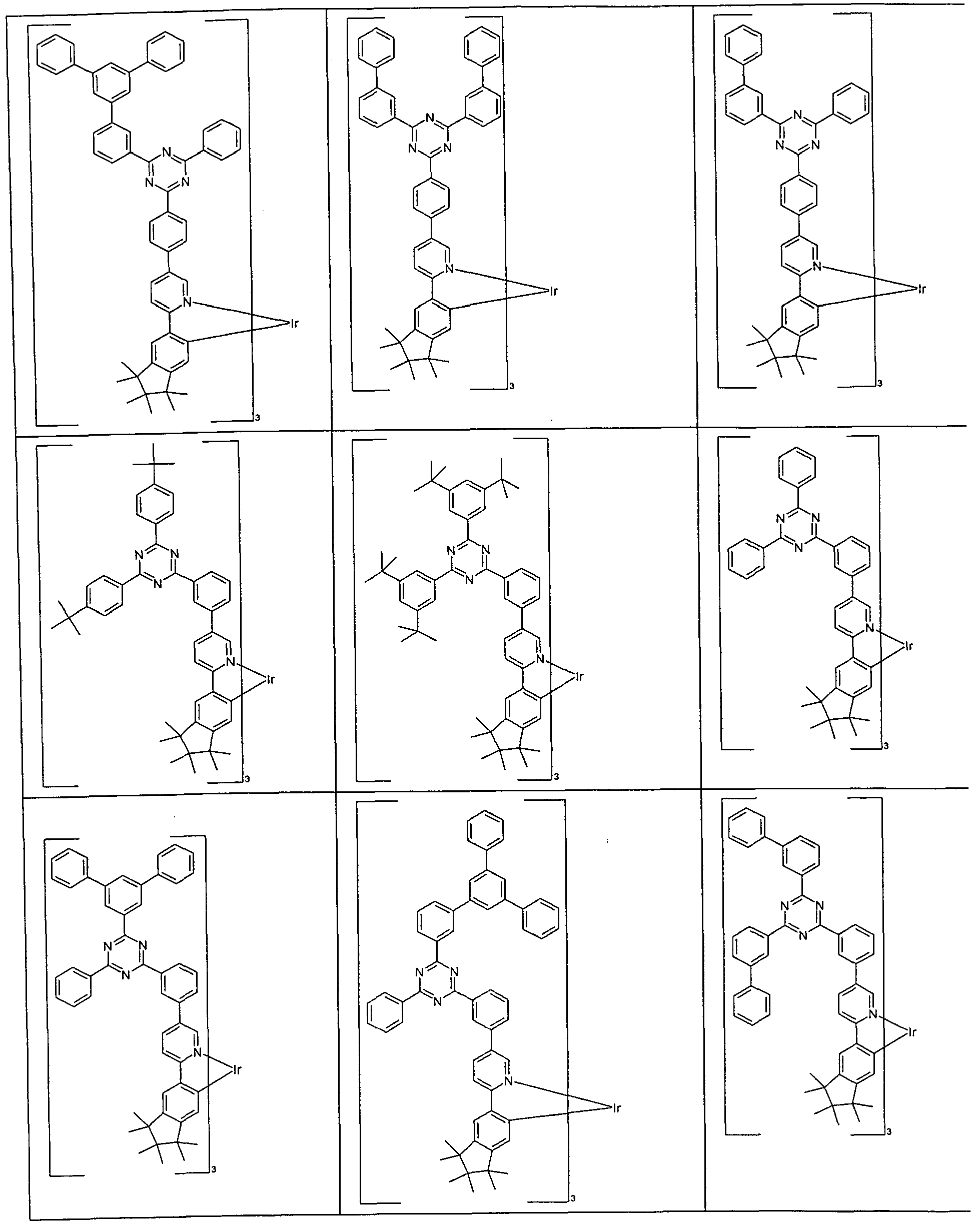

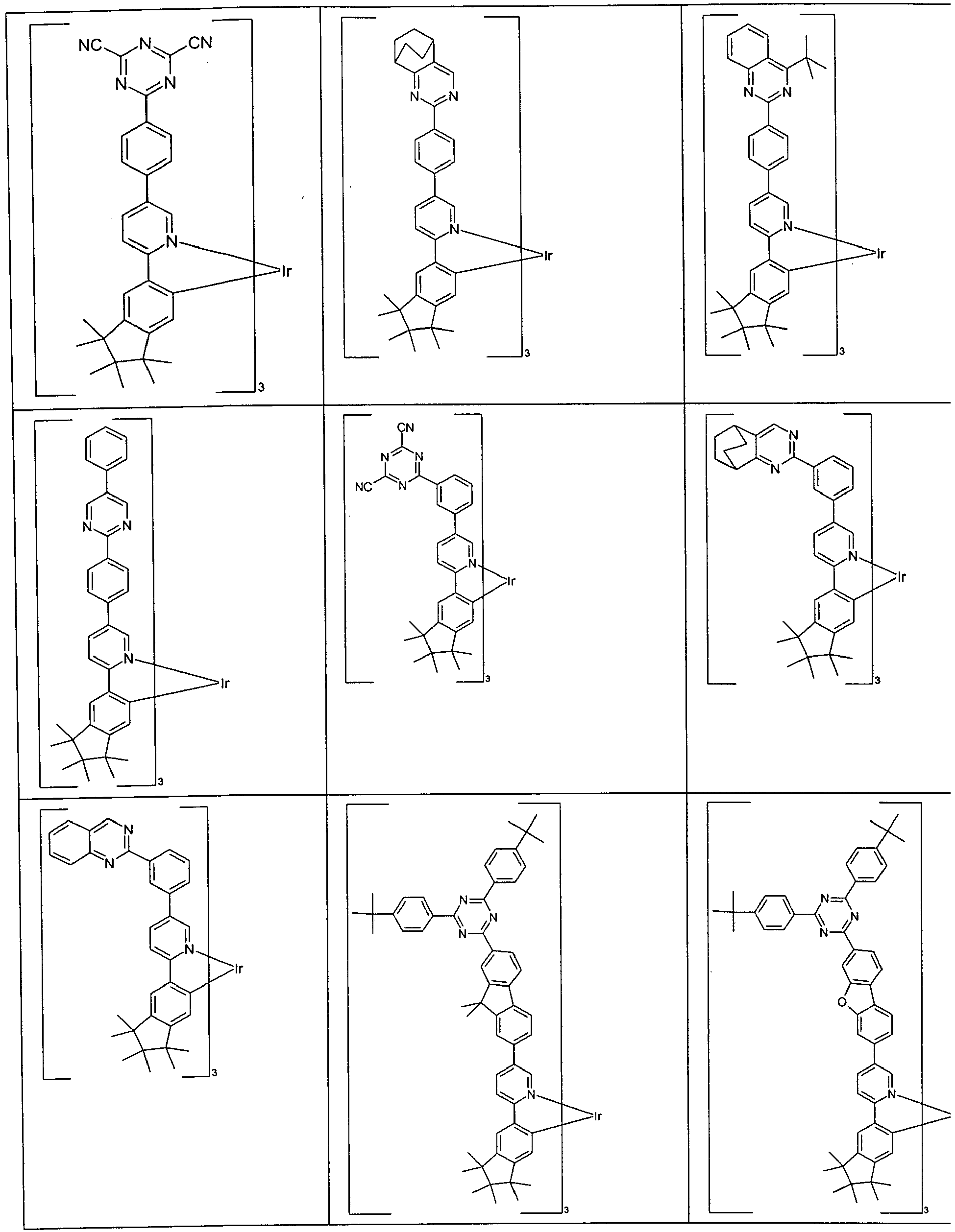

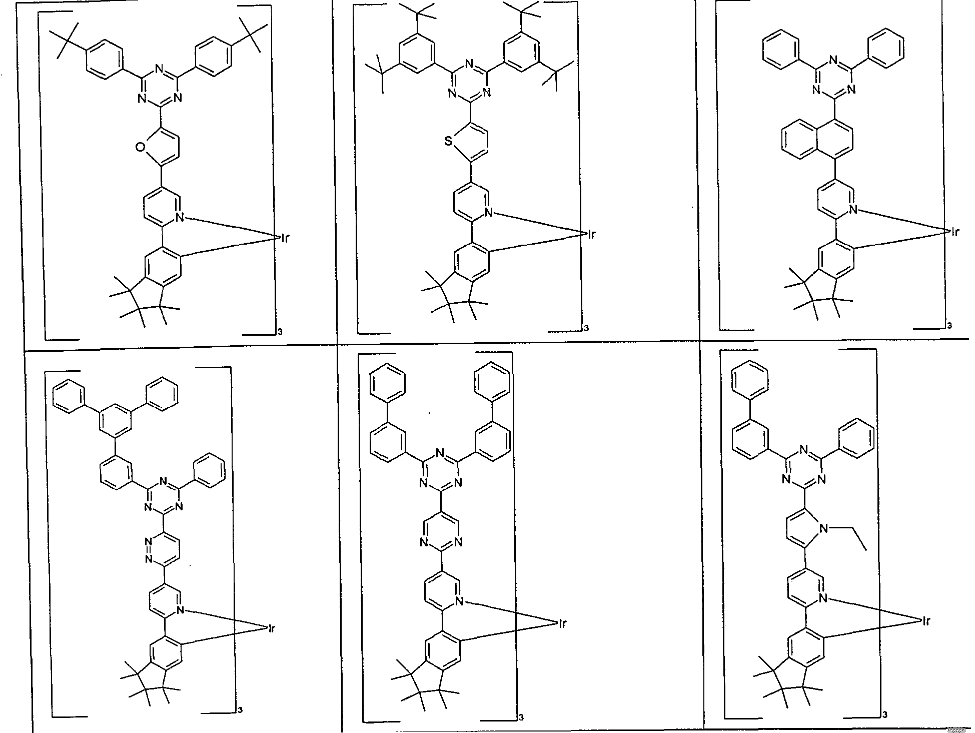

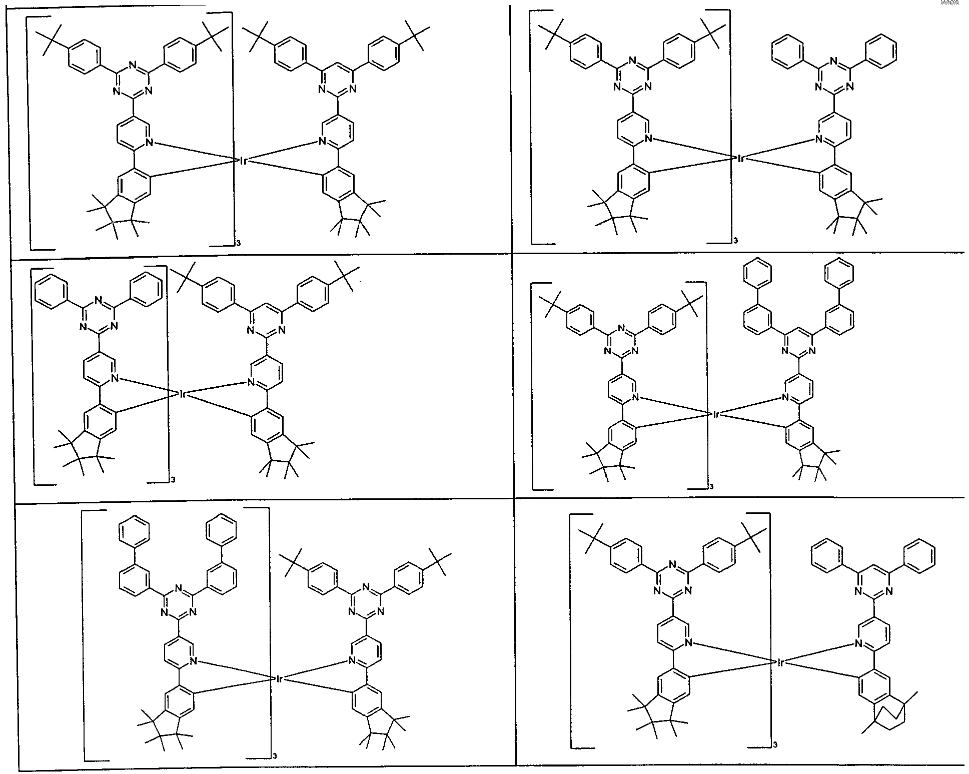

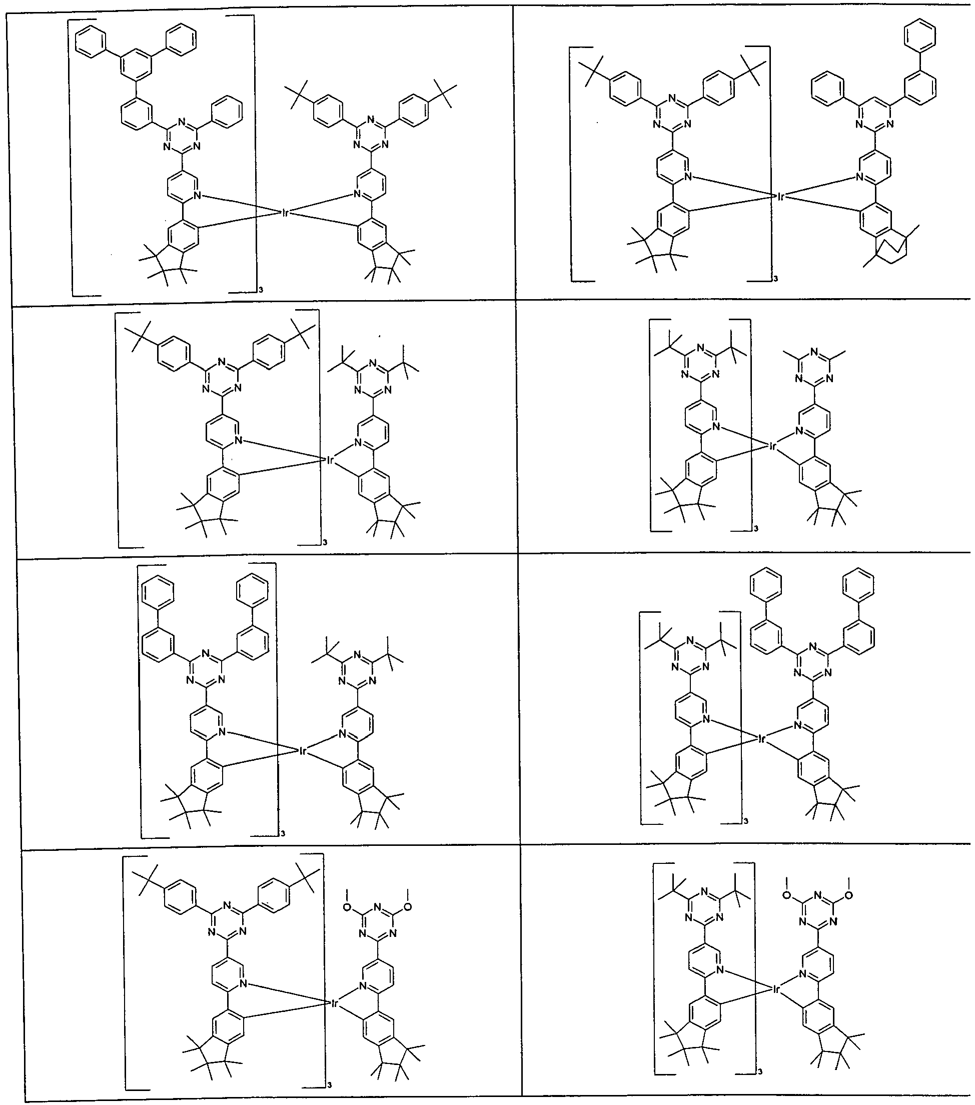

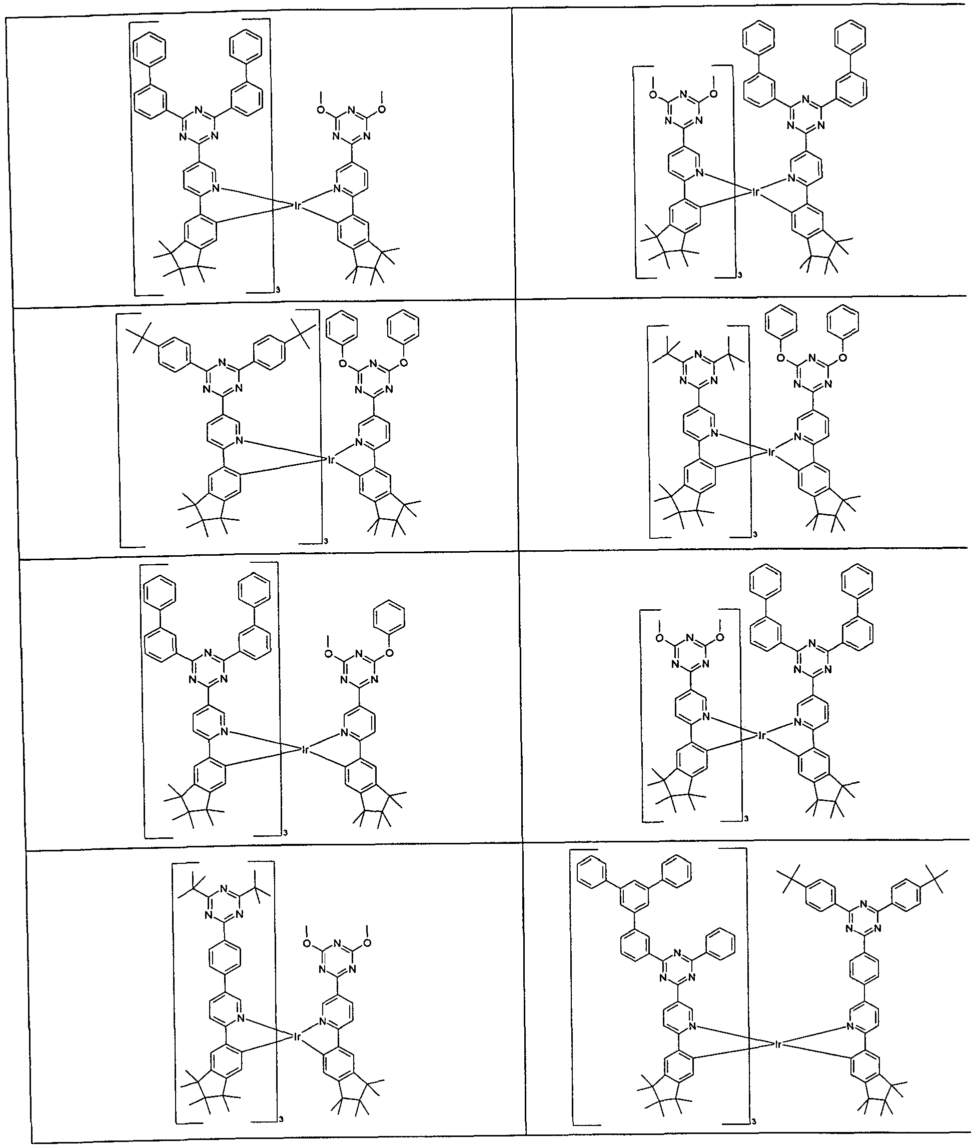

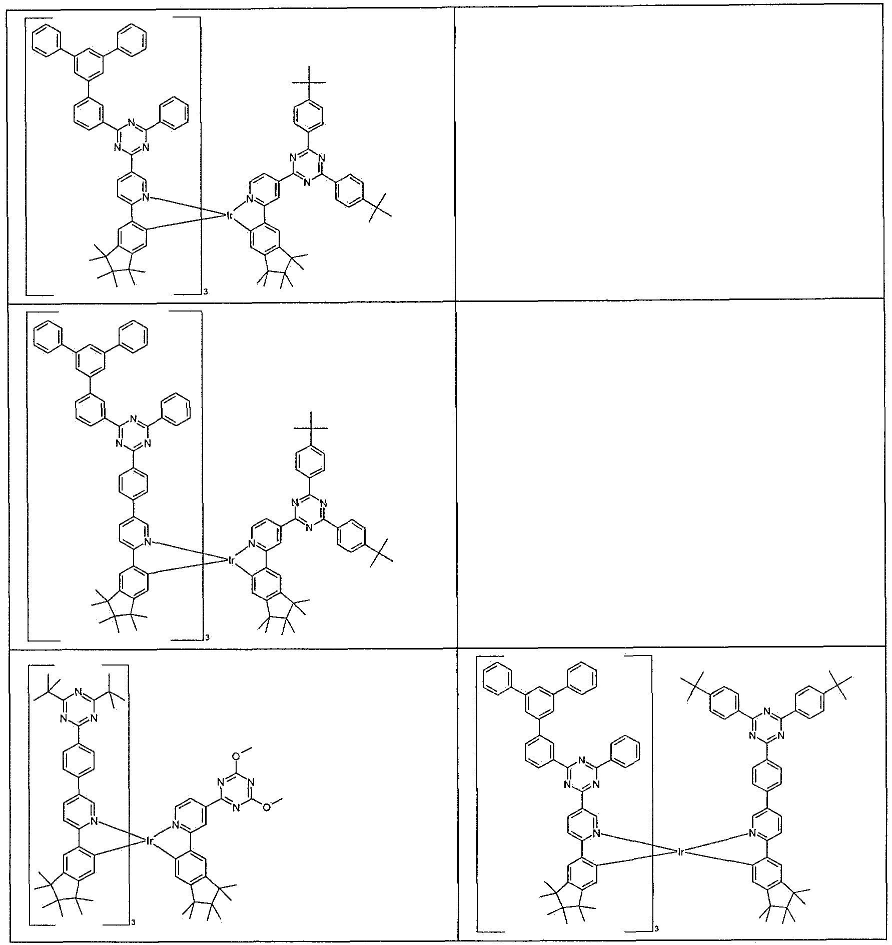

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der erfindungsgemäßen Verbindungen gemäß Formel (1) durch Umsetzung der entsprechenden freien Liganden mit Iridiumalkoholaten der Formel (39), mit Iridiumketoketonaten der Formel (40), mit Iridiumhalogeniden der Formel (41) oder mit dimeren Iridiumkomplexen der Formel (42) oder (43), 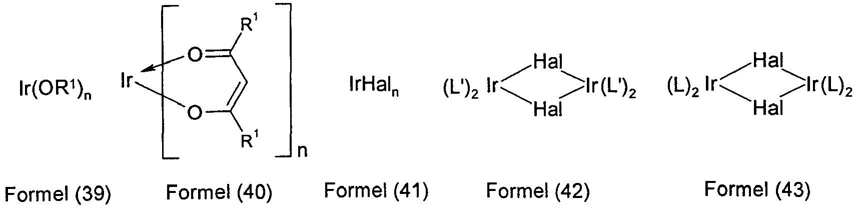 wobei die Symbole und Indizes L', m, n und R¹ die oben angegebenen Bedeutungen haben und Hal = F, Cl, Br oder I ist.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet ist [IrCl₂(acac)₂]⁻, beispielsweise Na[IrCl₂(acac)₂]. Weitere besonders geeignete Iridiumedukte sind Iridium(III)-tris(acetylacetonat) und Iridium(III)-tris(2,2,6,6-tetramethyl-3,5-heptandionat).

Die Synthese kann auch durch Umsetzung der Liganden L mit Iridiumkomplexen der Formel [Ir(L')₂(HOMe)₂]A oder [Ir(L')₂(NCMe)₂]A oder durch Umsetzung der Liganden L' mit Iridiumkomplexen der Formel [Ir(L)₂(HOMe)₂]A oder [Ir(L)₂(NCMe)₂]A, wobei A jeweils ein nicht koordinierendes Anion, wie z. B. Triflat, Tetrafluoroborat, Hexafluorophosphat, etc., darstellt, in dipolar-protischen Lösungsmitteln, wie z. B. Ethanol, iso-Propanol, Ethylenglykol, Propylenglykol, Glycerin, Diethylenglykol, Triethylenglykol, etc., durchgeführt werden.

Die Synthese der Komplexe wird bevorzugt durchgeführt wie in WO 2002/060910 und in WO 2004/085449 beschrieben. Heteroleptische Komplexe können beispielsweise auch gemäß WO 05/042548 synthetisiert werden. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMOS) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, 1,2-, 1,3-, 1,4-Bisphenoxybenzol, Triphenylphosphinoxid, 18-Krone-6, Phenol, 1-Naphthol, Hydrochinon, etc..

Nochmals ein weiterer geeigneter Syntheseweg der erfindungsgemäßen Verbindungen geht aus von einem Iridiumkomplex, der am Phenylpyridinliganden statt der Gruppe -(Ar)ₚ-HetAr eine reaktive Abgangsgruppe, insbesondere Chlor, Brom oder Iod, trägt. Dieses kann mit einer Boronsäure oder einem Boronsäurederivat, insbesondere einem Boronsäureester der Gruppe -(Ar)ₚ-HetAr zur erfindungsgemäßen Verbindung gekuppelt werden. Alternativ kann die reaktive Abgangsgruppe zu einer Boronsäure oder einem Boronsäurederivat umgesetzt werden und dann mit der Gruppe -(Ar)ₚ-HetAr, die noch eine reaktive Abgangsgruppe, insbesondere Chlor, Brom oder Iod trägt, gekuppelt werden.

Ein weiterer Gegenstand der Erfindung sind die entsprechenden freien Liganden der erfindungsgemäßen Verbindungen gemäß der folgenden Formel (44), welche wertvolle Zwischenprodukte für die Synthese der Verbindungen gemäß Formel (1) sind: 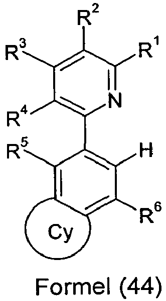 wobei die verwendeten Symbole die oben genannten Bedeutungen aufweisen. Dabei gelten die oben für den Iridiumkomplex genannten Bevorzugungen für die verwendeten Symbole gleichermaßen auch für die Verbindung gemäß Formel (44).

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan oder Mischungen dieser Lösemittel.

Ein weiterer Gegenstand der vorliegenden Erfindung ist daher eine Formulierung, enthaltend eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die oben beschriebenen Komplexe gemäß Formel (1) bzw. die oben aufgeführten bevorzugten Ausführungsformen und auch die Verbindungen gemäß Formel (44) können in einer elektronischen Vorrichtung als aktive Komponente verwendet werden. Ein weiterer Gegenstand der vorliegenden Erfindung ist daher die Verwendung einer Verbindung nach Formel (1) bzw. Formel (44) bzw. nach einer der bevorzugten Ausführungsformen in einer elektronischen Vorrichtung. Weiterhin können die erfindungsgemäßen Verbindungen zur Erzeugung von Singulett-Sauerstoff, in der Photokatalyse oder in Sauerstoffsensoren eingesetzt werden. Nochmals ein weiterer Gegenstand der vorliegenden Erfindung ist eine elektronische Vorrichtung enthaltend mindestens eine Verbindung gemäß Formel (1) bzw. Formel (44) bzw. nach einer der bevorzugten Ausführungsformen.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) bzw. Formel (44) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Eine bevorzugte Ausführungsform sind Dreischichtsysteme, wobei die drei Schichten blaue, grüne und orange oder rote Emission zeigen (siehe z. B. WO 2005/011013) bzw. Systeme, welche mehr als drei emittierende Schichten aufweisen. Eine weitere bevorzugte Ausführungsform sind Zweischichtsysteme, wobei die beiden Schichten entweder blaue und gelbe oder blaugrüne und orange Emission zeigen. Zweischichtsysteme sind insbesondere für Beleuchtungsanwendungen von Interesse. Solche Ausführungsformen sind mit den erfindungsgemäßen Verbindungen besonders geeignet, da diese häufig gelbe bzw. orange Emission zeigen. Die weiß emittierenden Elektrolumineszenzvorrichtungen können für Beleuchtungsanwendungen oder als Backlight für Displays oder mit Farbfilter als Display eingesetzt werden.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

In einer weiteren bevorzugten Ausführungsform der Erfindung enthält die organische Elektrolumineszenzvorrichtung die Verbindung gemäß Formel (44) bzw. die bevorzugten Ausführungsformen als Matrixmaterial, insbesondere für phosphoreszierende Emitter, in einer oder mehreren emittierenden Schichten oder als Lochblockiermaterial in einer Lochblockierschicht oder als Elektronentransportmaterial in einer Elektronentransportschicht.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Matrixmaterials bzw. der Matrixmaterialien bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Berylliumkomplexe, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877. Weitere geeignete Matrixmaterialien sind die Verbindungen der oben genannten Formel (44).

Es kann auch bevorzugt sein, mehrere verschiedene Matrixmaterialien als Mischung einzusetzen. Hierfür eignen sich insbesondere Mischungen aus mindestens einem elektronentransportierenden Matrixmaterial und mindestens einem lochtransportierenden Matrixmaterial oder Mischungen aus mindestens zwei elektronentransportierenden Matrixmaterialien oder Mischungen aus mindestens einem loch- oder elektronentransportierenden Matrixmaterial und mindestens einem weiteren Material mit einer großen Bandlücke, welches somit weitgehend elektrisch inert ist und nicht oder nicht in wesentlichem Umfang am Ladungstransport teilnimmt, wie z. B. in WO 2010/108579 beschrieben. Eine bevorzugte Kombination ist beispielsweise die Verwendung eines aromatischen Ketons oder eines Triazinderivats mit einem Triarylamin-Derivat oder einem Carbazol-Derivat als gemischte Matrix für den erfindungsgemäßen Metallkomplex.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise blau oder grün emittierende Triplettemitter als Co-Matrix für die erfindungsgemäßen Komplexe gemäß Formel (1) eingesetzt werden.

Die erfindungsgemäßen Verbindungen sind insbesondere auch geeignet als phosphoreszierende Emitter in organischen Elektrolumineszenzvorrichtungen, wie sie z. B. in WO 98/24271, US 2011/0248247 und US 2012/0223633 beschrieben sind. In diesen mehrfarbigen Display-Bauteilen wird eine zusätzliche blaue Emissionsschicht vollflächig auf alle Pixel, auch diejenigen mit einer von Blau verschiedenen Farbe, aufgedampft. Dabei wurde gefunden, dass die erfindungsgemäßen Verbindungen, wenn sie als Emitter für das rote Pixel eingesetzt werden, zusammen mit der aufgedampften blauen Emissionsschicht zu sehr guter Emission führen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, CS₂CO₃, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

In den weiteren Schichten können generell alle Materialien verwendet werden, wie sie gemäß dem Stand der Technik für die Schichten verwendet werden und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch folgende überraschende Vorteile gegenüber dem Stand der Technik aus:
1. Die erfindungsgemäßen Verbindungen weisen ein sehr schmales Emissionsspektrum und somit eine sehr geringe Halbwertsbreite der Emission auf. Dies führt zu einer größeren Farbreinheit der roten Emission der Verbindungen, so dass diese besser für die Verwendung in roten Pixeln in Displays geeignet sind als entsprechende Verbindungen, die zwar eine Gruppe HetAr, aber keine Gruppe gemäß einer der Formeln (4) bis (10) enthalten.
2. Organische Elektrolumineszenzvorrichtungen enthaltend Verbindungen gemäß Formel (1) als emittierende Materialien weisen eine sehr gute Effizienz auf. Insbesondere weisen sie eine bessere Effizienz auf als Elektrolumineszenzvorrichtungen, welche analoge Verbindungen enthalten, die keinen ankondensierten aliphatischen Fünfring gemäß einer der Formeln (4) bis (10) enthalten.
3. Die erfindungsgemäßen Verbindungen weisen eine sehr hohe Löslichkeit auf und lassen sich daher hervorragend aus Lösung verarbeiten.
4. Organische Elektrolumineszenzvorrichtungen enthaltend Verbindungen gemäß Formel (1) als emittierende Materialien weisen eine sehr gute Lebensdauer auf. Insbesondere weisen sie eine bessere Lebensdauer auf als Elektrolumineszenzvorrichtungen, welche analoge Verbindungen enthalten, die keinen ankondensierten aliphatischen Fünfring gemäß einer der Formeln (4) bis (10) enthalten.
5. Die erfindungsgemäßen Verbindungen weisen eine sehr geringe Aggregationsneigung auf, was zu einer sehr geringen Triplett-Triplett-Annihilation führt.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße Verbindungen synthetisieren und diese in elektronischen Vorrichtungen verwenden und kann somit die Erfindung im gesamten offenbarten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von VWR, Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese der Synthone

### Beispiel S1: 5-Brom-2-(1,1,2,2,3,3-hexamethyl-indan-5-yl)-pyridin

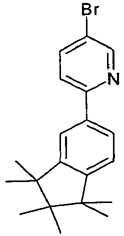

In einen 4L-Vierhalskolben mit Rückflusskühler, Argonanschluss, KPG-Rührer und Innenthermometer werden 92,5 g 2-(1,1,2,2,3,3-Hexamethyl-indan-5-yl)-4,4,5,5-tetramethyl-[1,3,2]dioxaborolan (282 mmol, [1562418-16-9]), 80,0 g 5-Brom-2-iod-pyridin (282mmol, [223463-13-6]) und 275g Cäsiumcarbonat (844mmol) eingewogen, der Kolben mit Argon inertisiert und mit 1400 ml entsalztem Wasser, 1100 ml 1,4-Dioxan und 550 ml absolutem Ethanol versetzt. Die Suspension wird für 5 Minuten homogenisiert, dann werden 4,7 g 1,1'-Bis(diphenylphosphino)ferrocen (DPPF, 8,5mmol) und 1,9 g Palladiumacetat (8,5 mmol) zugegeben. Die Reaktionsmischung wird über Nacht auf 80 °C erwärmt. Nach Abkühlen werden 750ml Ethylacetat zugegeben und die Phasen getrennt. Die wässrige Phase wird erneut mit Ethylacetat extrahiert. Die organischen Phasen werden vereinigt, mit Wasser und gesättigter NaCI-Lösung gewaschen und über Natriumsulfat getrocknet. Es wird über eine 5 cm Schicht Celite mit Ethylacetat als Eluent filtriert und anschließend das Lösemittel im Vakuum entfernt. Das Produkt wird im Hochvakuum (4x10⁻⁵ mbar, 185°C) destilliert und per Säulenchromatographie über Kieselgel mit Toluol als Eluent aufgereinigt. Es werden 75,1 g (75%) eines farblosen kristallinen Feststoffes erhalten.

Nach der allgemeinen Vorschrift können folgende bromierte Synthone hergestellt werden:

| **Bsp.** | **Edukt 1** | **Edukt 2** | **Produkt** | **Aus beute** |
|---|---|---|---|---|
| S2 | 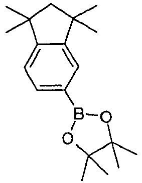 | 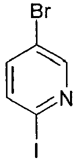 | 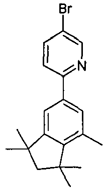 | 72% |
| | 1312464-73-5 | 223463-13-6 | | |
| S3 | 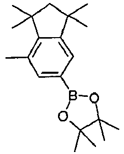 | 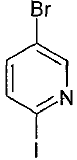 | 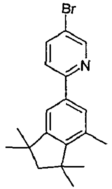 | 61% |
| | 1562418-19-2 | 223463-13-6 | | |
| S4 | 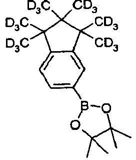 | 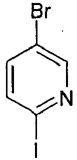 | 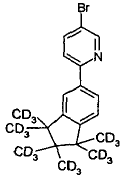 | 77% |
| | 1562418-17-0 | 223463-13-6 | | |
| S5 | 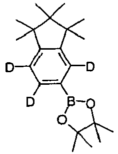 | 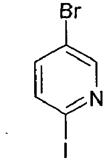 | 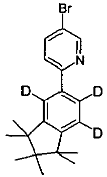 | 71% |
| | 1562418-21-6 | 223463-13-6 | | |
| S6 | 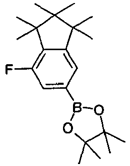 | 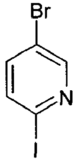 | 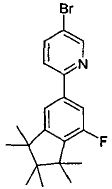 | 55% |
| | 1562418-23-8 | 223463-13-6 | | |
| S7 | 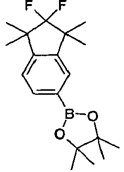 | 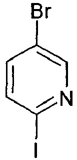 | 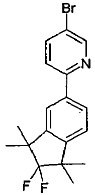 | 61% |
| | 1562418-25-0 | 223463-13-6 | | |
| S8 | 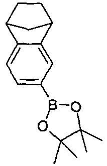 | 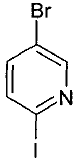 | 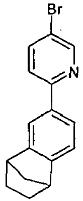 | 73% |
| | 1562418-27-2 | 223463-13-6 | | |
| S9 | 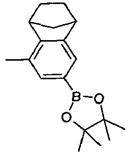 | 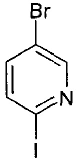 | 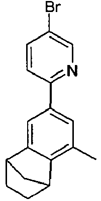 | 57% |
| | 1562418-29-4 | 223463-13-6 | | |
| S10 | 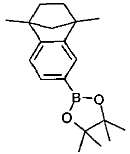 | 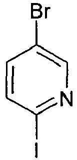 | 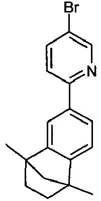 | 69% |
| | 1562418-31-8 | 223463-13-6 | | |
| S11 | 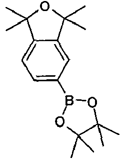 | 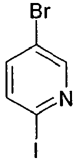 | 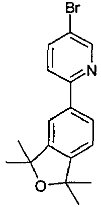 | 62% |
| | 1562418-33-0 | 223463-13-6 | | |
| S12 | 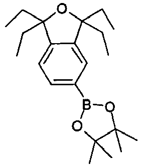 | 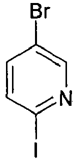 | 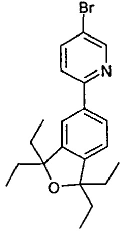 | 56% |
| | 1562418-35-2 | 223463-13-6 | | |
| S13 | 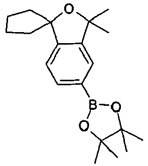 | 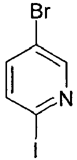 | 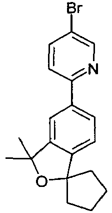 | 65% |
| | 1562418-37-4 | 223463-13-6 | | |
| S14 | 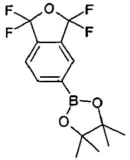 | 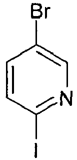 | 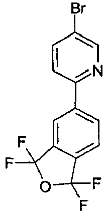 | 48% |
| | 1562418-39-6 | 223463-13-6 | | |
| S15 | 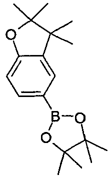 | 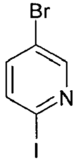 | 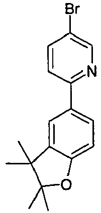 | 61% |
| | 1562418-41-0 | 223463-13-6 | | |
| S16 | 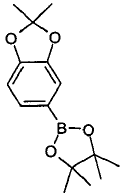 | 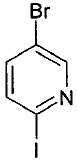 | 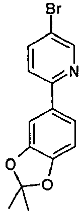 | 59% |
| | 1562418-43-2 | 223463-13-6 | | |
| S17 | 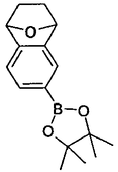 | 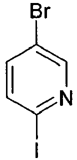 | 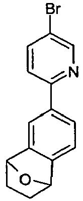 | 71% |
| | 1562418-44-3 | 223463-13-6 | | |
| S18 | 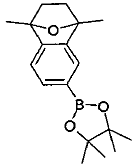 | 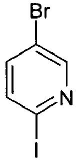 | 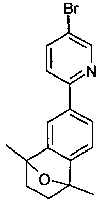 | 68% |
| | 1562418-47-6 | 223463-13-6 | | |
| S19 | 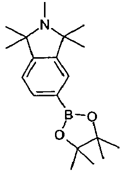 | 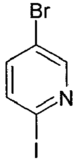 | 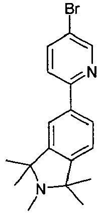 | 80% |
| | 1562418-49-8 | 223463-13-6 | | |
| S20 | 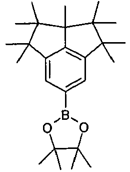 | 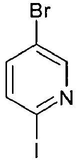 | 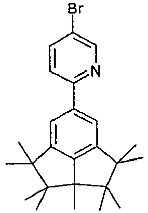 | 51% |
| | 1562418-51-2 | 223463-13-6 | | |
| S21 | 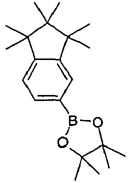 | 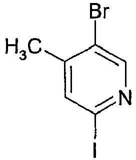 | 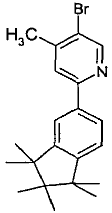 | 80% |
| | 1562418-16-9 | 941294-57-1 | | |
| S22 | 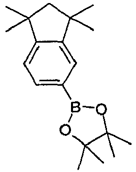 | 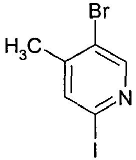 | 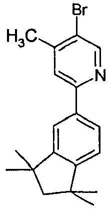 | 82% |
| | 1312464-73-5 | 941294-57-1 | | |
| S23 | 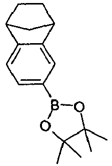 | 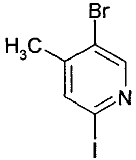 | 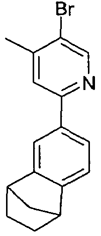 | 78% |
| | 1562418-27-2 | 941294-57-1 | | |
| S24 | 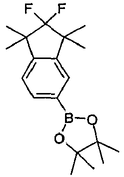 | 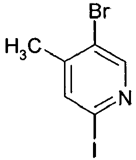 | 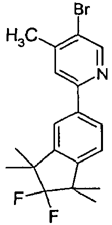 | 74% |
| | 1562418-25-0 | 941294-57-1 | | |
| S25 | 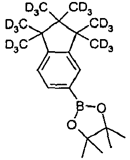 | 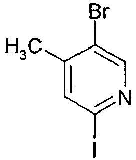 | 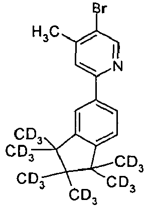 | 84% |
| | 1562418-17-0 | 941294-57-1 | | |
| S26 | 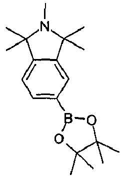 | 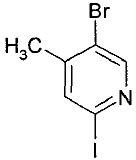 | 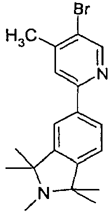 | 77% |
| | 1562418-49-8 | 941294-57-1 | | |
| S27 | 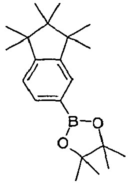 | 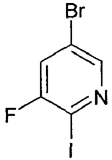 | 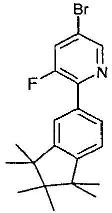 | 62% |
| | 1562418-16-9 | 1260665-95-9 | | |
| S28 | 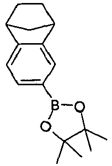 | 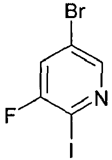 | 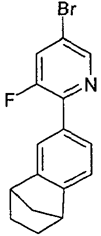 | 67% |
| | 1562418-27-2 | 1260665-95-9 | | |
| S29 | 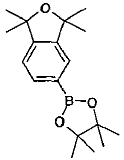 | 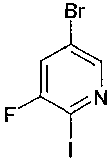 | 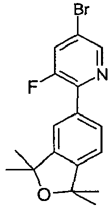 | 59% |
| | 1562418-33-0 | 1260665-95-9 | | |
| S30 | 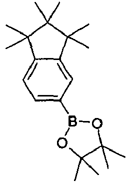 | 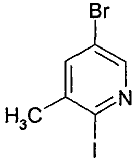 | 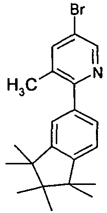 | 51% |
| | 1562418-16-9 | 376587-52-9 | | |
| S31 | 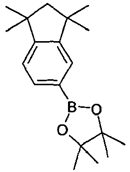 | 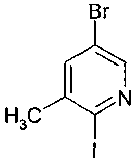 | 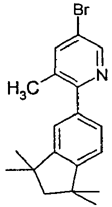 | 52% |
| | 1312464-73-5 | 376587-52-9 | | |
| S32 | 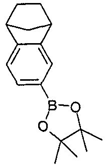 | 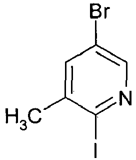 | 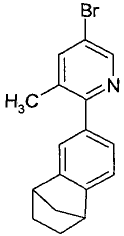 | 49% |
| | 1562418-27-2 | 376587-52-9 | | |
| S33 | 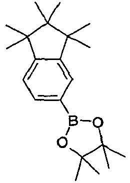 | 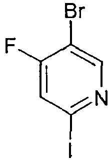 | 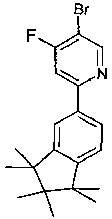 | 49% |
| | 1562418-16-9 | 1260669-95-1 | | |
| S34 | 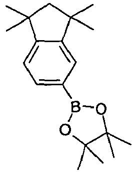 | 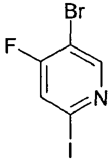 | 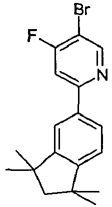 | 52% |
| | 1312464-73-5 | 1260669-95-1 | | |
| S35 | 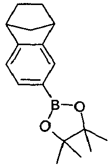 | 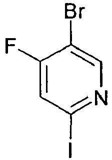 | 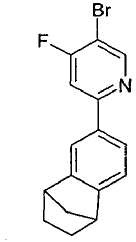 | 46% |
| | 1562418-27-2 | 1260669-95-1 | | |
| S36 | 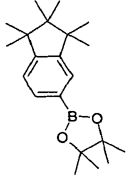 | 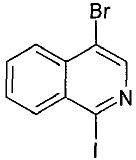 | 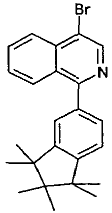 | 80% |
| | 1562418-16-9 | 927800-97-3 | | |
| S37 | 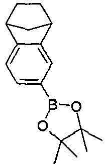 | 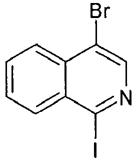 | 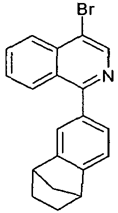 | 82% |
| | 1562418-27-2 | 927800-97-3 | | |
| S38 | 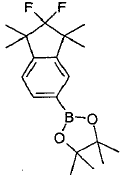 | 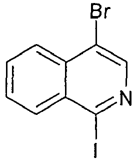 | 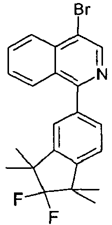 | 75% |
| | 1562418-25-0 | 927800-97-3 | | |
| S39 | 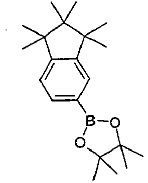 | 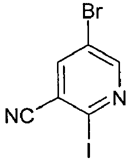 | 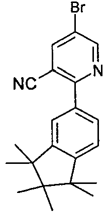 | 55% |
| | 1562418-16-9 | 1346540-97-3 | | |
| S40 | 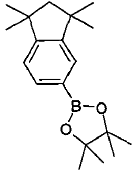 | 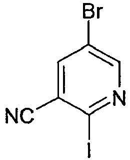 | 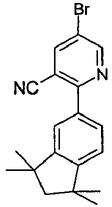 | 55% |
| | 1312464-73-5 | 1346540-97-3 | | |
| S41 | 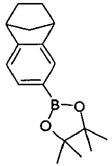 | 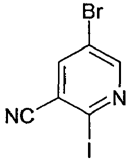 | 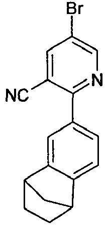 | 51% |
| | 1562418-27-2 | 1346540-97-3 | | |
| S42 | 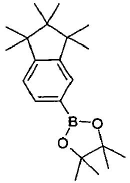 | 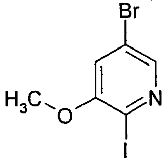 | 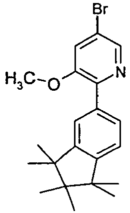 | 50% |
| | 1562418-16-9 | 944805-60-1 | | |
| S43 | 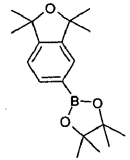 | 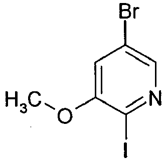 | 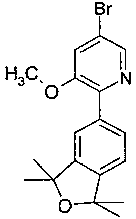 | 47% |
| | 1562418-33-0 | 944805-60-1 | | |
| S44 | 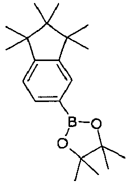 | 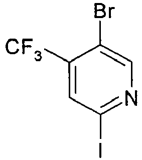 | 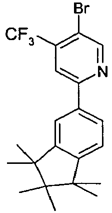 | 49% |
| | 1562418-16-9 | 1443792-54-8 | | |
| S45 | 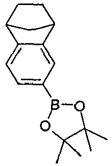 | 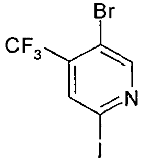 | 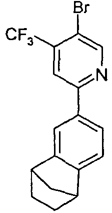 | 51% |
| | 1562418-27-2 | 1443792-54-8 | | |
| S46 | 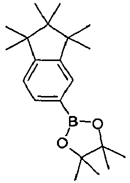 | 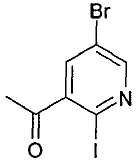 | 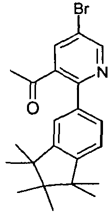 | 41% |
| | 1562418-16-9 | 1359703-93-7 | | |
| S47 | 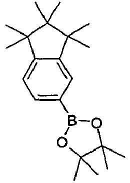 | 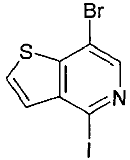 | 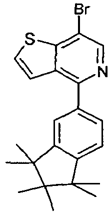 | 85% |
| | 1562418-16-9 | 1203579-77-4 | | |
| S48 | 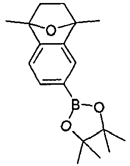 | 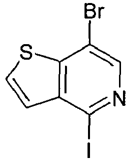 | 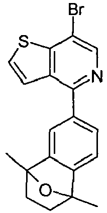 | 78% |
| | 1562418-47-6 | 1203579-77-4 | | |
| S49 | 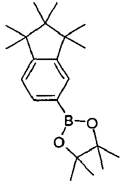 | 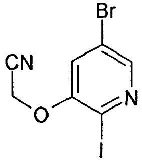 | 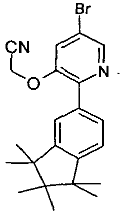 | 65% |
| | 1562418-16-9 | 1236062-30-8 | | |
| S50 | 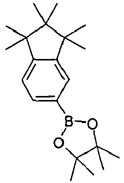 | 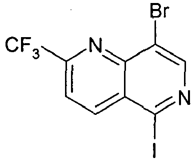 | 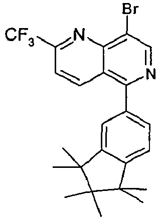 | 58% |
| | 1562418-16-9 | 890302-29-1 | | |
| S51 | 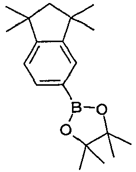 | 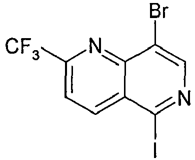 | 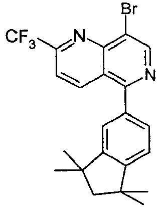 | 52% |
| | 1312464-73-5 | 890302-29-1 | | |
| S52 | 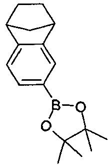 | 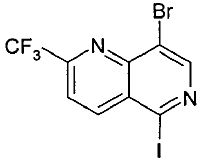 | 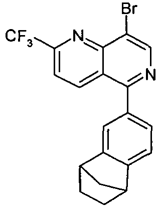 | 52% |
| | 1562418-27-2 | 890302-29-1 | | |
| S53 | 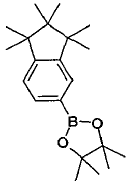 | 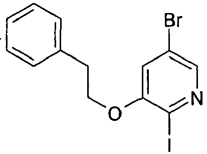 | 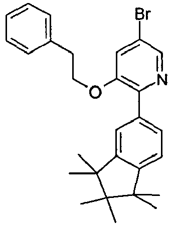 | 67% |
| | 1562418-16-9 | 1342906-74-4 | | |
| S54 | 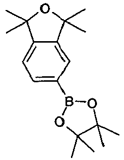 | 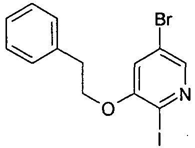 | 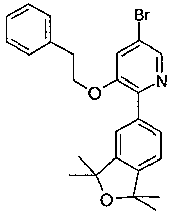 | 64% |
| | 1562418-33-0 | 1342906-74-4 | | |
| S55 | 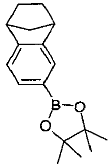 | 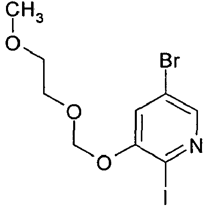 | 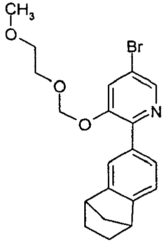 | 59% |
| | 1562418-27-2 | 1112983-05-7 | | |

### Beispiel S147: Borylierung der bromierten Synthone am Beispiel von 2-(1,1,2,2,3,3-Hexamethyl-indan-5-yl)-5-(4,4,5,5-tetramethyl-[1,3,2]di-oxaborolan-2-yl)-pyridin

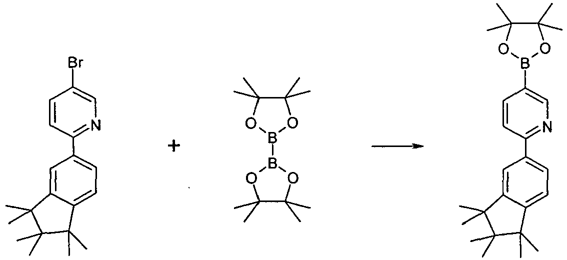

In einen 2L-Vierhalskolben mit Rückflusskühler, KPG-Rührer, Heizbad und Argonanschluss werden 30 g (83,7 mmol) **S1**, 22 g (86,6 mmol) Bis(pinacolato)diboran [73183-34-3], 50 g (510mmol) Kaliumacetat [127-08-2] und 3 g (4,1mmol) 1,1-Bis(diphenylphosphino)ferrocen-dichlorpalladium(II) [95464-05-4] eingewogen und mit 700 ml 1,4-Dioxan und 700 ml Toluol versetzt. Die Reaktionsmischung wird mit Argon inertisiert und 24 h unter Rückfluss gerührt. Nach Abkühlen wird die Reaktionslösung über Celite filtriert und die Phasen getrennt. Die wässrige Phase wird zweimal mit 50 ml Toluol extrahiert, die organischen Phasen vereinigt, über Natriumsulfat getrocknet und vom Lösemittel im Vakuum befreit. Es wird ein dunkler Feststoff erhalten, der ohne weitere Aufreinigung weiter eingesetzt wird.

Nach der allgemeinen Vorschrift können folgende borylierte Synthone hergestellt werden:

| **Bsp.** | **Edukt 1** | **Produkt** | **Aus- beute** |
|---|---|---|---|
| S100 | S1 | 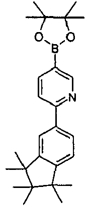 | 95% |
| S101 | S2 | 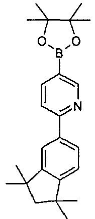 | 92% |
| S102 | S3 | 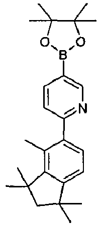 | 92% |
| S103 | S4 | 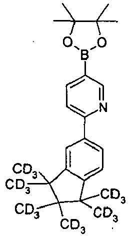 | 94% |
| S104 | S5 | 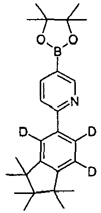 | 95% |
| S105 | S6 | 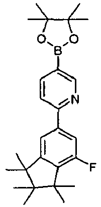 | 92% |
| S106 | S7 | 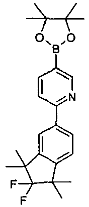 | 90% |
| S107 | S8 | 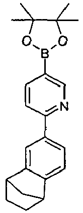 | 96% |
| S108 | S9 | 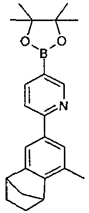 | 94% |
| S109 | S10 | 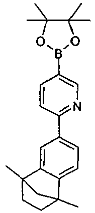 | 91% |
| S110 | S11 | 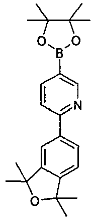 | 89% |
| S111 | S12 | 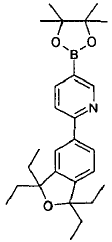 | 85% |
| S112 | S13 | 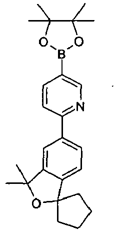 | 88% |
| S113 | S14 | 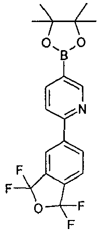 | 81% |
| S114 | S15 | 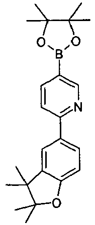 | 90% |
| S115 | S16 | 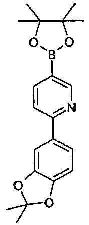 | 83% |
| S116 | S17 | 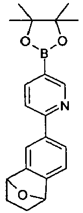 | 92% |
| S117 | S18 | 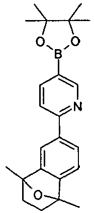 | 90% |
| S118 | S19 | 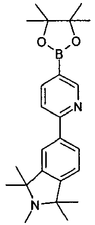 | 95% |
| S119 | S20 | 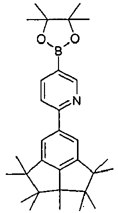 | 87% |
| S120 | S21 | 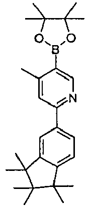 | 75% |
| S121 | S22 | 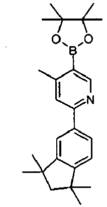 | 72% |
| S122 | S23 | 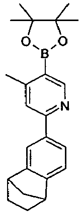 | 76% |
| S123 | S24 | 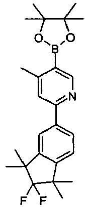 | 70% |
| S124 | S25 | 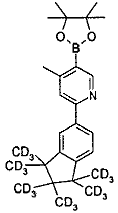 | 75% |
| S125 | S26 | 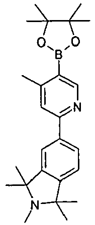 | 73% |
| S126 | S27 | 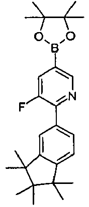 | 93% |
| S127 | S28 | 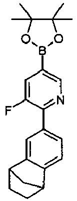 | 91% |
| S128 | S29 | 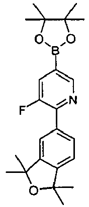 | 94% |
| S129 | S30 | 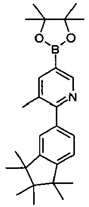 | 94% |
| S130 | S31 | 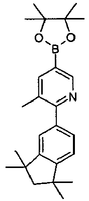 | 95% |
| S131 | S32 | 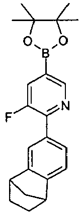 | 90% |
| S132 | S33 | 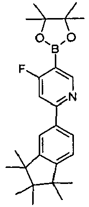 | 92% |
| S133 | S34 | 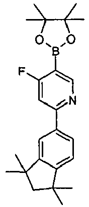 | 89% |
| S134 | S35 | 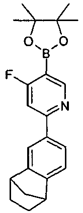 | 90% |
| S135 | S36 | 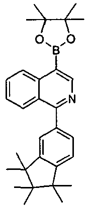 | 94% |
| S136 | S37 | 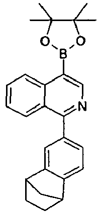 | 91% |
| S137 | S38 | 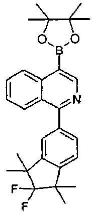 | 94% |
| S138 | S39 | 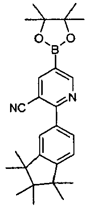 | 95% |
| S139 | S40 | 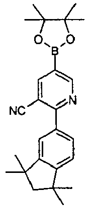 | 91% |
| S140 | S41 | 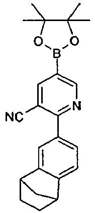 | 93% |
| S141 | S42 | 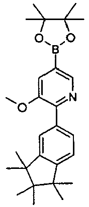 | 95% |
| S142 | S43 | 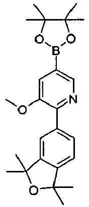 | 89% |
| S143 | S44 | 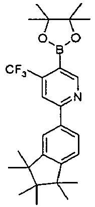 | 83% |
| S144 | S45 | 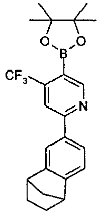 | 79% |
| S145 | S46 | 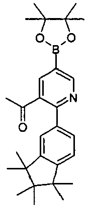 | 88% |
| S146 | S47 | 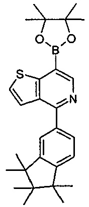 | 92% |
| S147 | S48 | 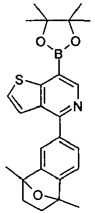 | 90% |
| S148 | S49 | 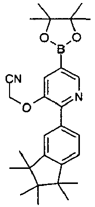 | 95% |
| S149 | S50 | 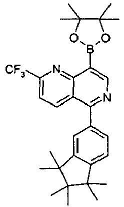 | 81% |
| S150 | S51 | 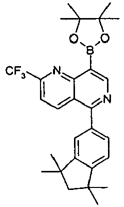 | 83% |
| S151 | S52 | 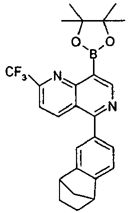 | 79% |
| S152 | S53 | 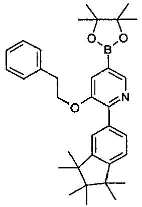 | 92% |
| S153 | S54 | 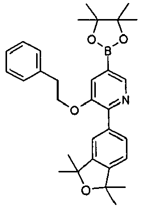 | 88% |
| S154 | S55 | 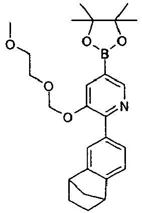 | 90% |

### Synthese der Triazin-Bausteine

### Beispielsynthese von 2-Chlor-4,6-bis-(3,5-di-tert-butyl-phenyl)-[1,3,5]triazin (S1000)

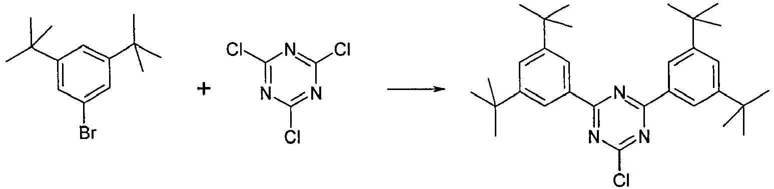

In einen ausgeheizten Kolben werden 5,8 g (238,6 mmol) Magnesiumspäne vorgelegt und eine Lösung von 73 g (271,1 mmol) Brom-3,5-di-*tert-*butylbenzol in 400 ml trockenem THF langsam zugetropft, so dass die Reaktionslösung stetig unter Rückfluss kocht. Nach vollständiger Zugabe wird die Lösung weitere 2 h unter Rückfluss erhitzt, danach abkühlen lassen. In einem weiteren Kolben werden 20 g (108,5 mmol) Cyanurchlorid in 400 ml trockenem THF vorgelegt und auf 0 °C gekühlt. Das Grignard-Reagenz wird so zugetropft, dass eine Innentemperatur von 20 °C nicht überschritten wird. Nach vollständiger Zugabe wird die Reaktionsmischung über Nacht auf Raumtemperatur aufgewärmt. Durch Zugabe von 500 ml 1N HCl-Lösung unter Eiskühlung wird die Reaktion gestoppt. Die Phasen werden getrennt und die wässrige Phase mehrfach mit Essigester nachgewaschen. Die organischen Phasen werden vereinigt und mit gesättigter NaCI-Lösung getrocknet, dann das Lösemittel im Vakuum entfernt. Das hellbraune Öl wird mit Methanol versetzt und unter Rückfluss erhitzt. Nach Abkühlen wird der Feststoff abgesaugt, mit Heptan gewaschen und im Vakuum getrocknet. Es werden 23,6 g (48,0 mmol, 44% Ausbeute) eines farblosen Feststoffes erhalten.

Analog können folgende literaturbekannte Bausteine eingesetzt werden:

| | | | |
|---|---|---|---|
| 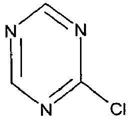 | 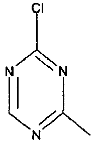 | 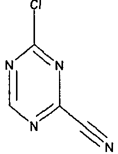 | 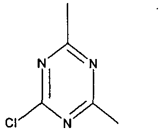 |
| 6153-86-2 | 444666-43-7 | 1451154-67-8 | 30894-84-9 |
| 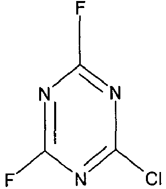 | 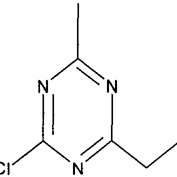 | 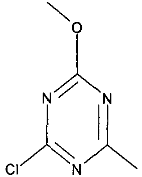 | 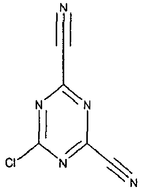 |
| 696-85-5 | 352440-04-1 | 27676-51-3 | 80587-76-4 |
| 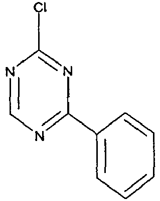 | 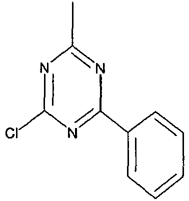 | 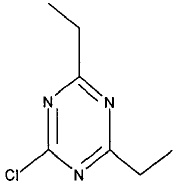 | 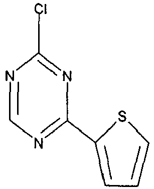 |
| 77007-96-6 | 30937-70-3 | 701-77-9 | 333737-07-8 |
| 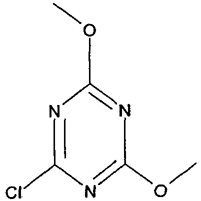 | 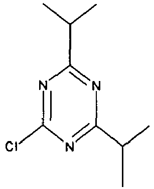 | 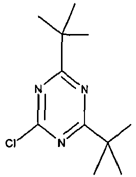 | 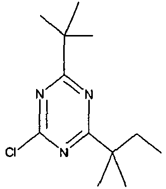 |
| 3140-73-6 | 911798-79-3 | 73084-03-4 | 1092838-33-9 |
| 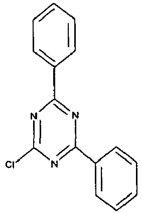 | 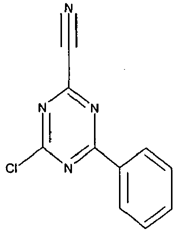 | 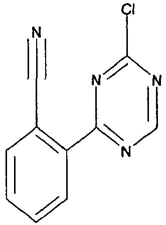 | 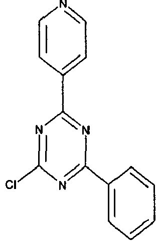 |
| 3842-55-5 | 91688-04-9 | 1426441-17-9 | 1426434-95-8 |
| 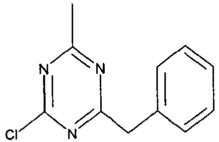 | 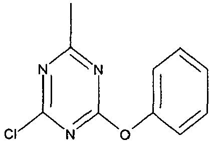 | 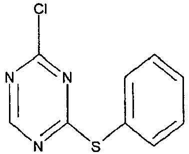 | 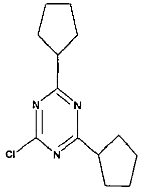 |
| 22404-35-9 | 36335-91-8 | 61810-06-8 | 78941-28-3 |
| 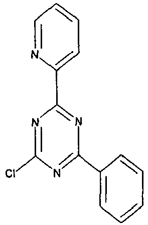 | 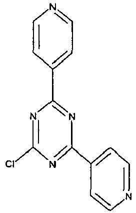 | 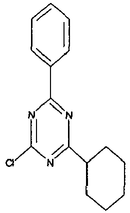 | 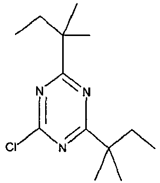 |
| 1477759-31-1 | 1253971-29-7 | 1426435-09-7 | 1092838-05-5 |
| 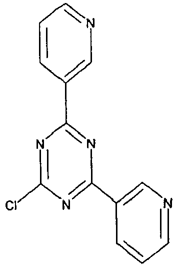 | 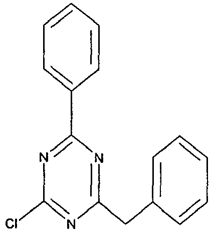 | 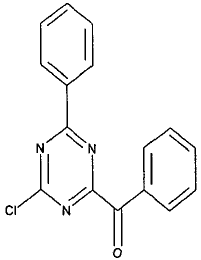 | 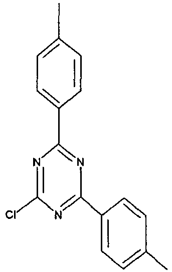 |
| 1418124-08-9 | 80984-77-6 | 1345834-25-4 | 21902-34-1 |
| 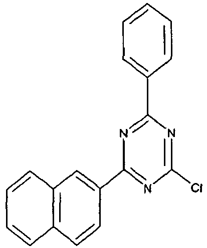 | 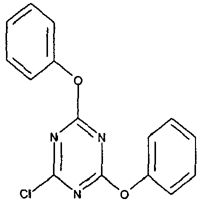 | 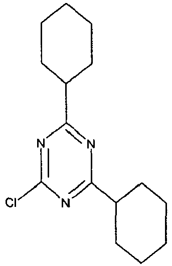 | 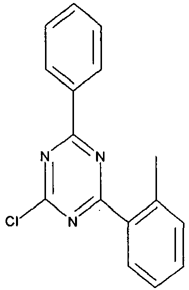 |
| 1342819-12-8 | 2972-65-8 | 78941-35-2 | 80984-76-5 |
| 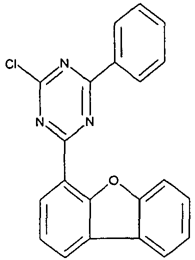 | 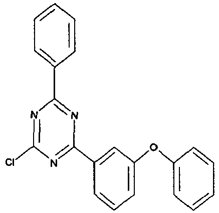 | 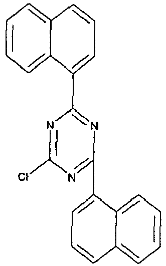 | 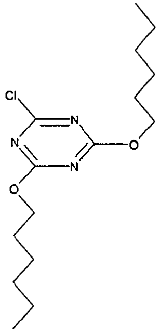 |
| 1472729-25-1 | 1426437-66-2 | 78941-32-9 | 38164-03-3 |
| 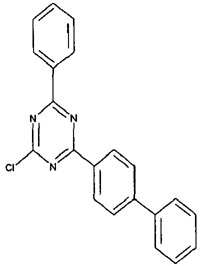 | 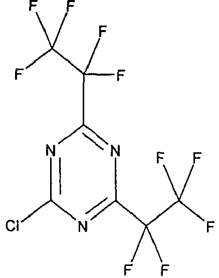 | 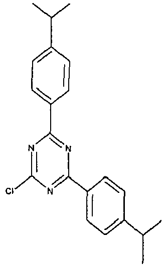 | 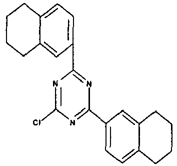 |
| 1472062-94-4 | 736-68-5 | 1383780-97-9 | 253133-88-9 |
| 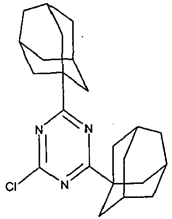 | 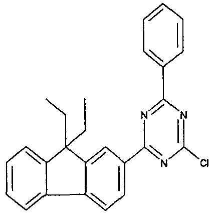 | 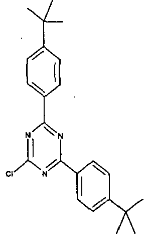 | 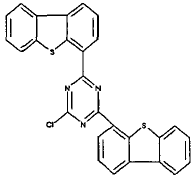 |
| 1092838-15-7 | 1015814-06-8 | 253158-13-3 | 1387596-01-1 |
| 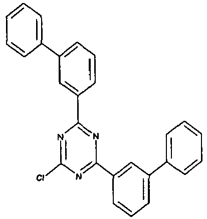 | 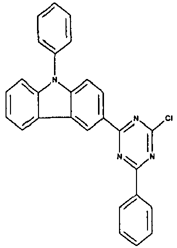 | 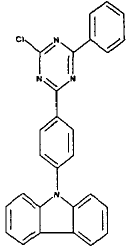 | 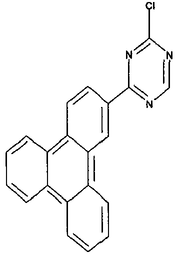 |
| 1205748-61-3 | 1476785-42-8 | 1477759-28-6 | 1404058-67-8 |
| 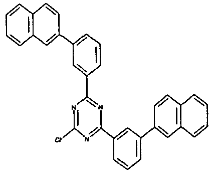 | 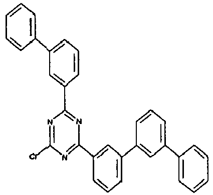 | 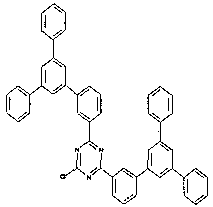 | 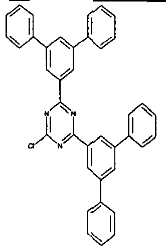 |
| 1253971-19-5 | 1402225-90-4 | 1233200-61-7 | 1205748-51-1 |
| 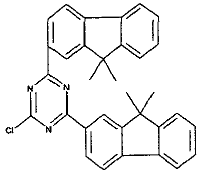 | 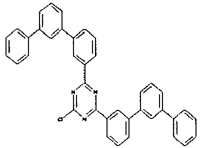 | 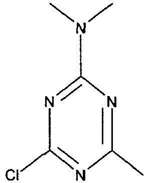 | 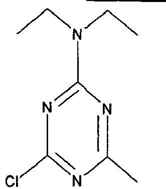 |
| 1459162-69-6 | 1205748-49-7 | 21320-63-8 | 58749-95-4 |
| 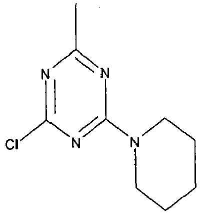 | 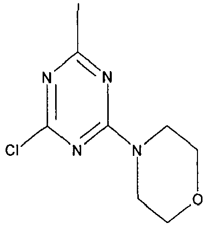 | 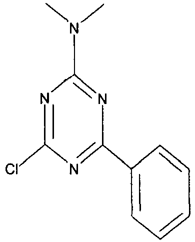 | 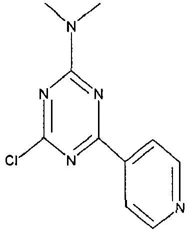 |
| 1071621-58-3 | 57639-20-0 | 36323-70-3 | 36818-25-4 |
| 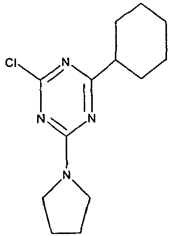 | 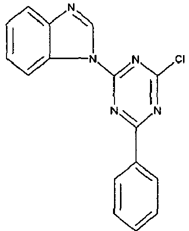 | 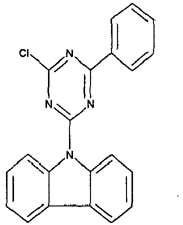 | 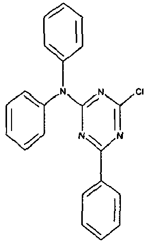 |
| 1426437-56-0 | 1454596-47-4 | 1268244-56-9 | 1260032-07-2 |
| 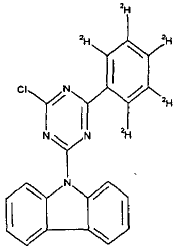 | 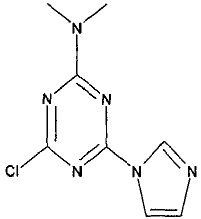 | 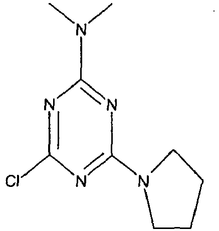 | 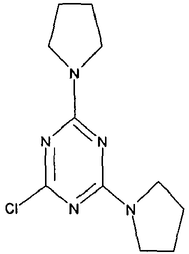 |
| 1480589-64-7 | 153430-09-2 | 189078-42-0 | 111669-20-6 |
| 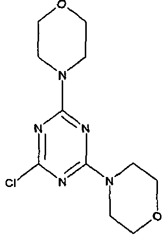 | 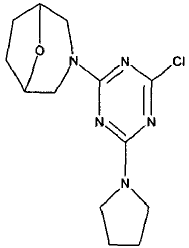 | 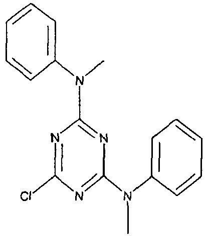 | 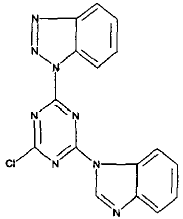 |
| 7597-22-0 | 1197160-83-0 | 3995-43-5 | 1398814-60-2 |
| 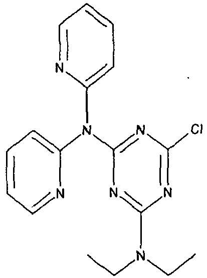 | 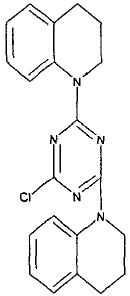 | 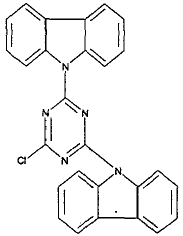 | 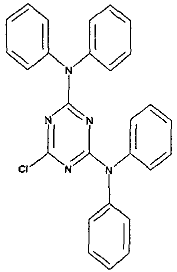 |
| 1492967-74-4 | 489422-72-2 | 877615-05-9 | 83820-01-3 |
| 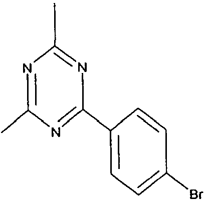 | 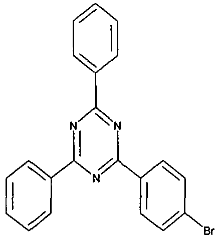 | 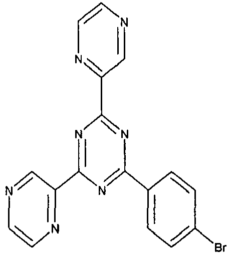 | 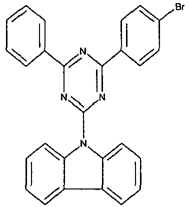 |
| 83253-21-8 | 23449-08-3 | 1016896-86-8 | 1616413-67-2 |
| 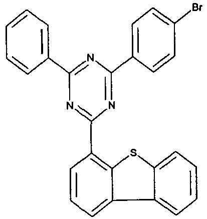 | 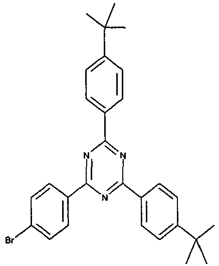 | 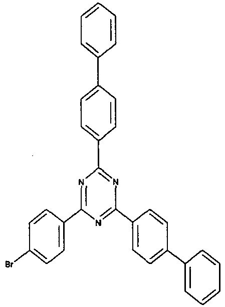 | 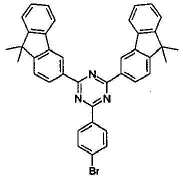 |
| 1476799-07-1 | 927898-18-8 | 877456-11-6 | 1646531-99-8 |
| 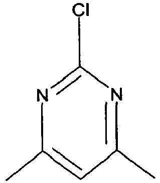 | 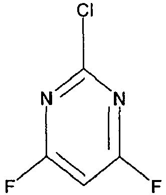 | 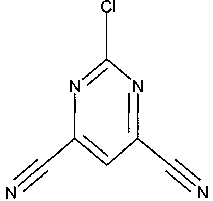 | 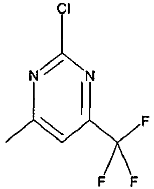 |
| 4472-44-0 | 38953-30-9 | 29872-58-0 | 241164-09-0 |
| 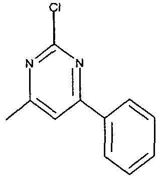 | 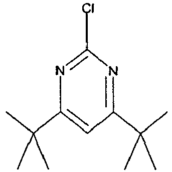 | 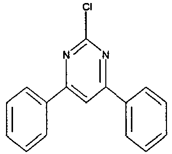 | 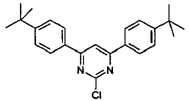 |
| 32785-40-3 | 71162-19-1 | 2915-16-4 | 1035556-77-4 |

### B: Synthese der Liganden

### Beispiel L47: 5-Brom-2-(1,1,2,2,3,3-hexamethyl-indan-5-yl)-pyridin

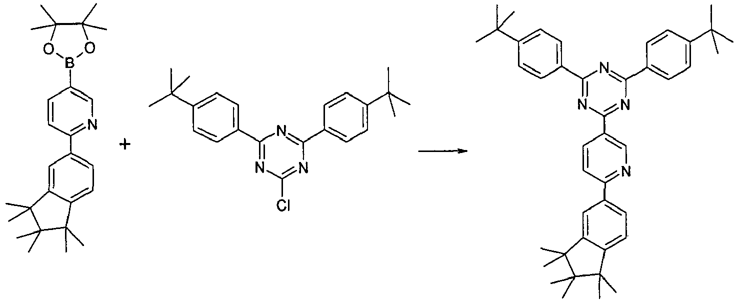

Zu 35 g (86,3 mmol) S2 werden 33 g (86,9 mmol) 2,4-Bis-(4-tert-butylphenyl)-6-chlor-[1,3,5]-triazin **S4**, 1 g (4,5 mmol) Palladium(II)acetat, 2,7 g (8,9 mmol) Tri-o-tolylphosphin [6163-58-2], 55 g (259,4 mmol) wasserfreies Kaliumphosphat eingewogen, inertisiert und mit 1 L Toluol, 500 ml Wasser und 500 ml 1,4-Dioxan versetzt. Die Reaktionsmischung wird 24 h unter Rückfluss gerührt. Nach Abkühlen rotiert man die Reaktionsmischung bis zur Trockene ein und reinigt den Rückstand säulenchromatographisch per Kieselgel und Toluol/Heptan (1:1) als Eluent. Der ölige Rückstand wird mit Methanol ausgekocht, abfiltriert und getrocknet. Es werden 37,6 g (60,4 mmol, 70%) eines farblosen Feststoffes L47 erhalten.

Analog der Vorschrift können weiterhin folgende Liganden swerden:

| Synthone | S1 | S1 | S1 | S1 |
|---|---|---|---|---|
| | 6153-86-2 | 444666-43-7 | 1451154-67-8 | 30894-84-9 |
| Ausbeute | 31% | 45% | 35% | 45% |
| Ligand | 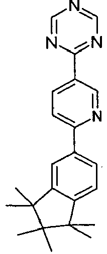 | 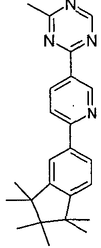 | 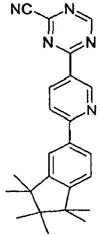 | 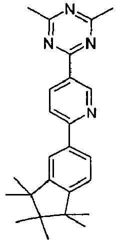 |
| | **L1** | **L2** | **L3** | **L4** |

| 696-85-5 | 352440-04-1 | 27676-51-3 | 80587-76-4 | |
|---|---|---|---|---|
| Ausbeute | 38% | 47% | 41% | 31% |
| Ligand | 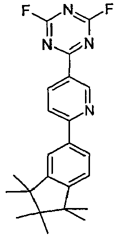 | 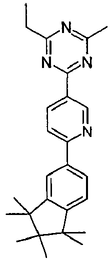 | 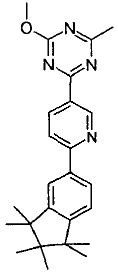 | 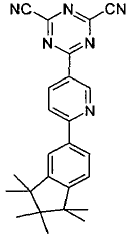 |
| | **L5** | **L6** | **L7** | **L8** |
| | | | | |

| Synthone | S1 | S1 | S1 | S1 |
|---|---|---|---|---|
| | 77007-96-6 | 0937-70-3 | 701-77-9 | 333737-07-8 |
| Ausbeute | 47% | 53% | 49% | 39% |
| Ligand | 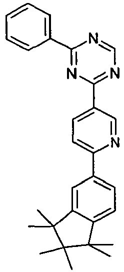 | 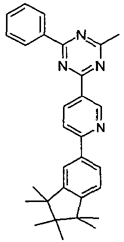 | 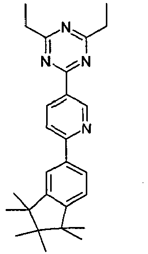 | 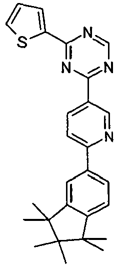 |
| | **L9** | **L10** | **L11** | **L12** |
| | | | | |

| Synthone | S1 | S1 | S1 | S1 |
|---|---|---|---|---|
| | 3140-73-6 | 911798-79-3 | 73084-03-4 | 1092838-33-9 |
| Ausbeute | 46% | 64% | 62% | 65% |
| Ligand | 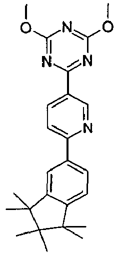 | 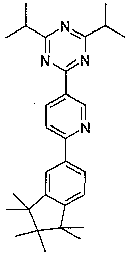 | 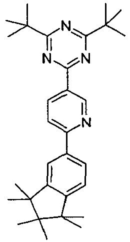 | 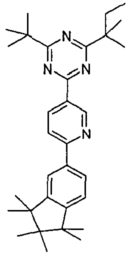 |
| | **L13** | **L14** | **L15** | **L16** |

| 3842-55-5 | 91688-04-9 | 1426441-17-9 | 1426434-95-8 | |
|---|---|---|---|---|
| Ausbeute | 71% | 62% | 45% | 69% |
| Ligand | 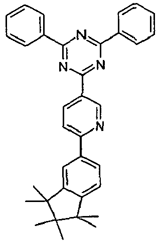 | 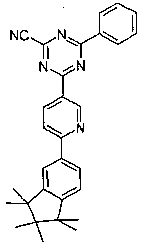 | 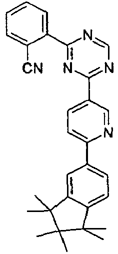 | 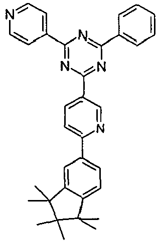 |
| | **L17** | **L18** | **L19** | **L20** |
| | | | | |

| Synthone | S1 | S1 | S1 | S1 |
|---|---|---|---|---|
| | 22404-35-9 | 36335-91-8 | 61810-06-8 | 78941-28-3 |
| Ausbeute | 67% | 65% | 61% | 74% |
| Ligand | 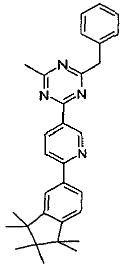 | 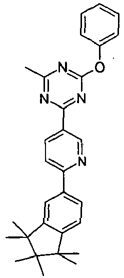 | 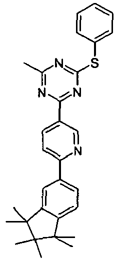 | 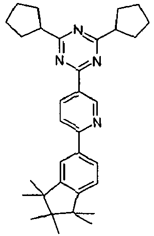 |
| | **L21** | **L22** | **L23** | **L24** |
| | | | | |

| Synthone | S1 | S1 | S1 | S1 |
|---|---|---|---|---|
| | 1477759-31-1 | 1253971-29-7 | 1426435-09-7 | 1092838-05-5 |
| Ausbeute | 71% | 73% | 67% | 68% |
| Ligand | 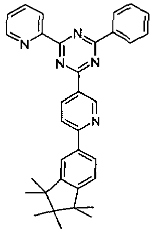 | 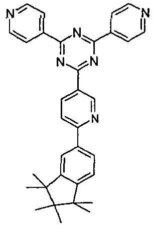 | 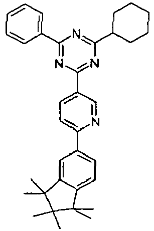 | 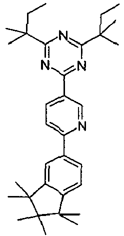 |
| | **L25** | **L26** | **L27** | **L28** |

| 1418124-08-9 | 80984-77-6 | 1345834-25-4 | 21902-34-1 | |
|---|---|---|---|---|
| Ausbeute | 65% | 70% | 55% | 75% |
| Ligand | 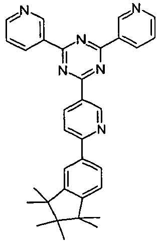 | 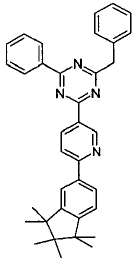 | 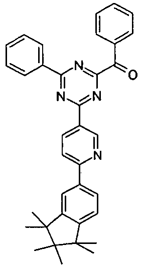 | 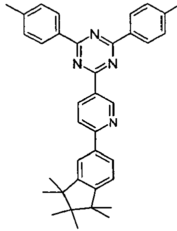 |
| | **L29** | **L30** | **L31** | **L32** |
| | | | | |

| Synthone | S1 | S1 | S1 | S1 |
|---|---|---|---|---|
| | 1342819-12-8 | 2972-65-8 | 78941-35-2 | 80984-76-5 |
| Ausbeute | 70% | 67% | 74% | 77% |
| Ligand | 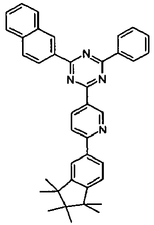 | 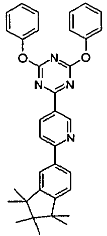 | 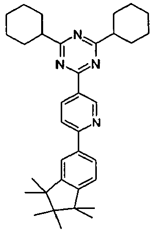 | 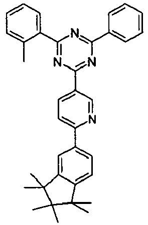 |
| | **L33** | **L34** | **L35** | **L36** |
| | | | | |

| Synthone | S1 | S1 | S1 | S1 |
|---|---|---|---|---|
| | 1472729-25-1 | 1426437-66-2 | 78941-32-9 | 38164-03-3 |
| Ausbeute | 72% | 67% | 65% | 73% |
| Ligand | 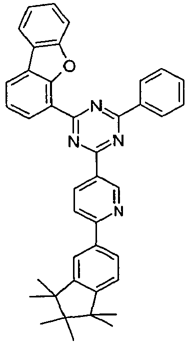 | 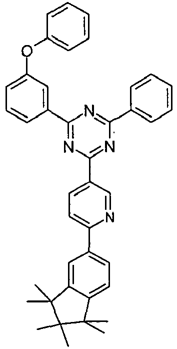 | 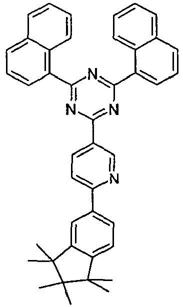 | 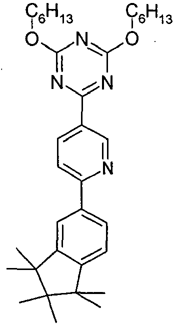 |
| | **L37** | **L38** | **L39** | **L40** |
| | | | | |

| Synthone | S1 | S1 | S1 | S1 |
|---|---|---|---|---|
| | 1472062-94-4 | 736-68-5 | 1383780-97-9 | 253133-88-9 |
| Ausbeute | 70% | 76% | 72% | 75% |
| Ligand | 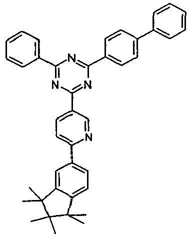 | 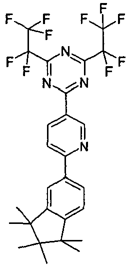 | 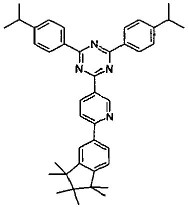 | 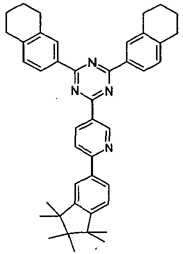 |
| | L41 | L42 | L43 | L44 |
| | | | | |

| Synthone | S1 | S1 | S1 | S1 |
|---|---|---|---|---|
| | 1092838-15-7 | 1015814-06-8 | 253158-13-3 | 1387596-01-1 |
| Ausbeute | 70% | 55% | 70% | 78% |
| Ligand | 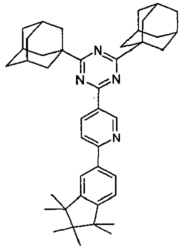 | 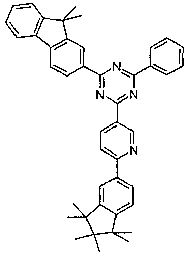 | 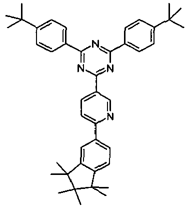 | 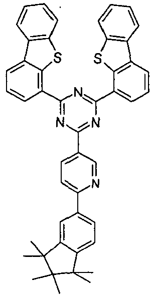 |
| | L45 | L46 | L47 | L48 |

| 1205748-61-3 | 1476785-42-8 | 1477759-28-6 | 1404058-67-8 | |
|---|---|---|---|---|
| Ausbeute | 51% | 70% | 70% | 58% |
| Ligand | 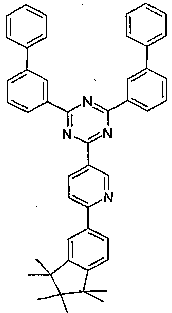 | 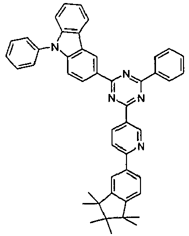 | 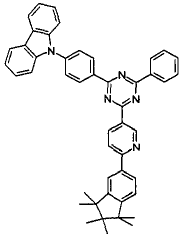 | 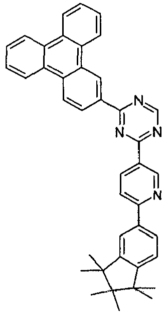 |
| | L49 | L50 | L51 | L52 |
| | | | | |

| Synthone | S1 | S1 | S1 | S1 |
|---|---|---|---|---|
| | 1253971-19-5 | 1402225-90-4 | 1233200-61-7 | 1205748-51-1 |
| Ausbeute | 67% | 76% | 73% | 74% |
| Ligand | 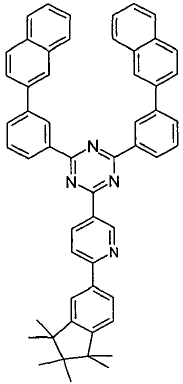 | 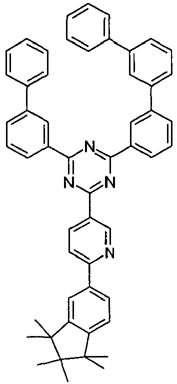 | 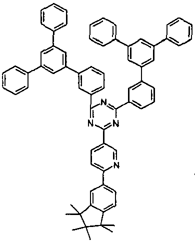 | 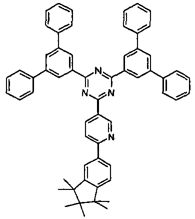 |
| | L53 | L54 | L55 | L56 |
| | | | | |

| Synthone | S1 | S1 | S1 | S1 |
|---|---|---|---|---|
| | 1459162-69-6 | 1205748-49-7 | 21320-63-8 | 58749-95-4 |
| Ausbeute | 76% | 71% | 57% | 60% |
| Ligand | 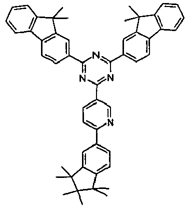 | 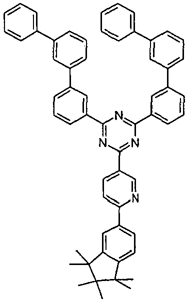 | 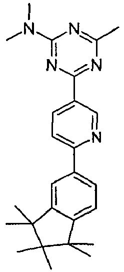 | 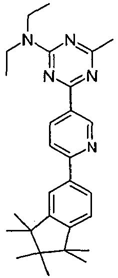 |
| | L57 | L58 | L59 | L60 |
| | | | | |

| Synthone | S1 | S1 | S1 | S1 |
|---|---|---|---|---|
| | 1071621-58-3 | 57639-20-0 | 36323-70-3 | 36818-25-4 |
| Ausbeute | 58% | 55% | 61% | 66% |
| Ligand | 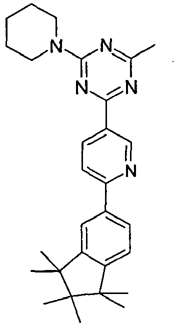 | 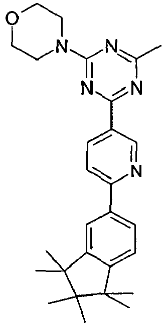 | 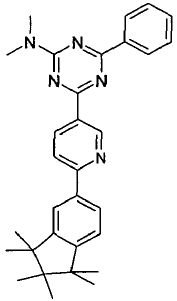 | 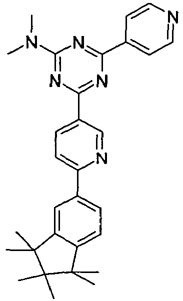 |
| | L61 | L62 | L63 | L64 |
| | | | | |

| Synthone | S1 | S1 | S1 | S1 |
|---|---|---|---|---|
| | 1426437-56-0 | 1454596-47-4 | 1268244-56-9 | 1260032-07-2 |
| Ausbeute | 61% | 52% | 77% | 72% |
| Ligand | 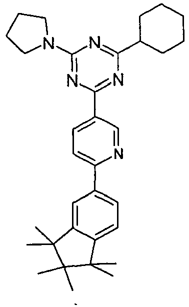 | 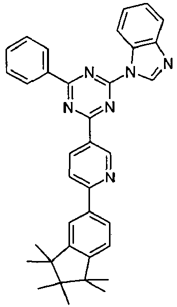 | 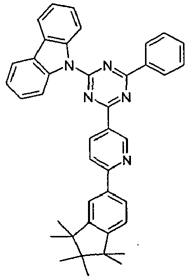 | 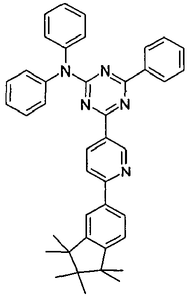 |
| | L65 | L66 | L67 | L68 |
| | | | | |

| Synthone | S1 | S1 | S1 | S1 |
|---|---|---|---|---|
| | 1480589-64-7 | 153430-09-2 | 189078-42-0 | 111669-20-6 |
| Ausbeute | 72% | 44% | 56% | 57% |
| Ligand | 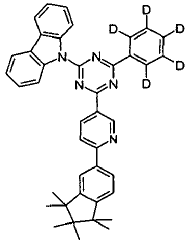 | 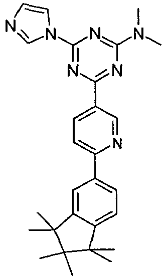 | 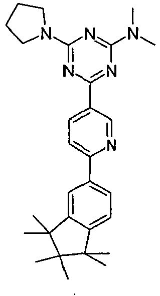 | 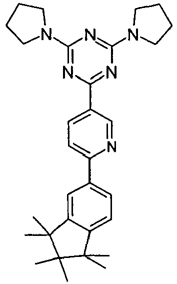 |
| | L69 | L70 | L71 | L72 |
| | | | | |

| Synthone | S1 | S1 | S1 | S1 |
|---|---|---|---|---|
| | 7597-22-0 | 1197160-83-0 | 3995-43-5 | 1398814-60-2 |
| Ausbeute | 55% | 59% | 69% | 56% |
| Ligand | 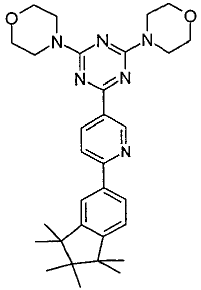 | 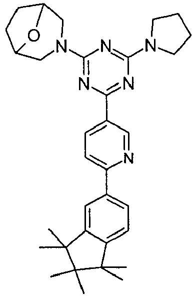 | 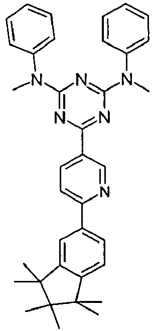 | 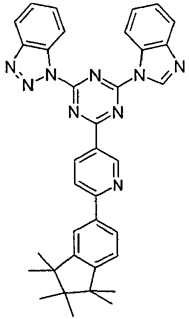 |
| | L73 | L74 | L75 | L76 |
| | | | | |

| Synthone | S1 | S1 | S1 | S1 |
|---|---|---|---|---|
| | 1492967-74-4 | 489422-72-2 | 877615-05-9 | 83820-01-3 |
| Ausbeute | 61% | 59% | 78% | 74% |
| Ligand | 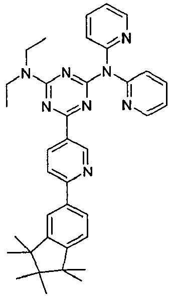 | 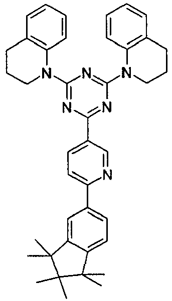 | 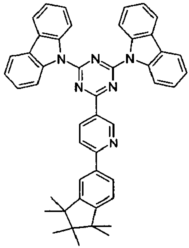 | 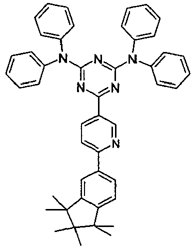 |
| | L77 | L78 | L79 | L80 |
| | | | | |

| Synthone | S1 | S1 | S1 | S1 |
|---|---|---|---|---|
| | 83253-21-8 | 23449-08-3 | 1016896-86-8 | 1616413-67-2 |
| Ausbeute | 81% | 84% | 79% | 83% |
| Ligand | 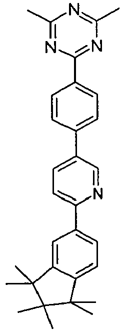 | 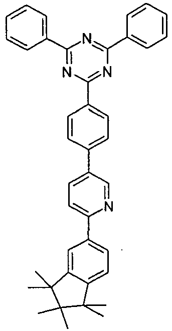 | 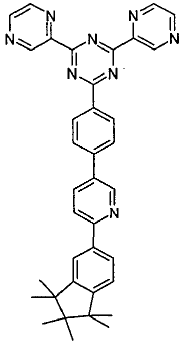 | 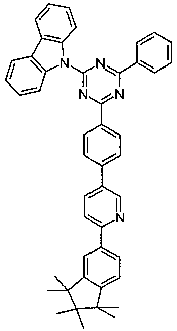 |
| | L81 | L82 | L83 | L84 |
| | | | | |

| Synthone | S1 | S1 | S1 | S1 |
|---|---|---|---|---|
| | 1476799-07-1 | 927898-18-8 | 877456-11-6 | 1646531-99-8 |
| Ausbeute | 85% | 77% | 81% | 77% |
| Ligand | 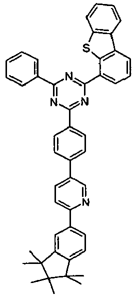 | 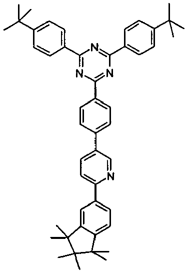 | 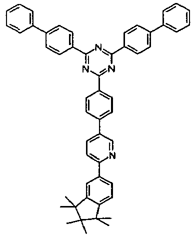 | 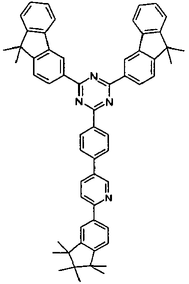 |
| | L85 | L86 | L87 | L88 |
| | | | | |

| Synthone | S1 | S1 | S1 | S1 |
|---|---|---|---|---|
| | 4472-44-0 | 38953-30-9 | 29872-58-0 | 241164-09-0 |
| Ausbeute | 66% | 52% | 44% | 57% |
| Ligand | 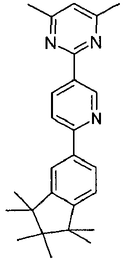 | 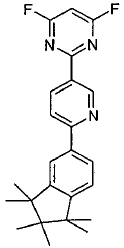 | 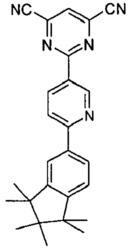 | 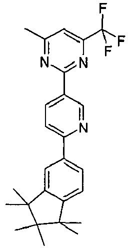 |
| | L89 | L90 | L91 | L92 |

| 71162-19-1 | 32785-40-3 | 2915-16-4 | 1035556-77-4 | |
|---|---|---|---|---|
| Ausbeute | 66% | 69% | 72% | 69% |
| Ligand | 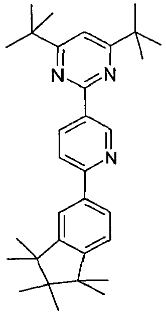 | 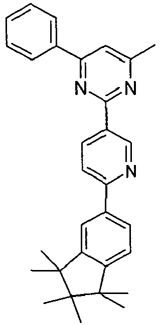 | 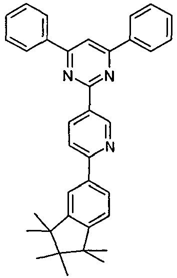 | 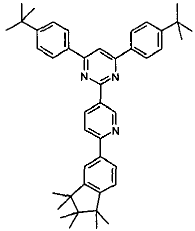 |
| | L93 | L94 | L95 | L96 |
| | | | | |

| Synthone | S2 | S2 | S2 | S2 |
|---|---|---|---|---|
| | 30894-84-9 | 696-85-5 | 0937-70-3 | 73084-03-4 |
| Ausbeute | 58% | 51% | 63% | 74% |
| Ligand | 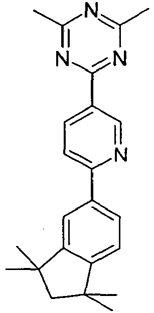 | 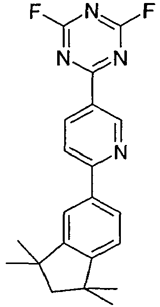 | 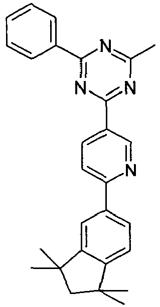 | 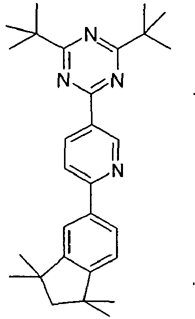 |
| | L97 | L98 | L99 | L100 |
| | | | | |

| Synthone | S2 | S2 | S2 | S2 |
|---|---|---|---|---|
| | 3842-55-5 | 78941-35-2 | 1472729-25-1 | 78941-32-9 |
| Ausbeute | 74% | 71% | 77% | 65% |
| Ligand | 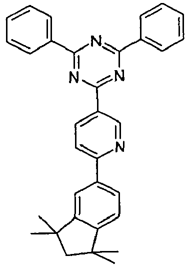 | 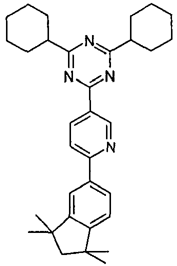 | 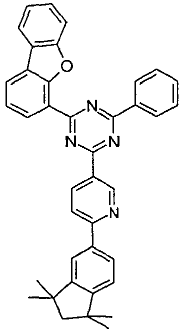 | 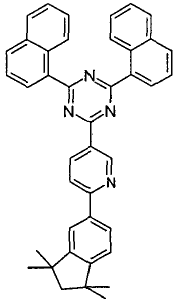 |
| | L101 | L102 | L103 | L104 |
| | | | | |

| Synthone | S2 | S2 | S2 | S2 |
|---|---|---|---|---|
| | 253158-13-3 | 1476785-42-8 | 1233200-61-7 | 1459162-69-6 |
| Ausbeute | 74% | 71% | 75% | 72% |
| Ligand | 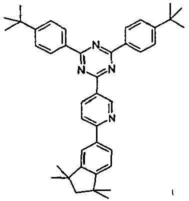 | 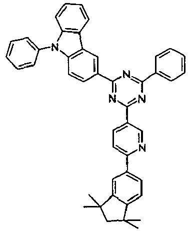 | 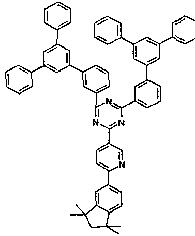 | 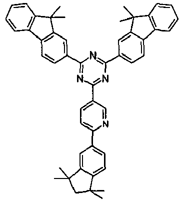 |
| | L105 | L106 | L107 | L108 |
| | | | | |

| Synthone | S2 | S2 | S2 | S2 |
|---|---|---|---|---|
| | 1205748-49-7 | 36323-70-3 | 3995-43-5 | 1268244-56-9 |
| Ausbeute | 70% | 66% | 68% | 73% |
| Ligand | 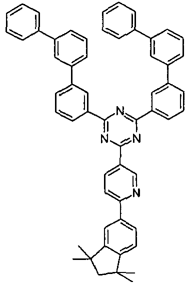 | 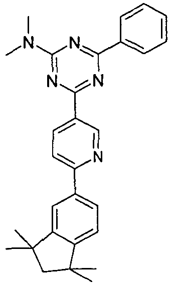 | 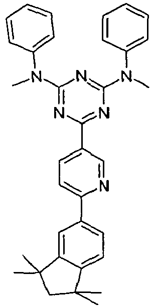 | 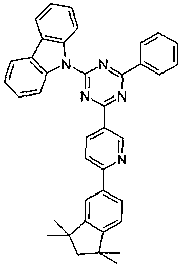 |
| | L109 | L110 | L111 | L112 |

| 1260032-07-2 | 927898-18-8 | 71162-19-1 | 2915-16-4 | |
|---|---|---|---|---|
| Ausbeute | 74% | 78% | 72% | 71% |
| Ligand | 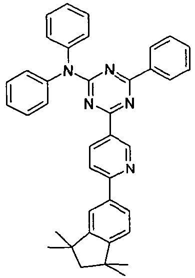 | 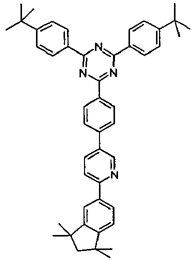 | 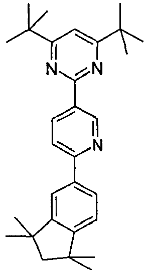 | 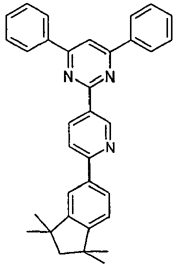 |
| | L113 | L114 | L115 | L116 |
| | | | | |

| Synthone | S3 | S3 | S4 | S4 |
|---|---|---|---|---|
| | 253158-13-3 | 73084-03-4 | 253158-13-3 | 1233200-61-7 |
| Ausbeute | 75% | 73% | 77% | 79% |
| Ligand | 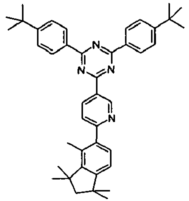 | 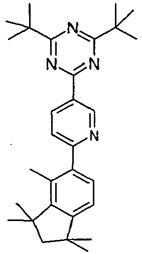 | 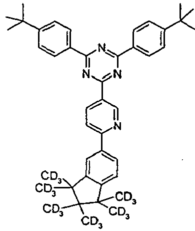 | 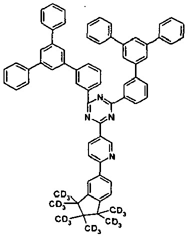 |
| | L117 | L118 | L119 | L120 |
| | | | | |

| Synthone | S5 | S | S6 | S6 |
|---|---|---|---|---|
| | 253158-13-3 | 73084-03-4 | 253158-13-3 | 73084-03-4 |
| Ausbeute | 77% | 82% | 76% | 71% |
| Ligand | 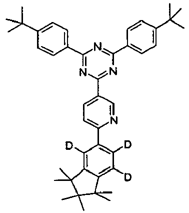 | 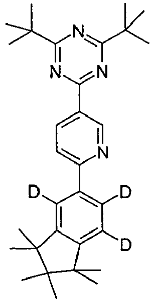 | 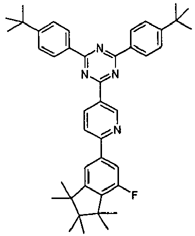 | 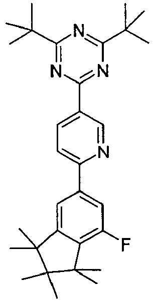 |
| | L121 | L122 | L123 | L124 |
| | | | | |

| Synthone | S7 | S7 | S8 | S8 |
|---|---|---|---|---|
| | 1205748-49-7 | 0937-70-3 | 3842-55-5 | 253158-13-3 |
| Ausbeute | 73% | 66% | 73% | 77% |
| Ligand | 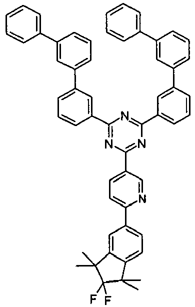 | 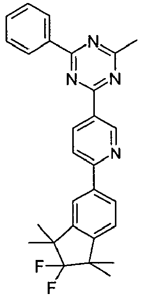 | 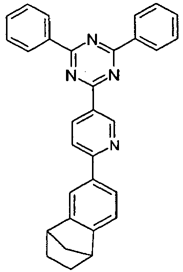 | 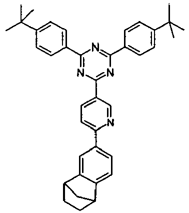 |
| | L125 | L126 | L127 | L128 |
| | | | | |

| Synthone | S9 | S9 | S10 | S10 |
|---|---|---|---|---|
| | 1260032-07-2 | 71162-19-1 | 1459162-69-6 | 83253-21-8 |
| Ausbeute | 71% | 69% | 75% | 82% |
| Ligand | 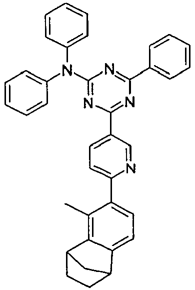 | 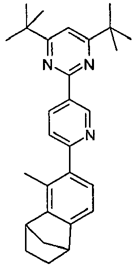 | 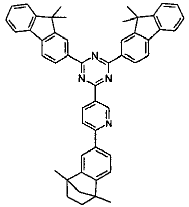 | 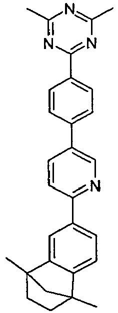 |
| | L129 | L130 | L131 | L132 |
| | | | | |

| Synthone | S11 | S11 | S12 | S12 |
|---|---|---|---|---|
| | 3842-55-5 | 78941-35-2 | 32785-40-3 | 1260032-07-2 |
| Ausbeute | 66% | 73% | 68% | 64% |
| Ligand | 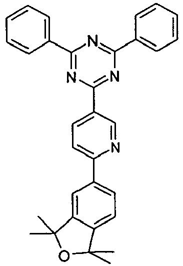 | 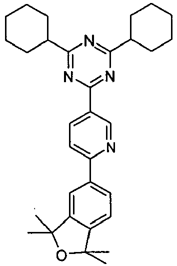 | 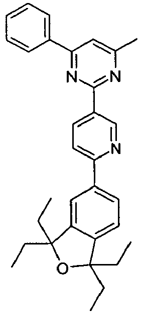 | 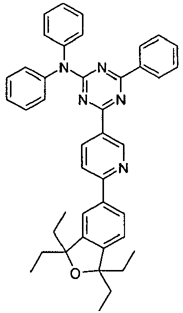 |
| | L133 | L134 | L135 | L136 |
| | | | | |

| Synthone | S13 | S13 | S14 | S14 |
|---|---|---|---|---|
| | 1472729-25-1 | 1205748-49-7 | 253158-13-3 | 73084-03-4 |
| Ausbeute | 70% | 68% | 59% | 63% |
| Ligand | 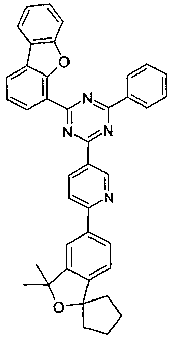 | 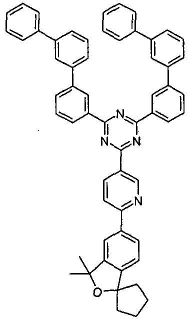 | 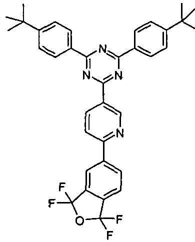 | 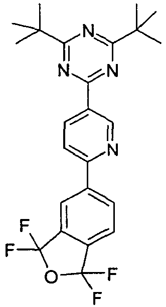 |
| | L137 | L138 | L139 | L140 |
| | | | | |

| Synthone | S15 | S15 | S16 | S16 |
|---|---|---|---|---|
| | 1260032-07-2 | 927898-18-8 | 36323-70-3 | 3995-43-5 |
| Ausbeute | 73% | 83% | 64% | 59% |
| Ligand | 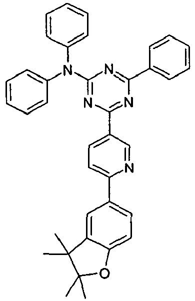 | 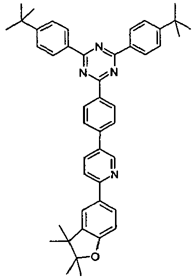 | 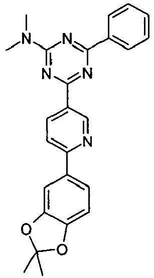 | 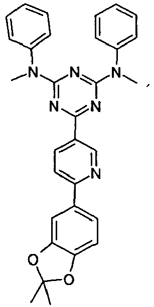 |
| | L141 | L142 | L143 | L144 |
| | | | | |

| Synthone | S17 | S17 | S18 | S18 |
|---|---|---|---|---|
| | 73084-03-4 | 253158-13-3 | 32785-40-3 | 2915-16-4 |
| Ausbeute | 72% | 75% | 66% | 72% |
| Ligand | 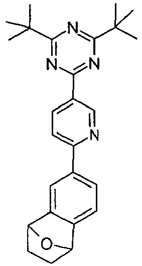 | 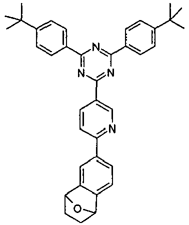 | 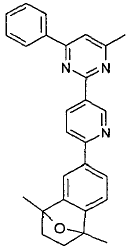 | 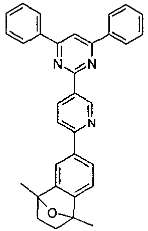 |
| | L145 | L146 | L147 | L148 |
| | | | | |

| Synthone | S19 | S19 | S20 | S20 |
|---|---|---|---|---|
| | 696-85-5 | 1383780-97-9 | 1477759-28-6 | 1476785-42-8 |
| Ausbeute | 57% | 79% | 72% | 72% |
| Ligand | 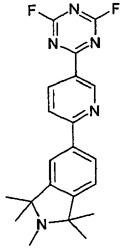 | 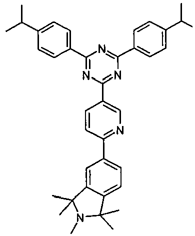 | 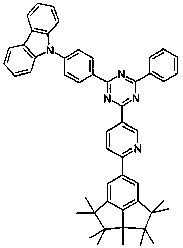 | 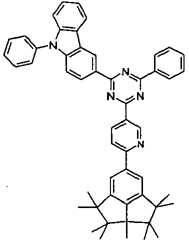 |
| | L149 | L150 | L151 | L152 |
| | | | | |

| Synthone | S21 | S21 | S22 | S22 |
|---|---|---|---|---|
| | 73084-03-4 | 253158-13-3 | 73084-03-4 | 253158-13-3 |
| Ausbeute | 65% | 61% | 59% | 61% |
| Ligand | 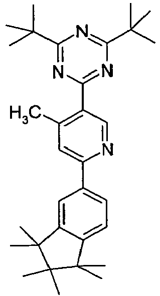 | 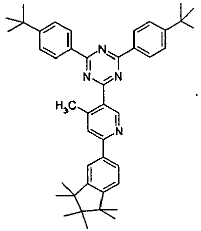 | 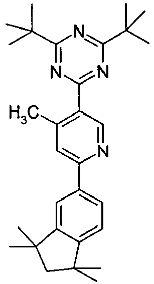 | 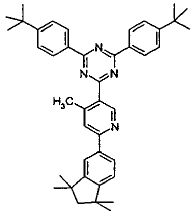 |
| | L153 | L154 | L155 | L156 |
| | | | | |

| Synthone 61% | S23 | S23 | S24 | S24 |
|---|---|---|---|---|
| | 253158-13-3 | 32785-40-3 | 927898-18-8 | 36323-70-3 |
| Ausbeute | 61% | 57% | 59% | 63% |
| Ligand | 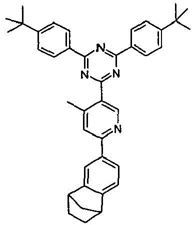 | 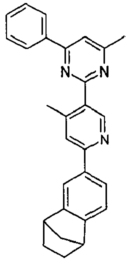 | 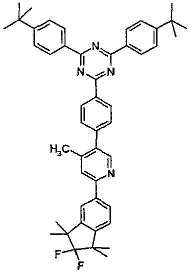 | 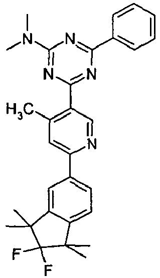 |
| | L157 | L158 | L159 | L160 |
| | | | | |

| Synthone | S25 | S25 | S26 | S26 |
|---|---|---|---|---|
| | 1472729-25-1 | 1233200-61-7 | 111669-20-6 | 1205748-49-7 |
| Ausbeute | 59% | 55% | 58% | 47% |
| Ligand | 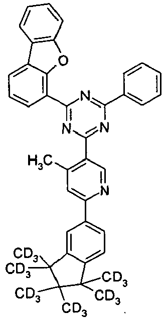 | 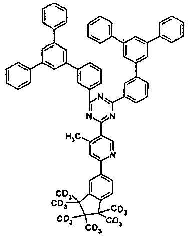 | 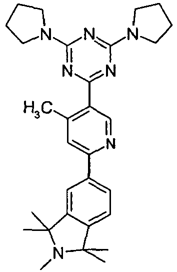 | 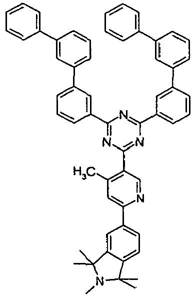 |
| | L161 | L162 | L163 | L164 |
| | | | | |

| Synthone | S27 | S27 | S28 | S28 |
|---|---|---|---|---|
| | 1398814-60-2 | 253158-13-3 | 1260032-07-2 | 1205748-49-7 |
| Ausbeute | 45% | 56% | 65% | 63% |
| Ligand | 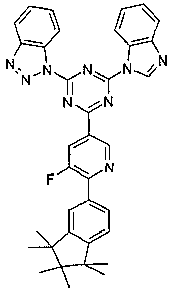 | 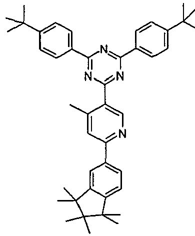 | 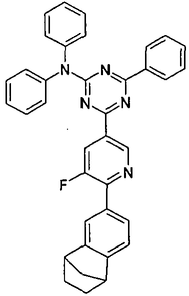 | 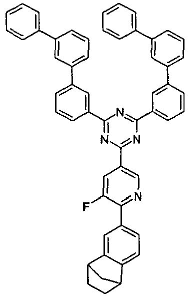 |
| | L165 | L166 | L167 | L168 |
| | | | | |

| Synthone | S29 | S29 | S30 | S30 |
|---|---|---|---|---|
| | 3842-55-5 | 71162-19-1 | 83253-21-8 | 1454596-47-4 |
| Ausbeute | 63% | 67% | 69% | 55% |
| Ligand | 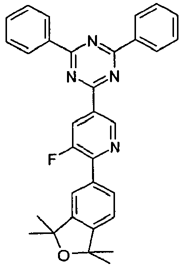 | 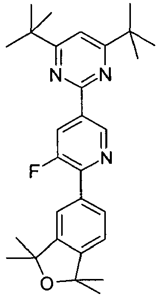 | 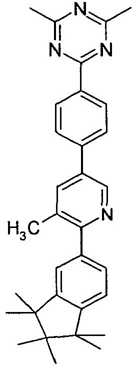 | 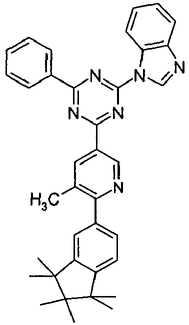 |
| | L169 | L170 | L171 | L172 |
| | | | | |

| Synthone | S31 | S31 | S32 | S32 |
|---|---|---|---|---|
| | 696-85-5 | 36323-70-3 | 1205748-49-7 | 1459162-69-6 |
| Ausbeute | 49% | 55% | 62% | 67% |
| Ligand | 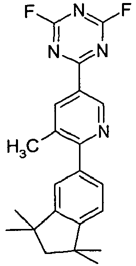 | 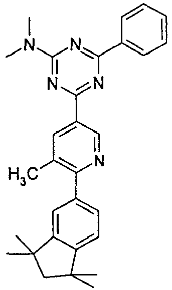 | 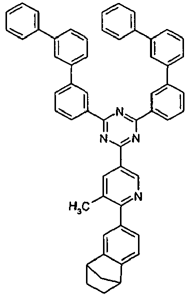 | 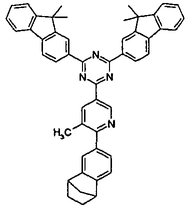 |
| | L173 | L174 | L175 | L176 |
| | | | | |

| Synthone | S33 | S33 | S34 | S34 |
|---|---|---|---|---|
| | 3995-43-5 | 489422-72-2 | 253158-13-3 | 1477759-28-6 |
| Ausbeute | 62% | 71% | 66% | 62% |
| Ligand | 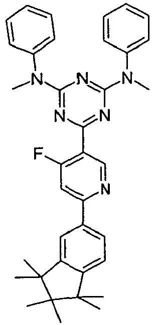 | 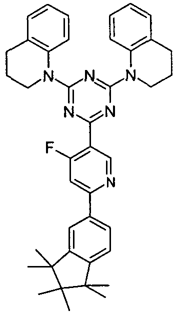 | 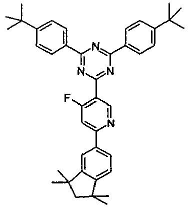 | 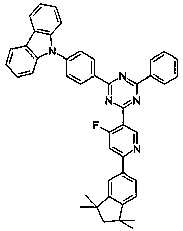 |
| | L177 | L178 | L179 | L180 |
| | | | | |

| Synthone | S35 | S35 | S36 | S36 |
|---|---|---|---|---|
| | 73084-03-4 | 1233200-61-7 | 253158-13-3 | 73084-03-4 |
| Ausbeute | 55% | 61% | 58% | 53% |
| Ligand | 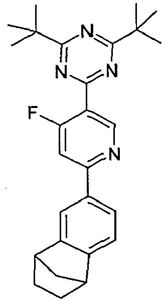 | 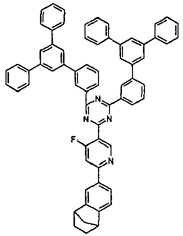 | 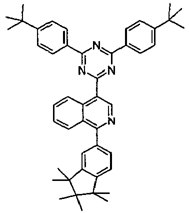 | 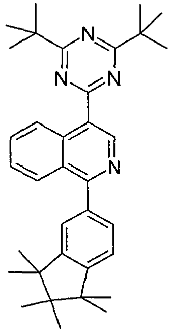 |
| | L181 | L182 | L183 | L184 |
| | | | | |

| Synthone | S37 | S37 | S38 | S38 |
|---|---|---|---|---|
| | 1260032-07-2 | 1477759-28-6 | 927898-18-8 | 1268244-56-9 |
| Ausbeute | 57% | 52% | 42% | 50% |
| Ligand | 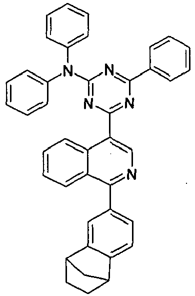 | 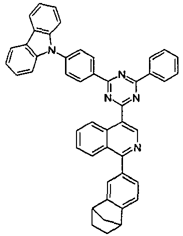 | 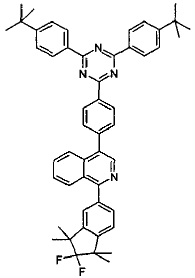 | 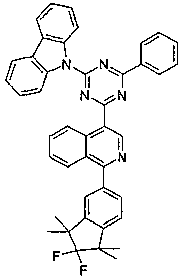 |
| | L185 | L186 | L187 | L188 |
| | | | | |

| Synthone | S39 | S39 | S40 | S40 |
|---|---|---|---|---|
| | 1646531-99-8 | 29872-58-0 | 1402225-90-4 | 1268244-56-9 |
| Ausbeute | 81% | 47% | 67% | 53% |
| Ligand | 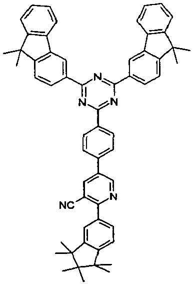 | 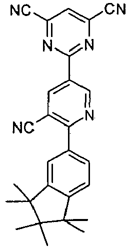 | 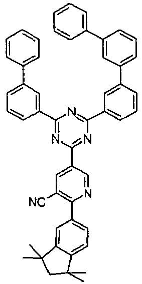 | 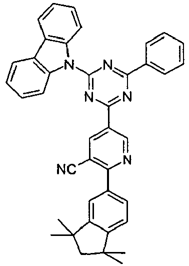 |
| | L189 | L190 | L191 | L192 |
| | | | | |

| Synthone | S41 | S41 | S42 | S42 |
|---|---|---|---|---|
| | 1383780-97-9 | 1477759-28-6 | 0937-70-3 | 3842-55-5 |
| Ausbeute | 67% | 63% | 69% | 73% |
| Ligand | 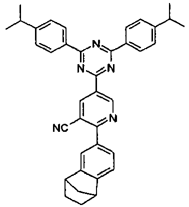 | 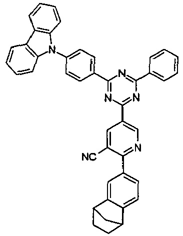 | 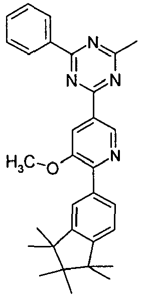 | 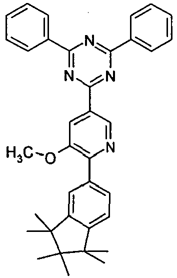 |
| | L193 | L194 | L195 | L196 |
| | | | | |

| Synthone | S43 | S43 | S44 | S44 |
|---|---|---|---|---|
| | 489422-72-2 | 71162-19-1 | 36323-70-3 | 29872-58-0 |
| Ausbeute | 67% | 68% | 62% | 59% |
| Ligand | 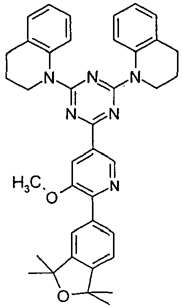 | 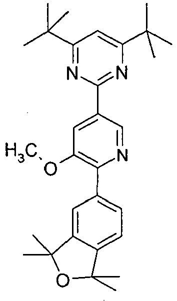 | 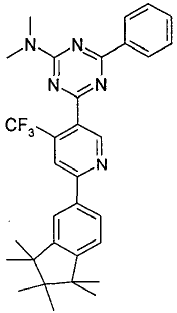 | 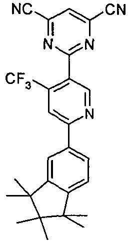 |
| | L197 | L198 | L199 | L200 |

| Synthone | S45 | S45 | S46 | S46 |
|---|---|---|---|---|
| | 83253-21-8 | 253158-13-3 | 1260032-07-2 | 927898-18-8 |
| Ausbeute | 55% | 47% | 47% | 40% |
| Ligand | 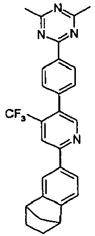 | 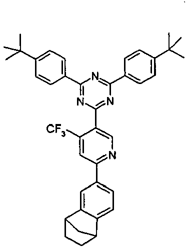 | 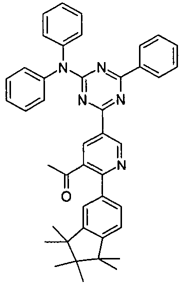 | 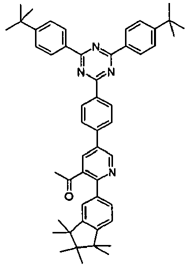 |
| | L201 | L202 | L203 | L204 |
| | | | | |

| Synthone | S47 | S47 | S48 | S48 |
|---|---|---|---|---|
| | 1454596-47-4 | 1454596-47-4 | 153430-09-2 | 57639-20-0 |
| Ausbeute | 64% | 64% | 69% | 65% |
| Ligand | 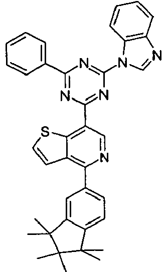 | 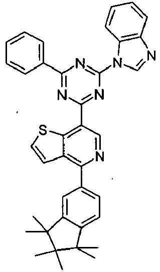 | 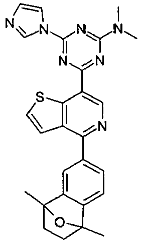 | 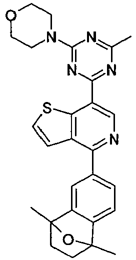 |
| | L205 | L206 | L207 | L208 |
| | | | | |

| Synthone | S49 | S49 | S50 | S50 |
|---|---|---|---|---|
| | 1459162-69-6 | 36818-25-4 | 78941-35-2 | 1472729-25-1 |
| Ausbeute | 56% | 62% | 43% | 38% |
| Ligand | 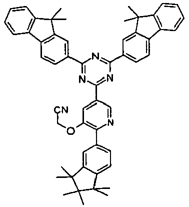 | 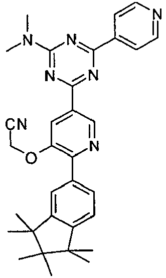 | 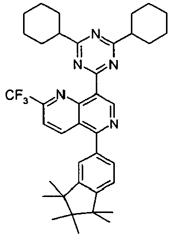 | 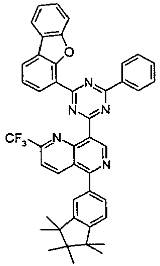 |
| | L209 | L210 | L211 | L212 |
| | | | | |

| Synthone | S51 | S51 | S52 | S52 |
|---|---|---|---|---|
| | 3842-55-5 | 78941-35-2 | 1472729-25-1 | 78941-32-9 |
| Ausbeute | 39% | 40% | 42% | 35% |
| Ligand | 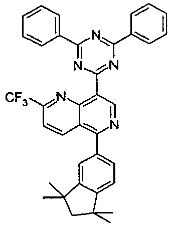 | 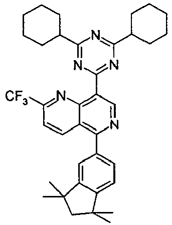 | 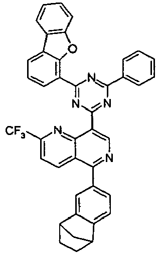 | 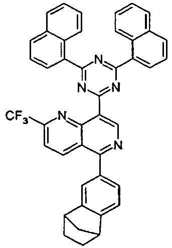 |
| | L213 | L214 | L215 | L216 |
| | | | | |

| Synthone | S53 | S53 | S54 | S54 |
|---|---|---|---|---|
| | 71162-19-1 | 83253-21-8 | 1383780-97-9 | 1477759-28-6 |
| Ausbeute | 59% | 68% | 63% | 58% |
| Ligand | 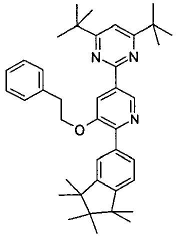 | 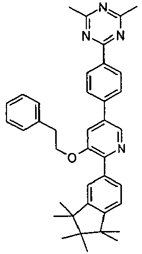 | 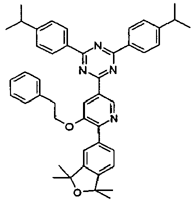 | 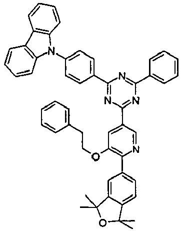 |
| | L217 | L218 | L219 | L220 |

| Synthone | S55 | S55 | S1 | |
|---|---|---|---|---|
| | 1383780-97-9 | 489422-72-2 | S1000 | |
| Ausbeute | 63% | 65% | 58% | |
| Ligand | 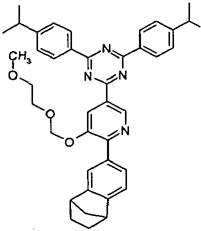 | 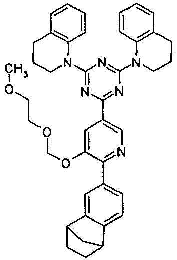 | 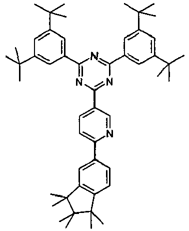 | |
| | L221 | L222 | L223 | |

### Synthese der Metallkomplexe

### 1) Homoleptische tris-faciale Iridium-Komplexe vom Phenyl-Pyridin-, Phenyl-Imidazol- bzw. Phenyl-Benzimidazol-Typ

### Variante A: Tris-acetylacetonato-iridium(III) als Iridium-Edukt

Ein Gemisch aus 10 mmol Tris-acetylacetonato-iridium(III) [15635-87-7] und 40-60 mmol (bevorzugt 40 mmol) des Liganden L, gegebenenfalls 1-10 g - typischerweise 3 g - eines inerten hochsiedenden Zusatzes als Schmelzhilfe bzw. Lösungsmittel, z. B. Hexadecan, m-Terphenyl, Triphenylen, Bisphenylether, 3-Phenoxytoluol, 1,2-, 1,3-, 1,4-Bis-phenoxybenzol, Triphenylphosphinoxid, Sulfolan, 18-Krone-6, Triethylenglykol, Glycerin, Polyethylenglykole, Phenol, 1-Naphthol, Hydrochinon, etc., und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Um eine Sublimation der Liganden an kältere Stellen der Ampulle zu vermeiden, muss die gesamte Ampulle die angegebene Temperatur besitzen. Alternativ kann die Synthese in einem Rührautoklaven mit Glaseinsatz erfolgen. Nach Erkalten (ACHTUNG: die Ampullen stehen meist unter Druck!) wird die Ampulle geöffnet, der Sinterkuchen wird mit 100 g Glaskugeln (3 mm Durchmesser) in 100 ml eines Suspensionsmittels (das Suspensionsmittel wird so gewählt, dass der Ligand gut, der Metallkomplex jedoch schlecht darin löslich ist, typische Suspensionsmittel sind Methanol, Ethanol, Dichlormethan, Aceton, THF, Ethylacetat, Toluol, etc.) 3 h gerührt und dabei mechanisch aufgeschlossen. Man dekantiert die feine Suspension von den Glaskugeln ab, saugt den Feststoff ab, wäscht mit 50 ml des Suspensionsmittels nach und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit einem Extraktionsmittel (Vorlagemenge ca. 500 ml, das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol, halogenierte aliphatische Kohlenwasserstoffe sind in der Regel ungeeignet, da sie die Komplexe gegebenenfalls halogenieren oder zersetzen) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metallkomplexes mittels NMR und / oder HPLC bestimmt. Liegt die Reinheit unter 99.5% wird der Heißextraktionsschritt wiederholt, wobei ab der 2. Extraktion das Alox-Bett weggelassen wird. Ist eine Reinheit von 99.5 - 99.9% erreicht, wird der Metallkomplex getempert oder chromatographiert. Das Tempern erfolgt im Hochvakuum (p ca. 10⁻⁶ mbar) im Temperaturbereich von ca. 200 - 300 °C. Gut in organischen Lösungsmitteln lösliche Komplexe können alternativ auch an Kieselgel chromatograpiert werden.

Werden chirale Liganden eingesetzt, fallen die abgeleiteten fac-Metallkomplexe als Diastereomerenmischung an. Die Enantiomere Λ,Δ der Punktgruppe C3 weisen in der Regel eine deutlich geringere Löslichkeit im Extraktionsmittel auf als die Enatiomeren der Punktgruppe C1, die sich folglich in der Mutterlauge anreichern. Eine Trennung der C3- von den C1-Diasteromeren auf diesem Wege ist häufig möglich. Daneben können die Diastereomeren auch chromatographisch getrennt werden. Werden Liganden der Punktgruppe C1 enantiomerenrein eingesetzt, entsteht ein Diasteromerenpaar Λ,Δ der Punktgruppe C3. Die Diastereomeren können durch Kristallisation oder Chromatographie getrennt und damit als enantiomerenreine Verbindungen erhalten werden.

### Variante B: Tris-(2,2,6,6-tetramethyl-3,5-heptandionato)iridium(III) als Iridium-Edukt

Durchführung analog zu Variante A, wobei anstelle von 10 mmol Tris-acetylacetonato-iridium(III) [15635-87-7] 10 mmol Tris-(2,2,6,6-tetramethyl-3,5-heptandionato)iridium [99581-86-9] eingesetzt werden. Die Verwendung dieses Edukts ist vorteilhaft, da die Reinheit der erhaltenen Rohprodukte häufig besser ist als bei Variante A. Außerdem ist der Druckaufbau in der Ampulle häufig nicht so ausgeprägt.

### Variante C: Natrium[cis,trans-dichloro-bis(acetylacetonato)]iridat(III) als Iridium-Edukt

Ein Gemisch aus 10 mmol Natrium[cis,trans-di-chloro-bis(acetyl-acetonato)]iridat(III) [876296-21-8] und 60 mmol das Liganden in 50 ml Ethylen-, Propylen- oder Diethylenglykol wird unter einem leichten Argonstrom für die angegebene Zeit unter schwachem Rückfluss erhitzt. Nach Erkalten auf 60 °C verdünnt man unter Rühren mit einem Gemisch aus 50 ml Ethanol und 50 ml 2 N Salzsäure, rührt 1 h nach, saugt vom ausgefallenen Feststoff ab, wäscht diesen dreimal mit je 30 ml Ethanol und trocknet dann im Vakuum. Reinigung durch Heißextraktion oder Chromatographie und fraktionierte Sublimation, wie unter A beschrieben.

### Variante D:

### Schritt 1:

Ein Gemisch aus 10 mmol Iridiumtrichlorid und 24 mmol des Liganden L und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Nach Erkalten - ACHTUNG: die Ampullen stehen meist unter Druck! - wird die Ampulle geöffnet, der Sinterkuchen wird mit 100 g Glaskugeln (3 mm Durchmesser) in 100 ml des angegebenen Suspensionsmittels (das Suspensionsmittel wird so gewählt, dass der Ligand gut, das Chloro-Dimer der Formel [Ir(L)₂Cl]₂ jedoch schlecht darin löslich ist, typische Suspensionsmittel sind DCM, Aceton, Ethylacetat, Toluol, etc.) 3 h gerührt und dabei mechanisch aufgeschlossen. Man dekantiert die feine Suspension von den Glaskugeln ab, saugt den Feststoff (Ir(L)₂Cl]₂, das noch ca. 2 eq NaCl enthält, nachfolgend das rohe Chloro-Dimer genannt) ab und trocknet diesen im Vakuum.

### Schritt 2:

Das rohe Chloro-Dimer der Formel [Ir(L)₂Cl]₂ wird in 200 ml THF suspendiert, die Suspension wird mit 20 mmol des Liganden L, 20 mmol Silber(I)-trifluoracetat und 30 mmol Kaliumcarbonat versetzt und 24 h unter Rückfluss erhitzt. Nach Erkalten wird das THF im Vakuum entfernt. Der Rückstand wird in 200 ml eines Gemischs aus Ethanol und konz. Ammoniak-Lösung (1:1, vv) aufgenommen. Die Suspension wird 1 h bei Raumtemperatur gerührt, der Feststoff wird abgesaugt, zweimal mit je 50 ml eines Gemischs aus Ethanol und konz. Ammoniak-Lösung (1:1, vv) und zweimal mit je 50 ml Ethanol gewaschen und dann im Vakuum getrocknet. Heißextraktion und Sublimation wie in Variante A.

### Beispiele nach Variante A bis D:

| **Bsp.** | **Ir(L1)₃** | **Ir(L2) ₃** | **Ir(L3) ₃** | **Ir(L4) ₃** |
|---|---|---|---|---|
| Ligand L | L1 | L2 | L3 | L4 |
| Ir-Komplex | 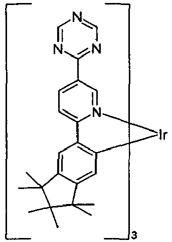 | 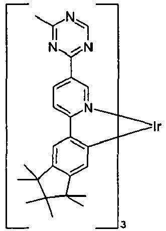 | 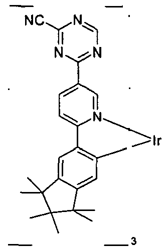 | 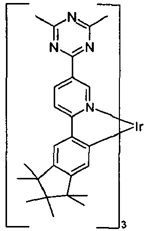 |
| Variante | D | D | D | A |
| Reaktionsmedium | --- | --- | --- | --- |
| Schmelzhilfe | --- | --- | --- | Hydrochinon |
| Reaktionstemp. | 260 °C | 270 °C | 270 °C | 270 °C |
| Reaktionszeit | 24 h | 24 h | 24 h | 24 h |
| Suspensionsmittel | EtOH | EtOH | EtOH | EtOH |
| Extraktionsmittel | m-Dichlorbenzol | Toluol | p-Xylol | Toluol |
| Ausbeute | *12%* | 16% | *4%* | *16%* |
| | | | | |

| **Bsp.** | **Ir(L5) ₃** | **Ir(L6) ₃** | **Ir(L7) ₃** | **Ir(L8) ₃** |
|---|---|---|---|---|
| Ligand L | L5 | L6 | L7 | L8 |
| Ir-Komplex | 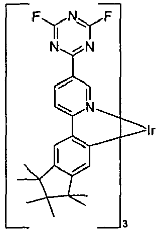 | 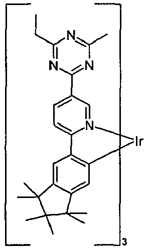 | 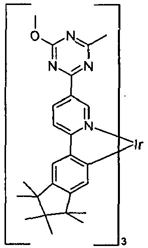 | 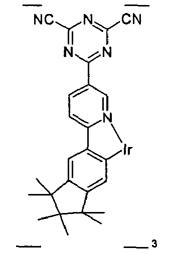 |
| Variante | B | A | A | A |
| Reaktionsmedium | --- | --- | --- | --- |
| Schmelzhilfe | Sulfolan | Hydrochinon | Hydrochinon | Hydrochinon |
| Reaktionstemp. | 285 °C | 270 °C | 260 °C | 260 °C |
| Reaktionszeit | 24 h | 24 h | 48 h | 24 h |
| Suspensionsmittel | EtOH | EtOH | EtOH | EtOH |
| Extraktionsmittel | p-Xylol | Ethylacetat | p-Xylol | m-Dichlorbenzol |
| Ausbeute | *6%* | 17% | *14%* | *13%* |
| | | | | |

| **Bsp.** | **Ir(L9) ₃** | **Ir(L1) ₃** | **Ir(L11)₃** | **Ir(L12)₃** |
|---|---|---|---|---|
| Ligand L | L9 | L10 | L11 | L12 |
| Ir-Komplex | 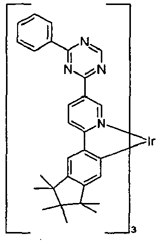 | 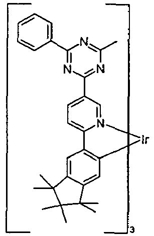 | 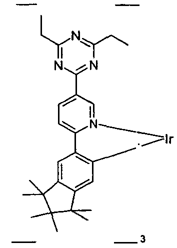 | 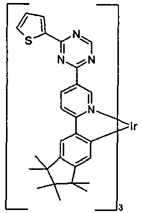 |
| Variante | D | A | A | A |
| Reaktionsmedium | --- | --- | --- | --- |
| Schmelzhilfe | --- | Hydrochinon | Hydrochinon | Hydrochinon |
| Reaktionstemp. | 270 °C | 270 °C | 275 °C | 260 °C |
| Reaktionszeit | 24 h | 24 h | 24 h | 48 h |
| Suspensionsmittel | EtOH | EtOH | EtOH | EtOH |
| Extraktionsmittel | Mesitol | p-Xylol | Ethylacetat | p-Xylol |
| Ausbeute | *7%* | 11% | *17%* | *6%* |
| | | | | |

| **Bsp.** | **Ir(L13)₃** | **Ir(L14)₃** | **Ir(L15)₃** | **Ir(L16)₃** |
|---|---|---|---|---|
| Ligand L | L13 | L14 | L15 | L16 |
| Ir-Komplex | 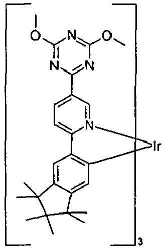 | 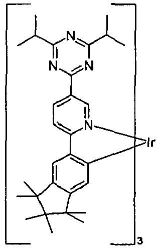 | 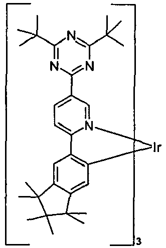 | 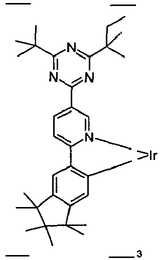 |
| Variante | A | A | A | A |
| Reaktionsmedium | --- | --- | --- | --- |
| Schmelzhilfe | Hydrochinon | --- | --- | Hydrochinon |
| Reaktionstemp. | 260 °C | 280 °C | 280 °C | 270 °C |
| Reaktionszeit | 36 h | 24 h | 24 h | 24 h |
| Suspensionsmittel | EtOH | EtOH | EtOH | EtOH |
| Extraktionsmittel | m-Xylol | Ethylacetat | Ethylacetat | Ethylacetat |
| Ausbeute | *12%* | 13% | *10%* | *11%* |
| | | | | |
| **Bsp.** | **Ir(L17)₃** | **Ir(L18)₃** | **Ir(L19)₃** | **Ir(L20)₃** |
| Ligand L | L17 | L18 | L19 | L20 |
| Ir-Komplex | 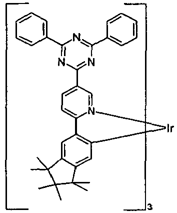 | 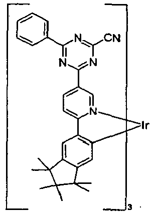 | 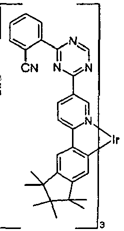 | 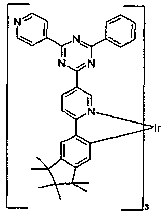 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 275 °C | 275 °C | 265 °C | 270 °C |
| Reaktionszeit | 24 h | 24 h | 36 h | 24 h |
| Suspensionsmittel | EtOH | EtOH | EtOH | EtOH |
| Extraktionsmittel | m-Xylol | Toluol | Toluol | Toluol |
| Ausbeute | *7%* | 11% | *9%* | *13%* |
| | | | | |

| **Bsp.** | **Ir(L21) ₃** | **Ir(L22) ₃** | **Ir(L23)₃** | **Ir(L24) ₃** |
|---|---|---|---|---|
| Ligand L | L21 | L22 | L23 | L24 |
| Ir-Komplex | 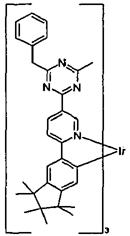 | 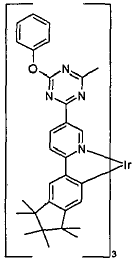 | 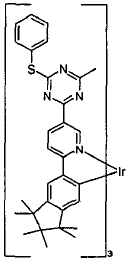 | 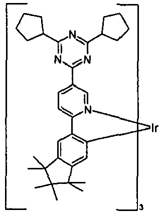 |
| Variante | A | A | A | A |
| Reaktionsmedium | --- | --- | --- | --- |
| Schmelzhilfe | 1-Naphthol | 1-Naphthol | 1-Naphthol | Hydrochinon |
| Reaktionstemp. | 260 °C | 265 °C | 265 °C | 260 °C |
| Reaktionszeit | 36 h | 36 h | 36 h | 24 h |
| Suspensionsmittel | EtOH | EtOH | EtOH | EtOH |
| Extraktionsmittel | Toluol | Toluol | Toluol | Ethylacetat |
| Ausbeute | *5%* | 13% | *11%* | *15%* |
| | | | | |

| **Bsp.** | **Ir(L25) ₃** | **Ir(L26) ₃** | **Ir(L27) ₃** | **Ir(L28)₃** |
|---|---|---|---|---|
| Ligand L | L25 | L26 | L27 | L28 |
| Ir-Komplex | 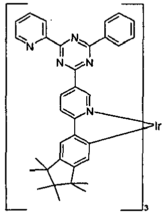 | 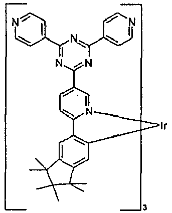 | 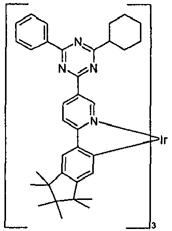 | 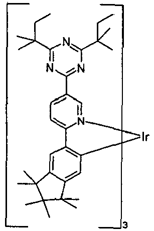 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 275 °C | 275 °C | 275 °C | 265 °C |
| Reaktionszeit | 24 h | 24 h | 24 h | 24 h |
| Suspensionsmittel Extraktionsmittel | EtOH Toluol | EtOH Chlorbenzol | EtOH Ethylacetat | EtOH Ethylacetat |
| Ausbeute | *9%* | 7% | *13%* | *16%* |
| | | | | |

| **Bsp.** | **Ir(L29)₃** | **Ir(L30) ₃** | **Ir(L31) ₃** | **Ir(L32) ₃** |
|---|---|---|---|---|
| Ligand L | L29 | L30 | L31 | L32 |
| Ir-Komplex | 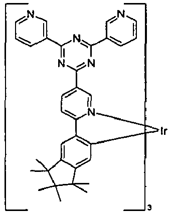 | 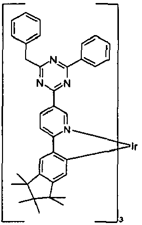 | 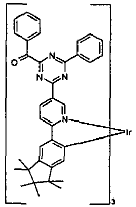 | 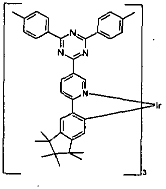 |
| Variante | A | A | A | A |
| Reaktionsmedium | --- | --- | --- | --- |
| Schmelzhilfe | Hydrochinon | 1-Naphthol | Hydrochinon | Hydrochinon |
| Reaktionstemp. | 275 °C | 265 °C | 260 °C | 275 °C |
| Reaktionszeit | 24 h | 24 h | 24 h | 24 h |
| Suspensionsmittel | EtOH | EtOH | EtOH | EtOH |
| Extraktionsmittel | Chlorbenzol | Toluol | Toluol | Toluol |
| Ausbeute | *8%* | 9% | *6%* | *12%* |
| | | | | |

| **Bsp.** | **Ir(L33) ₃** | **Ir(L34) ₃** | **Ir(L35) ₃** | **Ir(L36) ₃** |
|---|---|---|---|---|
| Ligand L | L33 | L34 | L35 | L36 |
| Ir-Komplex | 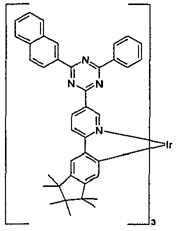 | 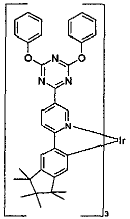 | 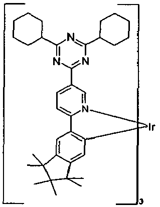 | 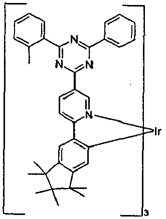 |
| Variante | A | A | A | A |
| Reaktionsmedium | --- | --- | --- | --- |
| Schmelzhilfe | Hydrochinon | 1-Naphthol | Hydrochinon | Hydrochinon |
| Reaktionstemp. | 275 °C | 270 °C | 260 °C | 275 °C |
| Reaktionszeit | 36 h | 24 h | 24 h | 24 h |
| Suspensionsmittel Extraktionsmittel | EtOH Toluol | EtOH p-Xylol | EtOH Ethylacetat | EtOH Toluol |
| Ausbeute | *4%* | 11% | *17%* | *11%* |
| | | | | |

| **Bsp.** | **Ir(L37) ₃** | **Ir(L38) ₃** | **Ir(L39) ₃** | **Ir(L40) ₃** |
|---|---|---|---|---|
| Ligand L | L37 | L38 | L39 | L40 |
| Ir-Komplex | 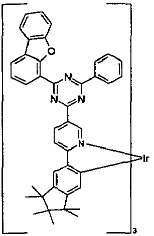 | 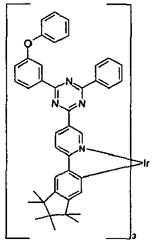 | 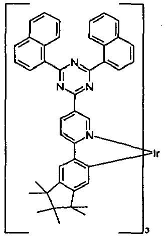 | 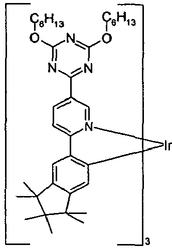 |
| Variante | A | A | A | A |
| Reaktionsmedium | --- | --- | --- | --- |
| Schmelzhilfe | Hydrochinon | 1-Naphthol | Hydrochinon | 1-Naphthol |
| Reaktionstemp. | 275 °C | 265 °C | 275 °C | 270 °C |
| Reaktionszeit | 24 h | 24 h | 36 h | 24 h |
| Suspensionsmittel | EtOH | EtOH | EtOH | EtOH |
| Extraktionsmittel | Chlorbenzol | Toluol | p-Dichlorbenzol | Butanol |
| Ausbeute | 13% | 8% | *10%* | *15%* |
| | | | | |

| **Bsp.** | **Ir(L41) ₃** | **Ir(L42) ₃** | **Ir(L43)₃** | **Ir(L44)₃** |
|---|---|---|---|---|
| Ligand L | L41 | L42 | L43 | L44 |
| Ir-Komplex | 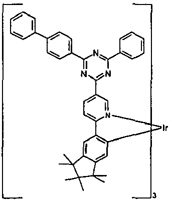 | 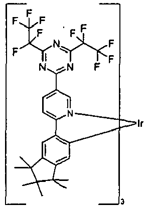 | 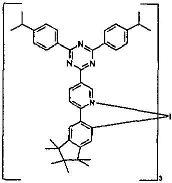 | 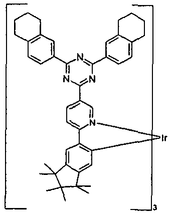 |
| Variante | A | A | A | A |
| Reaktionsmedium | --- | --- | --- | --- |
| Schmelzhilfe | Hydrochinon | Hexadecan | Hydrochinon | Hydrochinon |
| Reaktionstemp. | 270 °C | 270 °C | 260 °C | 260 °C |
| Reaktionszeit | 24 h | 24 h | 24 h | 24 h |
| Suspensionsmittel | EtOH | EtOH | EtOH | EtOH |
| Extraktionsmittel | Chlorbenzol | Chlorbenzol | Toluol | Toluol |
| Ausbeute | 13% | 3% | 9% | 12% |
| | | | | |

| **Bsp.** | **Ir(L45) ₃** | **Ir(L46) ₃** | **Ir(L47) ₃** | **Ir(L48)₃** |
|---|---|---|---|---|
| Ligand L | L45 | L46 | L47 | L48 |
| Ir-Komplex | 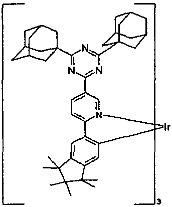 | 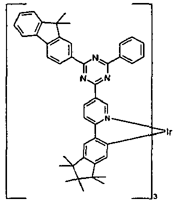 | 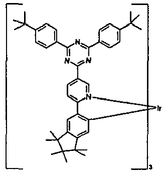 | 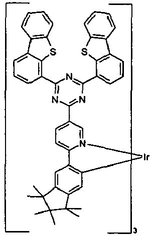 |
| Variante | A | A | A | A |
| Reaktionsmedium | --- | --- | --- | Hydrochinon |
| Schmelzhilfe | Hydrochinon | Hydrochinon | Hydrochinon | 275 °C |
| Reaktionstemp. | 275 °C | 270 °C | 270 °C | 36 h |
| Reaktionszeit | 24 h | 24 h | 60 h | EtOH |
| Suspensionsmittel | EtOH | EtOH | Methanol | p- |
| Extraktionsmittel | Toluol | Toluol | Toluol | Dichlorbenzol |
| Ausbeute | 6% | 11% | 12% | 12% |
| | | | | |

| **Bsp.** | **Ir(L49) ₃** | **Ir(L50)₃** | **Ir(L51) ₃** | **Ir(L52) ₃** |
|---|---|---|---|---|
| Ligand L | L49 | L50 | L51 | L52 |
| Ir-Komplex | 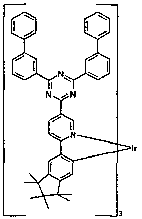 | 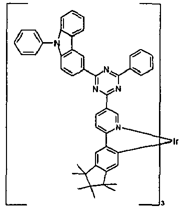 | 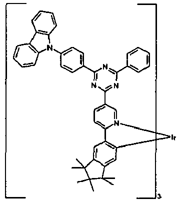 | 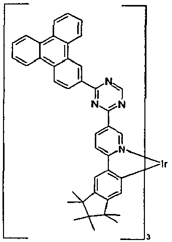 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 270 °C | 275 °C | 270 °C | 275 °C |
| Reaktionszeit | 24 h | 24 h | 24 h | 36 h |
| Suspensionsmittel | EtOH | EtOH | EtOH | EtOH |
| Extraktionsmittel | Toluol | Ethylacetat | Ethylacetat | p-Dichlorbenzol |
| Ausbeute | *9%* | 11% | *10%* | *5%* |
| | | | | |

| **Bsp.** | **Ir(L53) ₃** | **Ir(L54) ₃** | **Ir(L55)₃** | **Ir(L56) ₃** |
|---|---|---|---|---|
| Ligand L | L53 | L54 | L55 | L56 |
| Ir-Komplex | 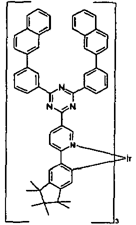 | 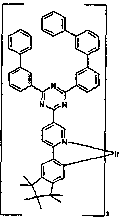 | 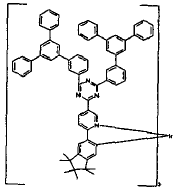 | 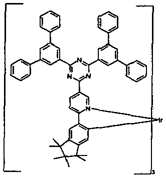 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 270 °C | 275 °C | 275 °C | 275 °C |
| Reaktionszeit | 24 h | 24 h | 24 h | 24 h |
| Suspensionsmittel | EtOH | EtOH | EtOH | EtOH |
| Extraktionsmittel | p-Xylol | Toluol | Toluol | Toluol |
| Ausbeute | 6% | 12% | *12%* | *10%* |
| | | | | |

| **Bsp.** | **Ir(L57) ₃** | **Ir(L58) ₃** | **Ir(L59) ₃** | **Ir(L60) ₃** |
|---|---|---|---|---|
| Ligand L | L57 | L58 | L59 | L60 |
| Ir-Komplex | 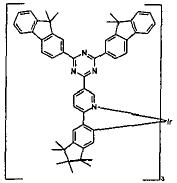 | 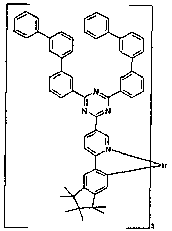 | 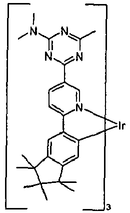 | 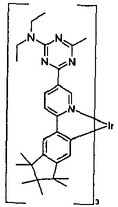 |
| Variante | A | A | A | A |
| Reaktionsmedium | Hydrochinon | Hydrochinon | Hydrochinon | Hydrochinon |
| Schmelzhilfe | 275 °C | 275 °C | 260 °C | 260 °C |
| Reaktionstemp. | 24 h | 24 h | 48 h | 48 h |
| Reaktionszeit | EtOH | EtOH | EtOH | EtOH |
| Suspensionsmittel | Toluol | Toluol | p-Xylol | Toluol |
| Extraktionsmittel | | | | |
| Ausbeute | 10% | 14% | *7%* | *4%* |
| | | | | |

| **Bsp.** | **Ir(L61) ₃** | **Ir(L62) ₃** | **Ir(L63) ₃** | **Ir(L64) ₃** |
|---|---|---|---|---|
| Ligand L | L61 | L62 | L63 | L64 |
| Ir-Komplex | 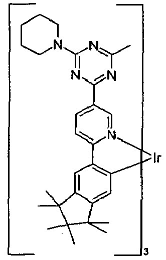 | 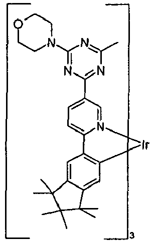 | 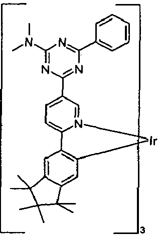 | 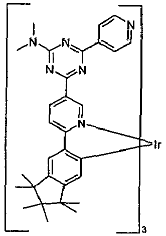 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 260 °C | 250 °C | 270 °C | 260 °C |
| Reaktionszeit | 24 h | 24 h | 24 h | 48 h |
| Suspensionsmittel | EtOH | EtOH | EtOH | EtOH |
| Extraktionsmittel | Ethylacetat | Ethylacetat | Toluol | p-Xylol |
| Ausbeute | 8% | 3% | *7%* | *5%* |
| | | | | |

| **Bsp.** | **Ir(L65) ₃** | **Ir(L66) ₃** | **Ir(L67) ₃** | **Ir(L68) ₃** |
|---|---|---|---|---|
| Ligand L | L65 | L66 | L67 | L68 |
| Ir-Komplex | 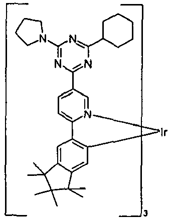 | 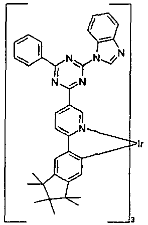 | 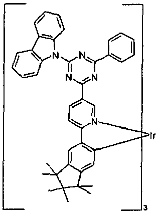 | 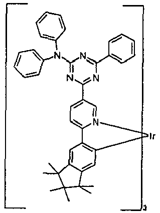 |
| Variante | A | A | A | A |
| Reaktionsmedium | --- | --- | --- | --- |
| Schmelzhilfe | Hydrochinon | Hydrochinon | 1-Naphthol | 1-Naphthol |
| Reaktionstemp. | 265 °C | 260 °C | 275 °C | 265 °C |
| Reaktionszeit | 24 h | 48 h | 24 h | 24 h |
| Suspensionsmittel | EtOH | EtOH | EtOH | EtOH |
| Extraktionsmittel | Toluol | p-Dichlorbenzol | Chlorbenzol | Toluol |
| Ausbeute | 11% | 8% | 4% | 7% |
| | | | | |

| **Bsp.** | **Ir(L69)₃** | **Ir(L70) ₃** | **Ir(L71) ₃** | **Ir(L72) ₃** |
|---|---|---|---|---|
| Ligand L | L69 | L70 | L71 | L72 |
| Ir-Komplex | 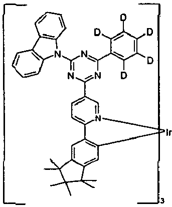 | 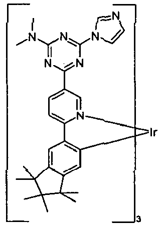 | 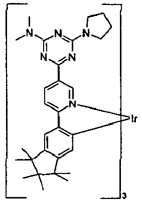 | 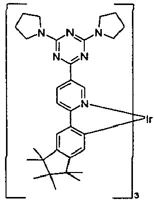 |
| Variante | A | A | A | A |
| Reaktionsmedium | --- | --- | --- | --- |
| Schmelzhilfe | 1-Naphthol | Hydrochinon | Hydrochinon | Hydrochinon |
| Reaktionstemp. | 275 °C | 255 °C | 260 °C | 255 °C |
| Reaktionszeit | 24 h | 48 h | 48 h | 48 h |
| Suspensionsmittel | EtOH | EtOH | EtOH | EtOH |
| Extraktionsmittel | Chlorbenzol | p-Dichlorbenzol | Toluol | Ethylacetat |
| Ausbeute | 3% | 4% | *4%* | *8%* |
| | | | | |

| **Bsp.** | **Ir(L73) ₃** | **Ir(L74) ₃** | **Ir(L75)₃** | **Ir(L76)₃** |
|---|---|---|---|---|
| Ligand L | L73 | L74 | L75 | L76 |
| Ir-Komplex | 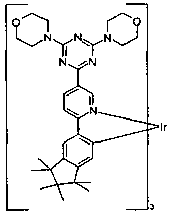 | 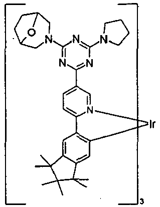 | 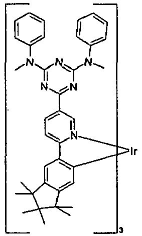 | 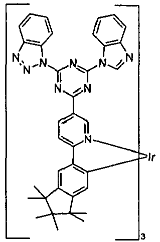 |
| Variante | A | A | A | A --- |
| Reaktionsmedium | --- | --- | --- | Hydrochinon |
| Schmelzhilfe | Hydrochinon | Hydrochinon | Hydrochinon | 275 °C |
| Reaktionstemp. | 250 °C | 265 °C | 260 °C | 24 h |
| Reaktionszeit | 24 h | 24 h | 48 h | EtOH |
| Suspensionsmittel | EtOH | EtOH | EtOH | m- |
| Extraktionsmittel | Ethylacetat | Ethylacetat | Toluol | Dichlorbenzol |
| Ausbeute | *6%* | 3% | *7%* | *5%* |
| | | | | |

| **Bsp.** | **Ir(L77) ₃** | **Ir(L78) ₃** | **Ir(L79)₃** | **Ir(L80) ₃** |
|---|---|---|---|---|
| Ligand L | L77 | L78 | L79 | L80 |
| Ir-Komplex | 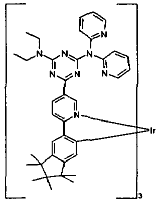 | 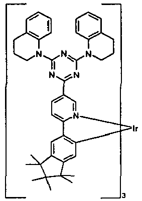 | 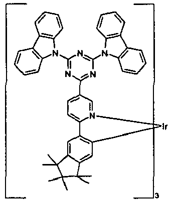 | 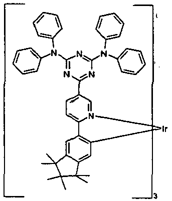 |
| Variante | A | A | A | A |
| Reaktionsmedium | --- | --- | --- | --- |
| Schmelzhilfe | 1-Naphthol | 1-Naphthol | 1-Naphthol | 1-Naphthol |
| Reaktionstemp. | 265 °C | 265 °C | 275 °C | 265 °C |
| Reaktionszeit | 24 h | 24 h | 36 h | 24 h |
| Suspensionsmittel | EtOH | EtOH | EtOH | EtOH |
| Extraktionsmittel | Toluol | Toluol | Chlorbenzol | Ethylacetat |
| Ausbeute | 7% | 11% | *13%* | *12%* |
| | | | | |

| **Bsp.** | **Ir(L81) ₃** | **Ir(L82) ₃** | **Ir(L83) ₃** | **Ir(L84) ₃** |
|---|---|---|---|---|
| Ligand L | L81 | L82 | L83 | L84 |
| Ir-Komplex | 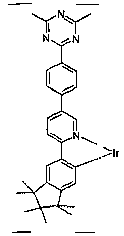 | 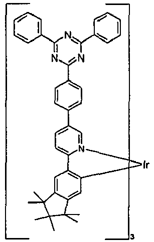 | 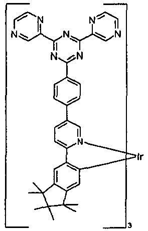 | 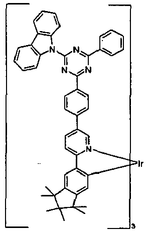 |
| Variante | A | A | D | A |
| Reaktionsmedium | --- | --- | --- | --- |
| Schmelzhilfe | Diphenylether | Diphenylether | | Diphenylether |
| Reaktionstemp. | 250 °C | 250 °C | 250 °C | 250 °C |
| Reaktionszeit | 36 h | 48 h | 48 h | 48 h |
| Suspensionsmittel | EtOH | EtOH | EtOH | EtOH |
| Extraktionsmittel | Toluol | p-Xylol | p-Xylol | Toluol |
| Ausbeute | 3% | 1% | *3%* | *2%* |
| | | | | |

| **Bsp.** | **Ir(L85) ₃** | **Ir(L86) ₃** | **Ir(L87)₃** | **Ir(L88) ₃** |
|---|---|---|---|---|
| **Ligand L** | **L85** | **L86** | **L87** | **L88** |
| Ir-Komplex | 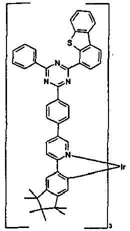 | 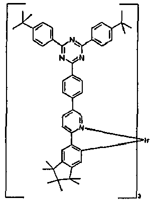 | 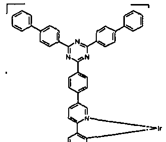 | 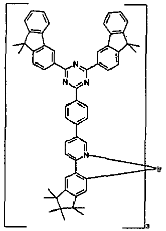 |
| Variante | A | A | A | A |
| Reaktionsmedium | --- | --- | --- | --- |
| Schmelzhilfe | Diphenylether | Diphenylether | Diphenylether | Diphenylether |
| Reaktionstemp. | 250 °C | 250 °C | 250 °C | 250 °C |
| Reaktionszeit | 48 h | 48 h | 48 h | 48 h |
| Suspensionsmittel | EtOH | EtOH | EtOH | EtOH |
| Extraktionsmittel | p-Xylol | Ethylacetat | Toluol | Chlorbenzol |
| Ausbeute | 3% | 3% | *2%* | *4%* |
| | | | | |

| **Bsp.** | **Ir(L89) ₃** | **Ir(L90) ₃** | **Ir(L91) ₃** | **Ir(L92) ₃** |
|---|---|---|---|---|
| Ligand L | L89 | L90 | L91 | L92 |
| Ir-Komplex | 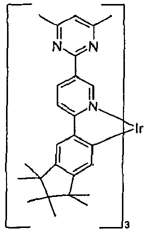 | 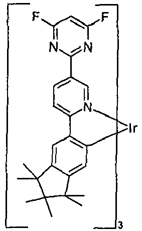 | 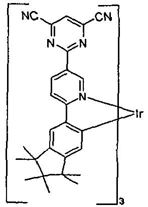 | 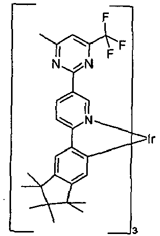 |
| Variante | A | A | D | A |
| Reaktionsmedium | | --- | --- | --- |
| Schmelzhilfe | Hydrochinon | Hydrochinon | --- | Hydrochinon |
| Reaktionstemp. | 270 °C | 275 °C | 270 °C | 270 °C |
| Reaktionszeit | 24 h | 24 h | 24 h | 24 h |
| Suspensionsmittel | EtOH | EtOH | EtOH | EtOH |
| Extraktionsmittel | m-Dichlorbenzol | Chlorbenzol | Chlorbenzol | Toluol |
| Ausbeute | 2% | 4% | *6%* | *3%* |
| | | | | |

| Bsp. | **Ir(L93) ₃** | **Ir(L94) ₃** | **Ir(L95) ₃** | **Ir(L96) ₃** |
|---|---|---|---|---|
| Ligand L | L93 | L94 | L95 | L96 |
| Ir-Komplex | 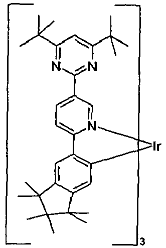 | 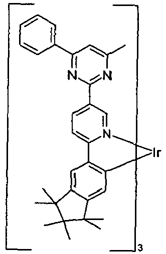 | 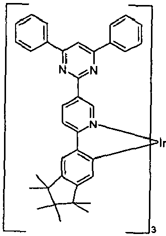 | 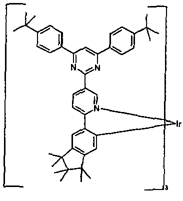 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 265 °C | 265 °C | 265 °C | 265 °C |
| Reaktionszeit | 24 h | 24 h | 24 h | 24 h |
| Suspensionsmittel | EtOH | EtOH | EtOH | EtOH |
| Extraktionsmittel | Ethylacetat | Toluol | Chlorbenzol | |
| Ausbeute | 6% | 3% | 2% | 4% |

| **Bsp.** | **Ir(L97) ₃** | **Ir(L98) ₃** | **Ir(L99)₃** | **Ir(L100)₃** |
|---|---|---|---|---|
| Ligand L | L97 | L98 | L99 | L100 |
| Ir-Komplex | 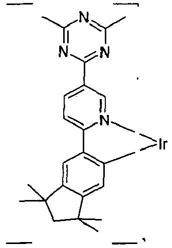 | 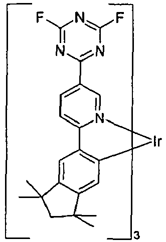 | 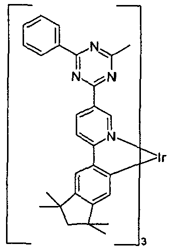 | 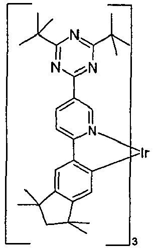 |
| Variante | A | A | A | A |
| Reaktionsmedium | --- | --- | --- | --- |
| Schmelzhilfe | Hydrochinon | Hydrochinon | --- | --- |
| Reaktionstemp. | 275 °C | 265 °C | 270 °C | 280 °C |
| Reaktionszeit | 24 h | 24 h | 24 h | 24 h |
| Suspensionsmittel | EtOH | EtOH | EtOH | EtOH |
| Extraktionsmittel | Chlorbenzol | Chlorbenzol | p-Xylol | Ethylacetat |
| Ausbeute | 10% | 8% | *9%* | *7%* |
| | | | | |

| **Bsp.** | **Ir(L101) ₃** | **Ir(L102)₃** | **Ir(L103)₃** | **Ir(L104)₃** |
|---|---|---|---|---|
| Ligand L | L101 | L102 | L103 | L104 |
| Ir-Komplex | 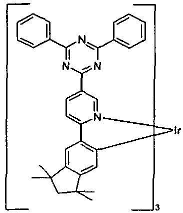 | 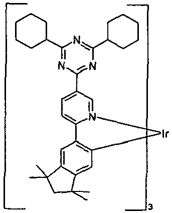 | 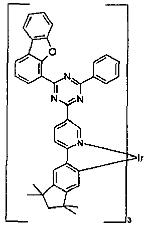 | 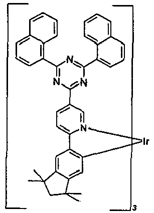 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 275 °C | 270 °C | 265 °C | 275 °C |
| Reaktionszeit | 24 h | 24 h | 24 h | 24 h |
| Suspensionsmittel | EtOH | EtOH | EtOH | EtOH |
| Extraktionsmittel | Toluol | Toluol | Ethylacetat | Chlorbenzol |
| Ausbeute | 11% | 14% | *11%* | *5%* |

| **Bsp.** | **Ir(L105)₃** | **Ir(L106)₃** | **Ir(L107)₃** | **Ir(L108)₃** |
|---|---|---|---|---|
| Ligand L | L105 | L106 | L107 | L108 |
| Ir-Komplex | 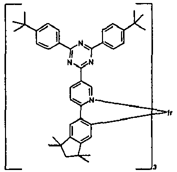 | 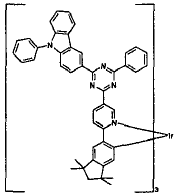 | 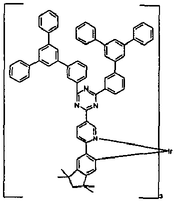 | 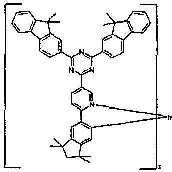 |
| Variante | A | A | A | A |
| Reaktionsmedium | --- | --- | --- | --- |
| Schmelzhilfe | Hydrochinon | 1-Naphthol | 1-Naphthol | Hydrochinon |
| Reaktionstemp. | 270 °C | 270 °C | 270 °C | 265 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Ethylacetat | Toluol |
| Ausbeute | 12% | 14% | *13%* | *11%* |
| | | | | |

| **Bsp.** | **Ir(L109)₃** | **Ir(L110)₃** | **Ir(L111)₃** | **Ir(L112)₃** |
|---|---|---|---|---|
| Ligand L | L109 | L110 | L111 | L112 |
| Ir-Komplex | 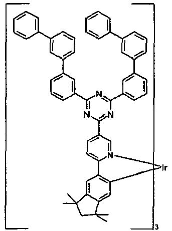 | 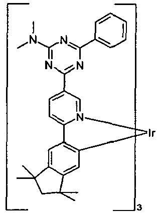 | 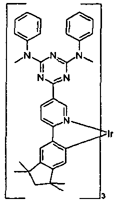 | 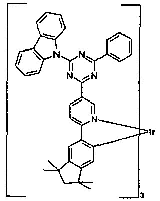 |
| Variante | A | A | A | A |
| Reaktionsmedium | --- | --- | --- | --- |
| Schmelzhilfe | Hydrochinon | 1-Naphthol | 1-Naphthol | Hydrochinon |
| Reaktionstemp. | 270 °C | 270 °C | 270 °C | 265 °C |
| Reaktionszeit | 24 h | 24 h | 24 h | 24 h |
| Suspensionsmittel | EtOH | EtOH | EtOH | EtOH |
| Extraktionsmittel | Ethylacetat | p-Xylol | Toluol | Ethylacetat |
| Ausbeute | *9%* | *5%* | *4%* | *8%* |

| **Bsp.** | **Ir(L113) ₃** | **Ir(L114) ₃** | **Ir(L115) ₃** | **Ir(L116) ₃** |
|---|---|---|---|---|
| Ligand L | L113 | L114 | L115 | L116 |
| Ir-Komplex | 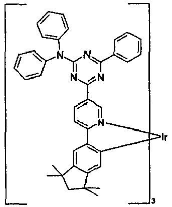 | 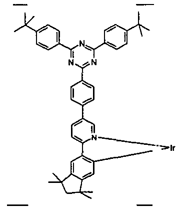 | 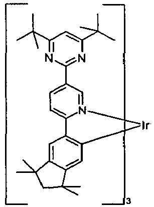 | 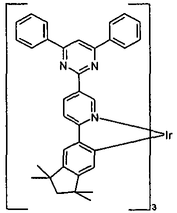 |
| Variante | A | A | A | A |
| Reaktionsmedium | --- | --- | --- | --- |
| Schmelzhilfe | Hydrochinon | Hydrochinon | --- | Hydrochinon |
| Reaktionstemp. | 265 °C | 270 °C | 280 °C | 275 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Ethylacetat | Toluol |
| Ausbeute | 10% | 4% | *2%* | *3%* |
| | | | | |

| **Bsp.** | **Ir(L117)₃** | **Ir(L118) ₃** | **Ir(L119)₃** | **Ir(L120)₃** |
|---|---|---|---|---|
| Ligand L | L117 | L118 | L119 | L120 |
| Ir-Komplex | 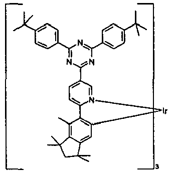 | 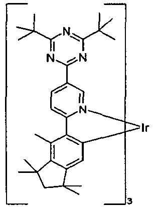 | 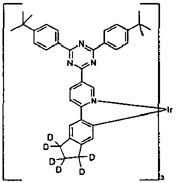 | 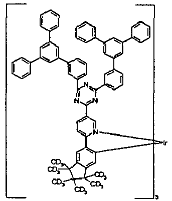 |
| Variante | A | A | A | A |
| Reaktionsmedium | --- | --- | --- | --- |
| Schmelzhilfe | Hydrochinon | --- | Hydrochinon | 1-Naphthol |
| Reaktionstemp. | 270 °C | 280 °C | 270 °C | 270 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Ethylacetat | Ethylacetat |
| Ausbeute | *12%* | 9% | *7%* | *10%* |

| **Bsp.** | **Ir(L121) ₃** | **Ir(L122)₃** | **Ir(L123) ₃** | **Ir(L124)₃** |
|---|---|---|---|---|
| Ligand L | L121 | L122 | L123 | L124 |
| Ir-Komplex | 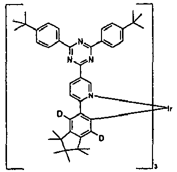 | 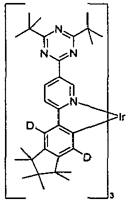 | 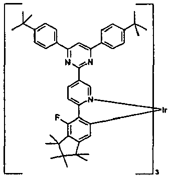 | 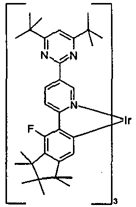 |
| Variante | A | A | A | A |
| Reaktionsmedium | --- | --- | --- | --- |
| Schmelzhilfe | Hydrochinon | --- | Hydrochinon | --- |
| Reaktionstemp. | 270 °C | 280 °C | 270 °C | 280 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Ethylacetat | Ethylacetat |
| Ausbeute | 11% | 10% | *7%* | *8%* |
| | | | | |

| **Bsp.** | **Ir(L125) ₃** | **Ir(L126)₃** | **Ir(L127)₃** | **Ir(L128)₃** |
|---|---|---|---|---|
| Ligand L | L125 | L126 | L127 | L128 |
| Ir-Komplex | 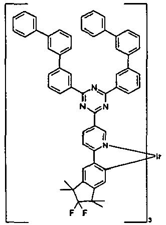 | 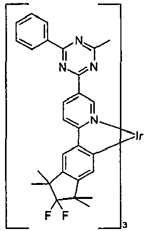 | 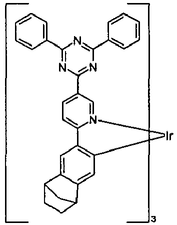 | 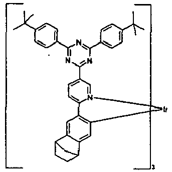 |
| Variante | A | A | A | A |
| Reaktionsmedium | --- | --- | --- | --- |
| Schmelzhilfe | Hydrochinon | --- | Hydrochinon | Hydrochinon |
| Reaktionstemp. | 270 °C | 270 °C | 275 °C | 270 °C |
| Reaktionszeit | 24 h | 36 h | 24 h | 24 h |
| Suspensionsmittel | EtOH | EtOH | EtOH | EtOH |
| Extraktionsmittel | Ethylacetat | p-Xylol | Toluol | Ethylacetat |
| Ausbeute | 8% | 5% | *5%* | *9%* |

| **Bsp.** | **Ir(L129) ₃** | **Ir(L130) ₃** | **Ir(L131)₃** | **Ir(L132)₃** |
|---|---|---|---|---|
| Ligand L | L129 | L130 | L131 | L132 |
| Ir-Komplex | 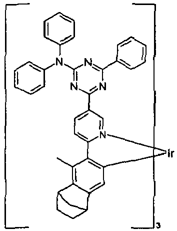 | 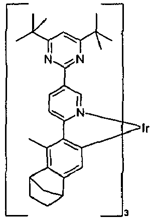 | 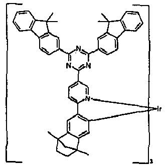 | 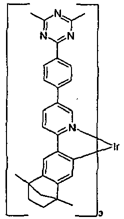 |
| Variante | A | D | A | A |
| Reaktionsmedium | --- | --- | --- | --- |
| Schmelzhilfe | Hydrochinon | --- | Hydrochinon | --- |
| Reaktionstemp. | 265 °C | 280 °C | 270 °C | 280 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Toluol | Ethylacetat |
| Ausbeute | 7% | 5% | *13%* | *4%* |
| | | | | |

| **Bsp.** | **Ir(L133) ₃** | **Ir(L134)₃** | **Ir(L135)₃** | **Ir(L136) ₃** |
|---|---|---|---|---|
| Ligand L | L133 | L134 | L135 | L136 |
| Ir-Komplex | 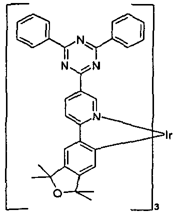 | 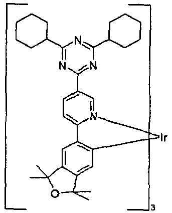 | 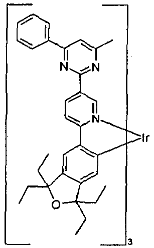 | 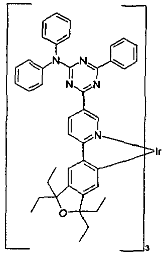 |
| Variante | A | A | A | A |
| Reaktionsmedium | --- | --- | --- | --- |
| Schmelzhilfe | Hydrochinon | Hydrochinon | --- | Hydrochinon |
| Reaktionstemp. | 275 °C | 270 °C | 270 °C | 265 °C |
| Reaktionszeit | 24 h | 24 h | 36 h | 24 h |
| Suspensions mittel | EtOH | EtOH | EtOH | EtOH |
| Extraktionsmittel | Toluol | Toluol | p-Xylol | Ethylacetat |
| Ausbeute | 7% | 10% | *13%* | *10%* |

| **Bsp.** | **Ir(L137) ₃** | **Ir(L138)₃** | **Ir(L139)₃** | **Ir(L140) ₃** |
|---|---|---|---|---|
| Ligand L | L141 | L142 | L143 | L144 |
| Ir-Komplex | 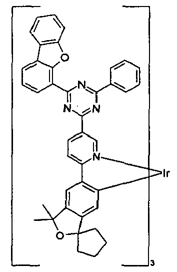 | 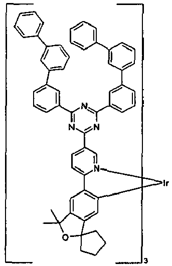 | 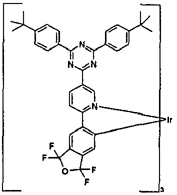 | 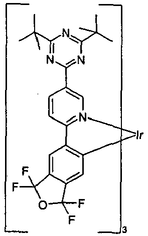 |
| Variante | A | A | A | A |
| Reaktionsmedium | --- | --- | --- | --- |
| Schmelzhilfe | Hydrochinon | Hydrochinon | Hydrochinon | --- |
| Reaktionstemp. | 265 °C | 270 °C | 265 °C | 260 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Ethylacetat | Ethylacetat |
| Ausbeute | 12% | 14% | *3%* | *3%* |
| | | | | |

| **Bsp.** | **Ir(L141)₃** | **Ir(L142)₃** | **Ir(L143)₃** | **Ir(L144)₃** |
|---|---|---|---|---|
| Ligand L | L137 | L138 | L139 | L140 |
| Ir-Komplex | 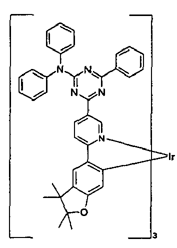 | 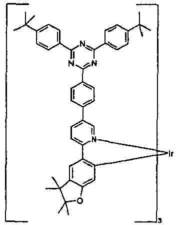 | 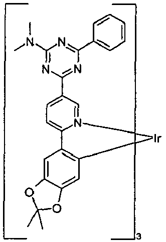 | 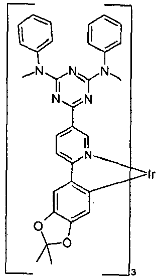 |
| Variante | A | A | A | A |
| Reaktionsmedium | --- | --- | --- | --- |
| Schmelzhilfe | Hydrochinon | Diphenylether | 1-Naphthol | 1-Naphthol |
| Reaktionstemp. | 265 °C | 250 °C | 265 °C | 275 °C |
| Reaktionszeit | 24 h | 48 h | 24 h | 24 h |
| Suspensionsmittel | EtOH | EtOH | EtOH | EtOH |
| Extraktionsmittel | Ethylacetat | Ethylacetat | Toluol | Toluol |
| Ausbeute | 12% | 4% | *8%* | *7%* |
| | | | | |

| **Bsp.** | **Ir(L145)₃** | **Ir(L146) ₃** | **Ir(L147)₃** | **Ir(L148) ₃** |
|---|---|---|---|---|
| Ligand L | L145 | L146 | L147 | L148 |
| Ir-Komplex | 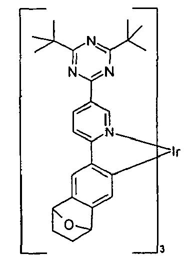 | 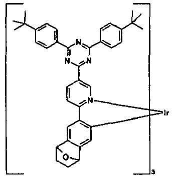 | 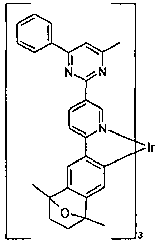 | 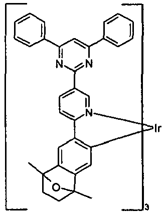 |
| Variante | A | A | A | A |
| Reaktionsmedium | --- | --- | --- | --- |
| Schmelzhilfe | --- | Hydrochinon | Diphenylether | Hydrochinon |
| Reaktionstemp. | 260 °C | 270 °C | 270 °C | 275 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | p-Xylol | Chlorbenzol |
| Ausbeute | 7% | 11% | *4%* | *2%* |
| | | | | |

| **Bsp.** | **Ir(L149) ₃** | **Ir(L150)₃** | **Ir(L151)₃** | **Ir(L152) ₃** |
|---|---|---|---|---|
| Ligand L | L149 | L150 | L151 | L152 |
| Ir-Komplex | 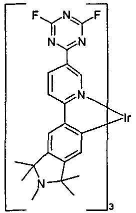 | 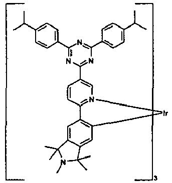 | 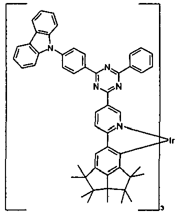 | 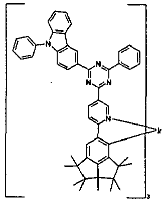 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 265 °C | 265 °C | 275 °C | 275 °C |
| Reaktionszeit | 24 h | 24 h | 24 h | 24 h |
| Suspensionsmittel Extraktionsmittel | EtOH Chlorbenzol | EtOH Ethylacetat | EtOH Ethylacetat | EtOH Ethylacetat |
| Ausbeute | 5% | 13% | *4%* | *2%* |
| | | | | |

| **Bsp.** | **Ir(L153)₃** | **Ir(L154)₃** | **Ir(L155)₃** | **Ir(L156)₃** |
|---|---|---|---|---|
| Ligand L | L153 | L154 | L155 | L156 |
| Ir-Komplex | 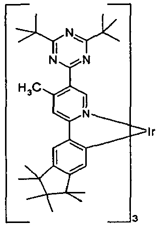 | 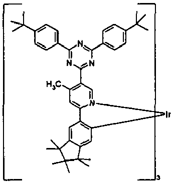 | 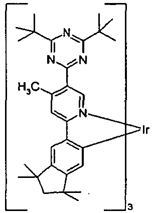 | 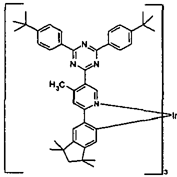 |
| Variante | A | A | A | A |
| Reaktionsmedium | --- | --- | --- | --- |
| Schmelzhilfe | --- | Hydrochinon | --- | Hydrochinon |
| Reaktionstemp. | 260 °C | 265 °C | 260 °C | 265 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Ethylacetat | Ethylacetat |
| Ausbeute | 5% | 13% | *4%* | *14%* |
| | | | | |

| **Bsp.** | **Ir(L157)₃** | **Ir(L158)₃** | **Ir(L159)₃** | **Ir(L160)₃** |
|---|---|---|---|---|
| Ligand L | L157 | L158 | L159 | L160 |
| Ir-Komplex | 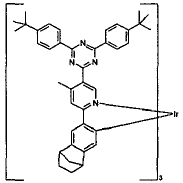 | 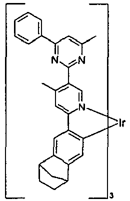 | 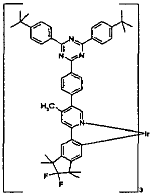 | 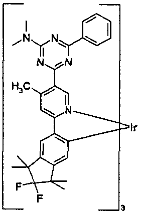 |
| Variante | A | A | A | A |
| Reaktionsmedium | --- | --- | --- | --- |
| Schmelzhilfe | Hydrochinon | Diphenylether | Diphenylether | Hydrochinon |
| Reaktionstemp. | 265 °C | 270 °C | 250 °C | 265 °C |
| Reaktionszeit | 24 h | 24 h | 48 h | 24 h |
| Suspensionsmittel | EtOH | EtOH | EtOH | EtOH |
| Extraktionsmittel | Ethylacetat | p-Xylol | Ethylacetat | Toluol |
| Ausbeute | 11% | 6% | *2%* | *4%* |
| | | | | |

| **Bsp.** | **Ir(L161)₃** | **Ir(L162)₃** | **Ir(L163)₃** | **Ir(L164)₃** |
|---|---|---|---|---|
| Ligand L | L161 | L162 | L163 | L164 |
| Ir-Komplex | 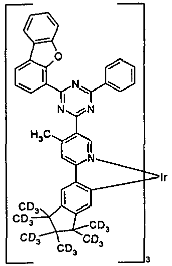 | 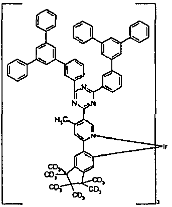 | 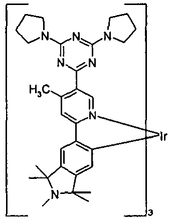 | 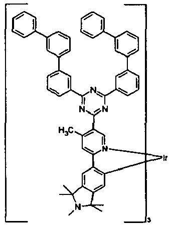 |
| Variante | A | A | A | A |
| Reaktionsmedium | --- | --- | --- | --- |
| Schmelzhilfe | Hydrochinon | 1-Naphthol | 1-Naphthol | Hydrochinon |
| Reaktionstemp. | 270 °C | 270 °C | 270 °C | 270 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Toluol | Ethylacetat |
| Ausbeute | 4% | 14% | *9%* | *11%* |
| | | | | |

| **Bsp.** | **Ir(L165)₃** | **Ir(L166) ₃** | **Ir(L167)₃** | **Ir(L168)₃** |
|---|---|---|---|---|
| Ligand L | L165 | L166 | L167 | L168 |
| Ir-Komplex | 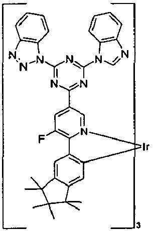 | 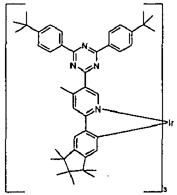 | 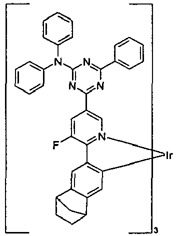 | 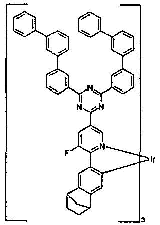 |
| Variante | A | A | A | A |
| Reaktionsmedium | --- | --- | --- | --- |
| Schmelzhilfe | 1-Naphthol | Hydrochinon | Hydrochinon | Hydrochinon |
| Reaktionstemp. | 265 °C | 265 °C | 265 °C | 270 °C |
| Reaktionszeit | 36 h | 24 h | 24 h | 24 h |
| Suspensionsmittel | EtOH | EtOH | EtOH | EtOH |
| Extraktionsmittel | Chlorbenzol | Ethylacetat | Ethylacetat | Ethylacetat |
| Ausbeute | 3% | 11% | *9%* | *10%* |
| | | | | |

| **Bsp.** | **Ir(L169)₃** | **Ir(L170) ₃** | **Ir(L171)₃** | **Ir(L172)₃** |
|---|---|---|---|---|
| Ligand L | L169 | L170 | L171 | L172 |
| Ir-Komplex | 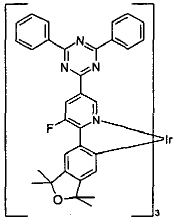 | 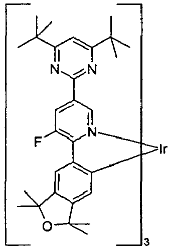 | 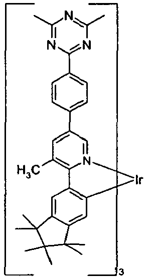 | 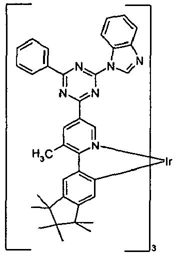 |
| Variante | A | A | A | A |
| Reaktionsmedium | --- | --- | --- | --- |
| Schmelzhilfe | Hydrochinon | --- | Diphenylether | 1-Naphthol |
| Reaktionstemp. | 275 °C | 260 °C | 250 °C | 265 °C |
| Reaktionszeit | 24 h | 24 h | 72 h | 36 h |
| Suspensionsmittel | EtOH | EtOH | EtOH | EtOH |
| Extraktionsmittel | Chlorbenzol | Ethylacetat | Chlorbenzol | Chlorbenzol |
| Ausbeute | 12% | 3% | *1%* | *4%* |
| | | | | |

| **Bsp.** | **Ir(L173) ₃** | **Ir(L174) ₃** | **Ir(L175)₃** | **Ir(L176) ₃** |
|---|---|---|---|---|
| Ligand L | L173 | L174 | L175 | L176 |
| Ir-Komplex | 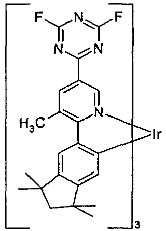 | 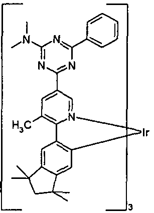 | 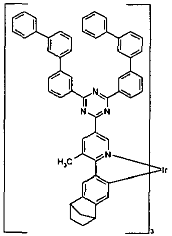 | 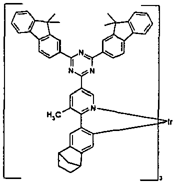 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 265 °C | 265 °C | 270 °C | 270 °C |
| Reaktionszeit | 24 h | 24 h | 24 h | 24 h |
| Suspensionsmittel | EtOH | EtOH | EtOH | EtOH |
| Extraktionsmittel | Chlorbenzol | Toluol | Ethylacetat | Toluol |
| Ausbeute | 4% | 7% | *10%* | *12%* |
| | | | | |

| **Bsp.** | **Ir(L177) ₃** | **Ir(L178)₃** | **Ir(L179)₃** | **Ir(L180)₃** |
|---|---|---|---|---|
| Ligand L | L177 | L178 | L179 | L180 |
| Ir-Komplex | 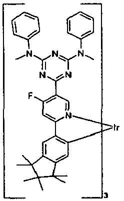 | 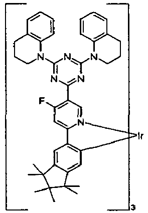 | 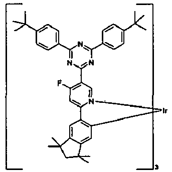 | 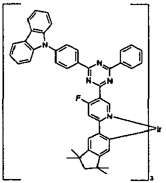 |
| Variante | A | A | A | A |
| Reaktionsmedium | --- | --- | --- | --- |
| Schmelzhilfe | Diphenylether | 1-Naphthol | Hydrochinon | Hydrochinon |
| Reaktionstemp. | 270 °C | 265 °C | 265 °C | 275 °C |
| Reaktionszeit | 24 h | 24 h | 24 h | 24 h |
| Suspensionsmittel | EtOH | EtOH | EtOH | EtOH |
| Extraktionsmittel | p-Xylol | Toluol | Ethylacetat | Ethylacetat |
| Ausbeute | 3% | 7% | *12%* | *9%* |
| | | | | |

| **Bsp.** | **Ir(L181)₃** | **Ir(L182) ₃** | **Ir(L183)₃** | **Ir(L184)₃** |
|---|---|---|---|---|
| Ligand L | L181 | L182 | L183 | L184 |
| Ir-Komplex | 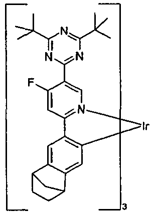 | 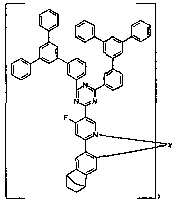 | 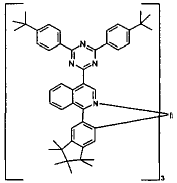 | 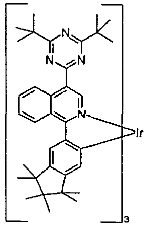 |
| Variante | A | A | A | A |
| Reaktionsmedium | --- | --- | --- | --- |
| Schmelzhilfe | --- | 1-Naphthol | Hydrochinon | Hydrochinon |
| Reaktionstemp. | 260 °C | 270 °C | 265 °C | 275 °C |
| Reaktionszeit | 24 h | 24 h | 24 h | 24 h |
| Suspensionsmittel | EtOH | EtOH | EtOH | EtOH |
| Extraktionsmittel | Ethylacetat | Ethylacetat | Ethylacetat | Ethylacetat |
| Ausbeute | *6%* | 4% | *3%* | *2%* |
| | | | | |

| **Bsp.** | **Ir(L185)** | **Ir(L186)₃** | **Ir(L187)₃** | **Ir(L188)₃** |
|---|---|---|---|---|
| Ligand L | L185 | L186 | L187 | L188 |
| Ir-Komplex | 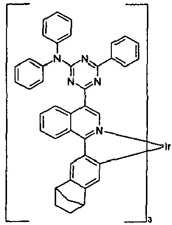 | 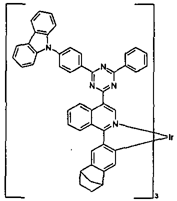 | 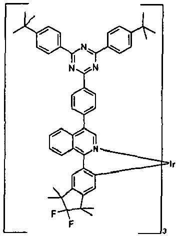 | 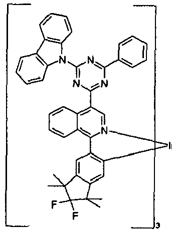 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 275 °C | 275 °C | 265 °C | 265 °C |
| Reaktionszeit | 24 h | 36 h | 24 h | 24 h |
| Suspensionsmittel | EtOH | EtOH | EtOH | EtOH |
| Extraktionsmittel | Toluol | Toluol | Ethylacetat | Toluol |
| Ausbeute | 4% | 4% | *1%* | *2%* |
| | | | | |

| **Bsp.** | **Ir(L189)₃** | **Ir(L190)₃** | **Ir(L191)₃** | **Ir(L192)₃** |
|---|---|---|---|---|
| Ligand L | L189 | L190 | L191 | L192 |
| Ir-Komplex | 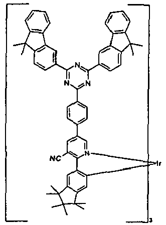 | 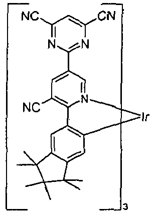 | 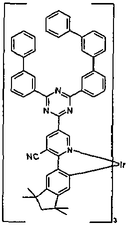 | 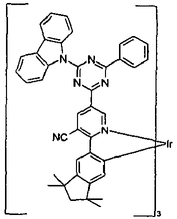 |
| Variante | A | A | A | A |
| Reaktionsmedium | --- | --- | --- | --- |
| Schmelzhilfe | Hydrochinon | --- | Hydrochinon | Hydrochinon |
| Reaktionstemp. | 275 °C | 260 °C | 270 °C | 275 °C |
| Reaktionszeit | 24 h | 24 h | 24 h | 24 h |
| Suspensionsmittel | EtOH | EtOH | EtOH | EtOH |
| Extraktionsmittel | Toluol | Chlorbenzol | Ethylacetat | Ethylacetat |
| Ausbeute | 3% | 1% | *7%* | *5%* |
| | | | | |

| **Bsp.** | **Ir(L193)₃** | **Ir(L194)₃** | **Ir(L195)₃** | **Ir(L196)₃** |
|---|---|---|---|---|
| Ligand L | L193 | L194 | L195 | L196 |
| Ir-Komplex | 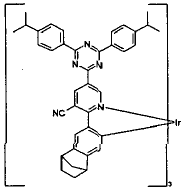 | 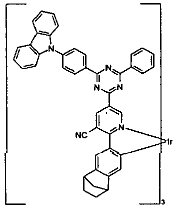 | 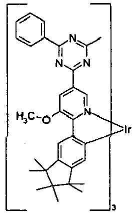 | 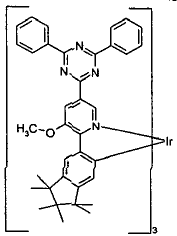 |
| Variante | A | A | A | A |
| Reaktionsmedium | --- | --- | --- | --- |
| Schmelzhilfe | Hydrochinon | Hydrochinon | Diphenylether | Hydrochinon |
| Reaktionstemp. | 265 °C | 275 °C | 270 °C | 275 °C |
| Reaktionszeit | *24 h* | *24 h* | *24 h* | *24 h* |
| Suspensionsmittel | EtOH | EtOH | EtOH | EtOH |
| Extraktionsmittel | Ethylacetat | Ethylacetat | p-Xylol | Chlorbenzol |
| Ausbeute | 4% | 7% | *4%* | *1%* |
| | | | | |

| **Bsp.** | **Ir(L197)₃** | **Ir(L198)₃** | **Ir(L199)₃** | **Ir(L200)₃** |
|---|---|---|---|---|
| Ligand L | L197 | L198 | L199 | L200 |
| Ir-Komplex | 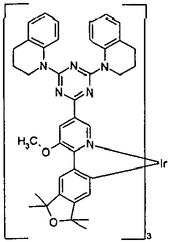 | 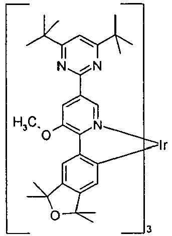 | 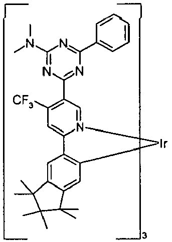 | 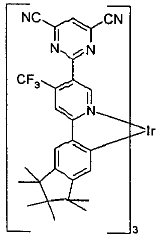 |
| Variante | A | A | D | A |
| Reaktionsmedium | --- | --- | --- | --- |
| Schmelzhilfe | 1-Naphthol | --- | --- | --- |
| Reaktionstemp. | 265 °C | 260 °C | 265 °C | 260 °C |
| Reaktionszeit | 24 h | 24 h | 24 h | 24 h |
| Suspensionsmittel | EtOH | EtOH | EtOH | EtOH |
| Extraktionsmittel | Toluol | Ethylacetat | Toluol | Chlorbenzol |
| Ausbeute | *7%* | 2% | *4%* | *3%* |
| | | | | |

| **Bsp.** | **Ir(L201) ₃** | **Ir(L202) ₃** | **Ir(L203) ₃** | **Ir(L204) ₃** |
|---|---|---|---|---|
| Ligand L | L201 | L202 | L203 | L204 |
| Ir-Komplex | 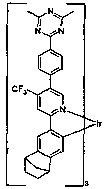 | 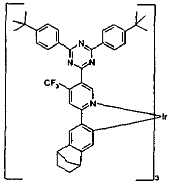 | 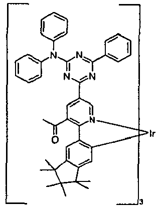 | 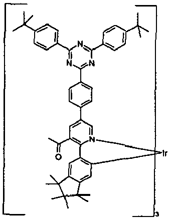 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 270 °C | 265 °C | 275 °C | 275 °C |
| Reaktionszeit | 48 h | 24 h | 24 h | 24 h |
| Suspensionsmittel | EtOH | EtOH | EtOH | EtOH |
| Extraktionsmittel | Ethylacetat | Ethylacetat | Toluol | Toluol |
| Ausbeute | 3% | 9% | *10%* | *5%* |
| | | | | |

| **Bsp.** | **Ir(L205) ₃** | **Ir(L206) ₃** | **Ir(L207)₃** | **Ir(L208)₃** |
|---|---|---|---|---|
| Ligand L | L205 | L206 | L207 | L208 |
| Ir-Komplex | 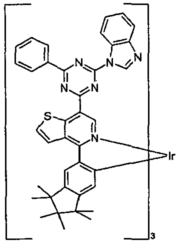 | 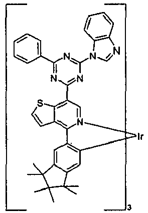 | 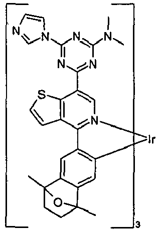 | 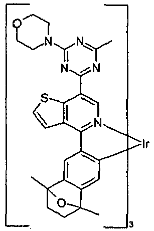 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 275 °C | 275 °C | 285 °C | 265 °C |
| Reaktionszeit | 24 h | 24 h | 48 h | 48 h |
| Suspensionsmittel | EtOH | EtOH | EtOH | EtOH |
| Extraktionsmittel | p-Dichlorbenzol | p-Dichlorbenzol | p-Dichlorbenzol | p-Xylol |
| Ausbeute | 3% | 5% | *4%* | *4%* |
| | | | | |

| **Bsp.** | **Ir(L209) ₃** | **Ir(L210)₃** | **Ir(L211)₃** | **Ir(L212)₃** |
|---|---|---|---|---|
| Ligand L | L209 | L210 | L211 | L212 |
| Ir-Komplex | 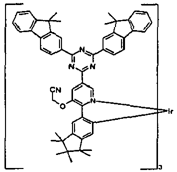 | 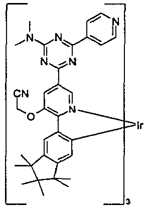 | 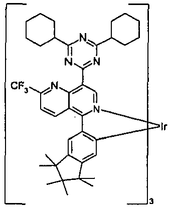 | 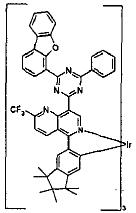 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 275 °C | 265 °C | 275 °C | 270 °C |
| Reaktionszeit | 24 h | 48 h | 48 h | 24 h |
| Suspensionsmittel | EtOH | EtOH | EtOH | EtOH |
| Extraktionsmittel | Toluol | p-Xylol | Ethylacetat | Ethylacetat |
| Ausbeute | 10% | 8% | *4%* | *7%* |

| **Bsp.** | **Ir(L213) ₃** | **Ir(L214) ₃** | **Ir(L215)₃** | **Ir(L216) ₃** |
|---|---|---|---|---|
| Ligand L | L213 | L214 | L215 | L216 |
| Ir-Komplex | 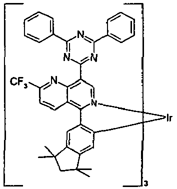 | 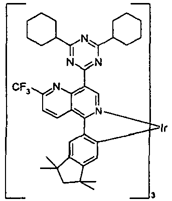 | 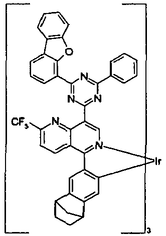 | 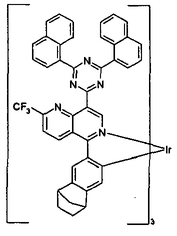 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 270 °C | 275 °C | 270 °C | 285 °C |
| Reaktionszeit | 24 h | 48 h | 24 h | 24 h |
| Suspensionsmittel | EtOH | EtOH | EtOH | EtOH |
| Extraktionsmittel | Ethylacetat | Ethylacetat | Ethylacetat | p-Dichlorbenzol |
| Ausbeute | 4% | 8% | *5%* | *3%* |
| | | | | |

| **Bsp.** | **Ir(L217)₃** | **Ir(L218) ₃** | **Ir(L219) ₃** | **Ir(L220) ₃** |
|---|---|---|---|---|
| Ligand L | L217 | L218 | L219 | L220 |
| Ir-Komplex | 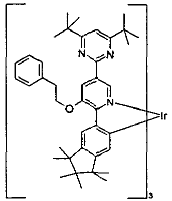 | 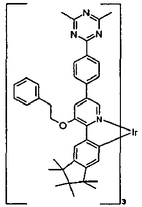 | 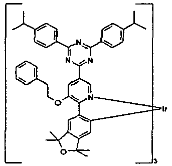 | 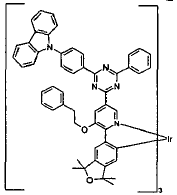 |
| Variante | A | D | A | A |
| Reaktionsmedium | --- | --- | --- | --- |
| Schmelzhilfe | --- | --- | Hydrochinon | Hydrochinon |
| Reaktionstemp. | 260 °C | 270 °C | 265 °C | 275 °C |
| Reaktionszeit | 24 h | 48 h | 24 h | 24 h |
| Suspensionsmittel | EtOH | EtOH | EtOH | EtOH |
| Extraktionsmittel | Ethylacetat | Ethylacetat | Ethylacetat | Ethylacetat |
| Ausbeute | 4% | 2% | *10%* | *12%* |

| **Bsp.** | **Ir(L221) ₃** | **Ir(L222) ₃** | **Ir(L223) ₃** | |
|---|---|---|---|---|
| Ligand L | L221 | L222 | L223 | |
| Ir-Komplex | 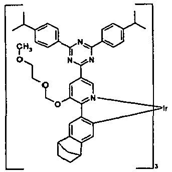 | 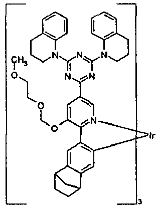 | 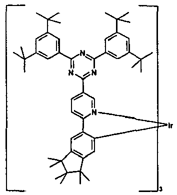 | |
| Variante | A | A | A | |
| Reaktionsmedium | --- | --- | --- | |
| Schmelzhilfe | Hydrochinon | 1-Naphthol | --- | |
| Reaktionstemp. | 265 °C | 265 °C | 275 °C | |
| Reaktionszeit | 24 h | 24 h | 24 h | |
| Suspensionsmittel | EtOH | EtOH | EtOH | |
| Extraktionsmittel | Ethylacetat | Toluol | Toluol | |
| Ausbeute | 9% | 5% | 9% | |

### Variante E:

### Schritt 1: Orthometallierung eines bromierten Liganden

Ein Gemisch aus 10 mmol Tris-acetylacetonato-iridium(III) [15635-87-7] und 40-60 mmol (bevorzugt 40 mmol) des **bromierten Liganden S1**, gegebenenfalls 1-10 g - typischerweise 3 g - eines inerten hochsiedenden Zusatzes als Schmelzhilfe bzw. Lösungsmittel, z. B. Hexadecan, m-Terphenyl, Triphenylen, Bisphenylether, 3-Phenoxy-toluol, 1,2-, 1,3-, 1,4-Bis-phenoxybenzol, Triphenylphosphinoxid, Sulfolan, 18-Krone-6, Triethylenglykol, Glycerin, Polyethylenglykole, Phenol, 1-Naphthol, Hydrochinon, etc., und ein glasummantelter Magnetrührkern werden unter Vakuum (10⁻⁵ mbar) in eine dickwandige 50 ml Glasampulle abgeschmolzen. Die Ampulle wird für die angegebene Zeit bei der angegebenen Temperatur getempert, wobei das aufgeschmolzene Gemisch mit Hilfe eines Magnetrührers gerührt wird. Um eine Sublimation der Liganden an kältere Stellen der Ampulle zu vermeiden, muss die gesamte Ampulle die angegebene Temperatur besitzen. Alternativ kann die Synthese in einem Rührautoklaven mit Glaseinsatz erfolgen. Nach Erkalten (ACHTUNG: die Ampullen stehen meist unter Druck!) wird die Ampulle geöffnet, der Sinterkuchen wird mit 100 g Glaskugeln (3 mm Durchmesser) in 100 ml eines Suspensionsmittels (das Suspensionsmittel wird so gewählt, dass der Ligand gut, der Metallkomplex jedoch schlecht darin löslich ist, typische Suspensionsmittel sind Methanol, Ethanol, Dichlormethan, Aceton, THF, Ethylacetat, Toluol, etc.) 3 h gerührt und dabei mechanisch aufgeschlossen. Man dekantiert die feine Suspension von den Glaskugeln ab, saugt den Feststoff ab, wäscht mit 50 ml des Suspensionsmittels nach und trocknet diesen im Vakuum. Der trockene Feststoff wird in einem kontinuierlichen Heißextraktor auf einem 3-5 cm hohen Alox-Bett (Alox, basisch Aktivitätsstufe 1) platziert und dann mit einem Extraktionsmittel (Vorlagemenge ca. 500 ml, das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol, halogenierte aliphatische Kohlenwasserstoffe sind in der Regel ungeeignet, da sie die Komplexe gegebenenfalls halogenieren oder zersetzen) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metallkomplexes mittels NMR und / oder HPLC bestimmt. Liegt die Reinheit unter 99.5% wird der Heißextraktionsschritt wiederholt, wobei ab der 2. Extraktion das Alox-Bett weggelassen wird. Ist eine Reinheit von 99.5 - 99.9% erreicht, wird der Metallkomplex getempert oder chromatographiert. Das Tempern erfolgt im Hochvakuum (p ca. 10⁻⁶ mbar) im Temperaturbereich von ca. 200 - 300 °C. Gut in organischen Lösungsmitteln lösliche Komplexe können alternativ auch an Kieselgel chromatograpiert werden.

Werden chirale Liganden eingesetzt, fallen die abgeleiteten fac-Metallkomplexe als Diastereomerenmischung an. Die Enantiomere Λ,Δ der Punktgruppe C3 weisen in der Regel eine deutlich geringere Löslichkeit im Extraktionsmittel auf als die Enatiomeren der Punktgruppe C1, die sich folglich in der Mutterlauge anreichern. Eine Trennung der C3- von den C1-Diasteromeren auf diesem Wege ist häufig möglich. Daneben können die Diastereomeren auch chromatographisch getrennt werden. Werden Liganden der Punktgruppe C1 enantiomerenrein eingesetzt, entsteht ein Diasteromerenpaar Λ,Δ der Punktgruppe C3. Die Diastereomeren können durch Kristallisation oder Chromatographie getrennt und damit als enantiomerenreine Verbindungen erhalten werden.

| **Bsp.** | **Ligand S** | **Ir-Komplex Diastereomer** | **Variante Reaktionsmedium Schmelzhilfe Reaktionstemp. Reaktionszeit Suspensions mittel Extraktionsmittel** | **Aus beute** |
|---|---|---|---|---|
| Ir(S1)₃ | S1 | 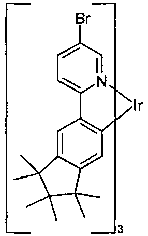 | A | 15% |
| | | | --- | |
| | | | --- | |
| | | | 270 °C | |
| | | | 24 h | |
| | | | EtOH | |
| | | | Toluol | |

### Schritt 2: Borylierung

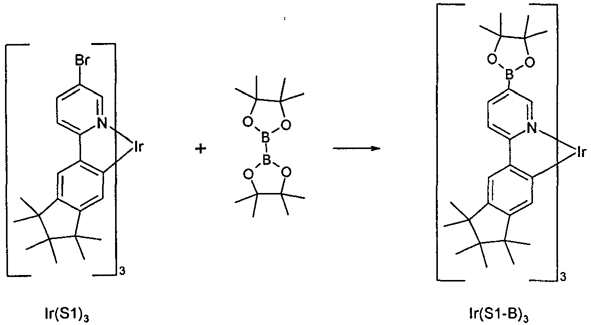

Ein Gemisch aus 12 mmol Ir(S1)₃, 40 mmol Bis(pinacolato)diboran [73183-34-3], 214 mmol Kaliumacetat [127-08-2] und 602 µmol 1,1-Bis(diphenyl-phosphino)ferrocen-dichlorpalladium(II) wird mit 300 ml 1,4-Dioxan und 300 ml Toluol versetzt und 20 h unter Rückfluss gekocht. Die Reaktionslösung wird über Celite filtriert, bis zur Trockne einrotiert und ohne weitere Aufreinigung im nächsten Schritt eingesetzt.

### Schritt 3: Suzuki-Kupplung

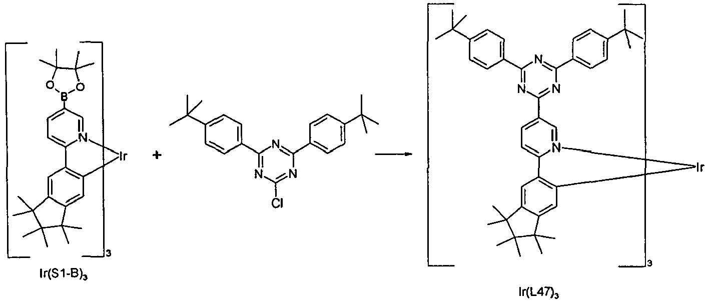

Zu 16 g (11,4 mmol) des Komplexes Ir(S1-B)₃ aus Schritt 2 werden 15,6 g (41 mmol) des Synthons [253158-13-3], 180 mg (0,8 mmol) Palladium(II)-acetat, 485 mg (1,6 mmol) Tri-o-tolylphosphin und 14,5 g (60 mmol) Kaliumphosphat gegeben und mit 500 ml Toluol, 250 ml VW-Wasser und 250 ml 1,4-Dioxan versetzt. Die Reaktionsmischung wird 72 h unter Rückfluss erhitzt. Nach Abkühlen wird über Celite filtriert und die Lösemittel im Vakuum entfernt. Der Rückstand wird gereinigt wie in Variante A beschrieben.

Unter anderem verwendbare Synthone:

| | | |
|---|---|---|
| 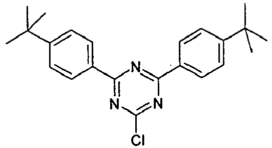 | 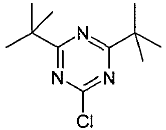 | 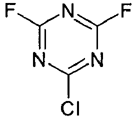 |
| 253158-13-3 | 73084-03-4 | 696-85-5 |
| 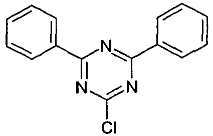 | 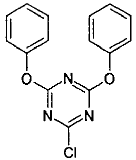 | 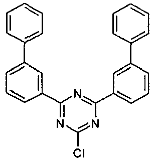 |
| 3842-55-5 | 2972-65-8 | 1205748-61-3 |
| 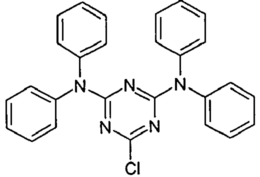 | 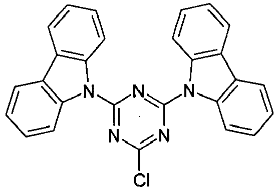 | 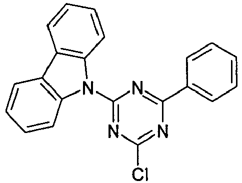 |
| 83820-01-3 | 877615-05-9 | 1268244-56-9 |
| 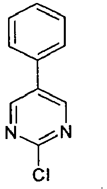 | 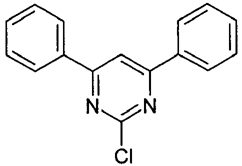 | 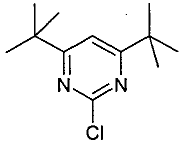 |
| 22536-62-5 | 2915-16-4 | 71162-19-1 |
| 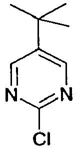 | 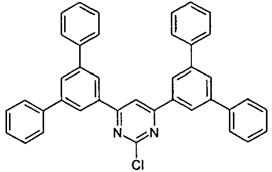 | 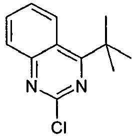 |
| 156777-81-0 | 1384480-21-0 | 1092837-92-7 |
| 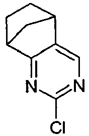 | 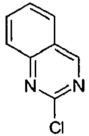 | 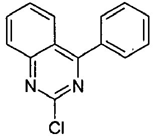 |
| 1037776-03-6 | 6141-13-5 | 529874-83-7 |
| 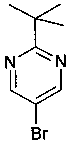 | 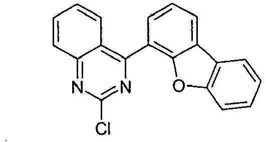 | 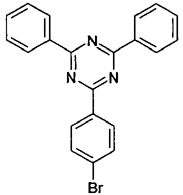 |
| 85929-94-8 | 1403252-54-9 | 23449-08-3 |
| 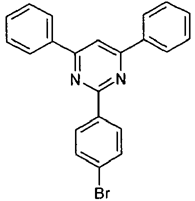 | 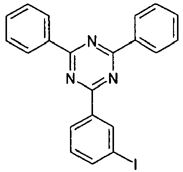 | 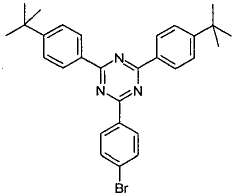 |
| 457613-56-8 | 1476799-05-9 | 927898-18-8 |

### Beispiele:

| **Bsp.** | **Ir(L47) ₃** | **Ir(L15) ₃** | **Ir(L5) ₃** | **Ir(L17) ₃** |
|---|---|---|---|---|
| Synthon CAS-Nr. | 253158-13-3 | 73084-03-4 | 696-85-5 | 3842-55-5 |
| Ir-Komplex | 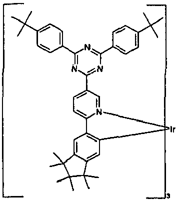 | 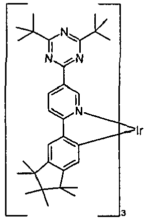 | 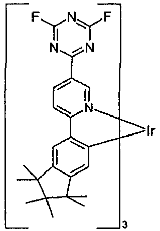 | 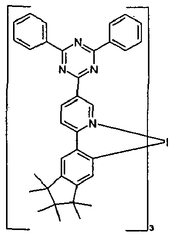 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 250 °C | 250 °C | 250 °C | 250 °C |
| Reaktionszeit | 48 h | 48 h | 48 h | 48 h |
| Suspensionsmittel | EtOH | EtOH | EtOH | EtOH |
| Extraktionsmittel | Ethylacetat | Ethylacetat | Ethylacetat | Ethylacetat |
| Ausbeute | 79% | 67% | *71%* | *80%* |
| | | | | |

| **Bsp.** | **Ir(L34) ₃** | **Ir(L74) ₃** | **Ir(L80)₃** | **Ir(L79)₃** |
|---|---|---|---|---|
| Synthon CAS-Nr. | 2972-65-8 | 1205748-61-3 | 83820-01-3 | 877615-05-9 |
| Ir-Komplex | 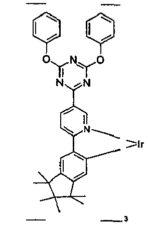 | 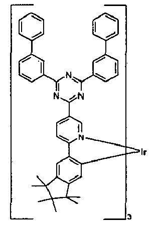 | 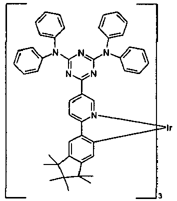 | 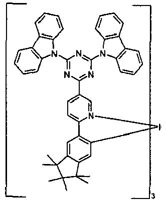 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 250 °C | 250 °C | 250 °C | 250 °C |
| Reaktionszeit | 48 h | 48 h | 48 h | 48 h |
| Suspensionsmittel | EtOH | EtOH | EtOH | EtOH |
| Extraktionsmittel | Ethylacetat | Ethylacetat | Ethylacetat | Ethylacetat |
| Ausbeute | 67% | 71% | *63%* | *70%* |
| | | | | |

| **Bsp.** | **Ir(L67) ₃** | **Ir(L1000)₃** | **Ir(L95)₃** | **Ir(L93) ₃** |
|---|---|---|---|---|
| Synthon CAS-Nr. | 1268244-56-9 | 22536-62-5 | 2915-16-4 | 71162-19-1 |
| Ir-Komplex | 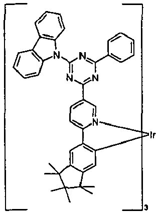 | 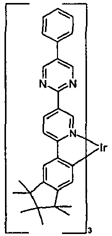 | 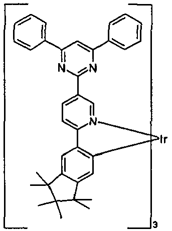 | 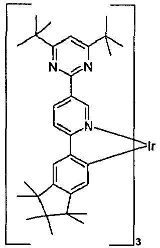 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 250 °C | 250 °C | 250 °C | 250 °C |
| Reaktionszeit | 48 h | 48 h | 48 h | 48 h |
| Suspensionsmittel | EtOH | EtOH | EtOH | EtOH |
| Extraktionsmittel | Ethylacetat | Ethylacetat | Ethylacetat | Ethylacetat |
| Ausbeute | 65% | 67% | *73%* | *81%* |
| | | | | |

| **Bsp.** | **Ir(L1001)₃** | **Ir(L1002)₃** | **Ir(L1003)₃** | **Ir(L1004)₃** |
|---|---|---|---|---|
| Synthon CAS-Nr. | 156777-81-0 | 1384480-21-0 | 1092837-92-7 | 1037776-03-6 |
| Ir-Komplex | 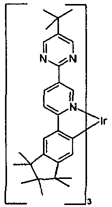 | 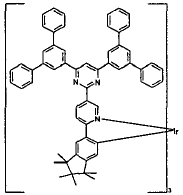 | 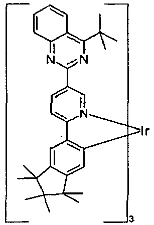 | 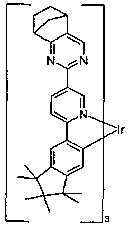 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 250 °C | 250 °C | 250 °C | 250 °C |
| Reaktionszeit | 48 h | 48 h | 48 h | 48 h |
| Suspensionsmittel | EtOH | EtOH | EtOH | EtOH |
| Extraktionsmittel | Ethylacetat | Ethylacetat | Ethylacetat | Ethylacetat |
| Ausbeute | 73% | 74% | *79%* | *73%* |
| | | | | |

| **Bsp.** | **Ir(L1005)₃** | **Ir(L1006)₃** | **Ir(L1007)₃** | **Ir(L1008) ₃** |
|---|---|---|---|---|
| Synthon CAS-Nr. | 6141-13-5 | 529874-83-7 | 85929-94-8 | 1403252-54-9 |
| Ir-Komplex | 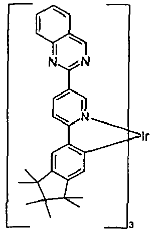 | 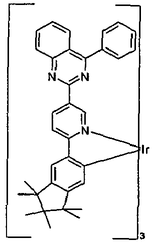 | 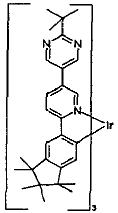 | 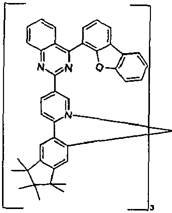 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 250 °C | 250 °C | 250 °C | 250 °C |
| Reaktionszeit | 48 h | 48 h | 48 h | 48 h |
| Suspensionsmittel | EtOH | EtOH | EtOH | EtOH |
| Extraktionsmittel | Ethylacetat | Ethylacetat | Ethylacetat | Ethylacetat |
| Ausbeute | 71% | 75% | *72%* | *73%* |
| | | | | |

| **Bsp.** | **Ir(L1009)₃** | **Ir(L1010)₃** | **Ir(L1011)₃** | **Ir(L1012)₃** |
|---|---|---|---|---|
| Synthon CAS-Nr. | 23449-08-3 | 457613-56-8 | 1476799-05-9 | 927898-18-8 |
| Ir-Komplex | 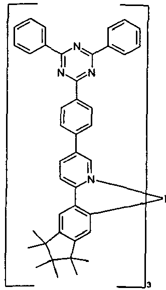 | 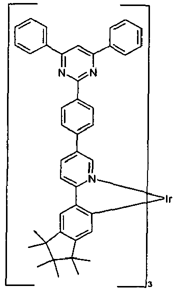 | 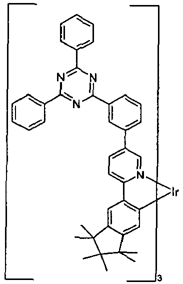 | 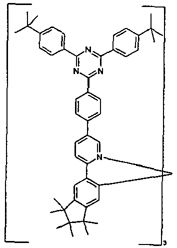 |
| Variante | A | A | A | A |
| Reaktionsmedium | --- | --- | --- | --- |
| Schmelzhilfe | Hydrochinon | Hydrochinon | Hydrochinon | Hydrochinon |
| Reaktionstemp. | 250 °C | 250 °C | 250 °C | 250 °C |
| Reaktionszeit | 48 h | 48 h | 48 h | 48 h |
| Suspensionsmittel | EtOH | EtOH | EtOH | EtOH |
| Extraktionsmittel | Ethylacetat | Ethylacetat | Ethylacetat | Ethylacetat |
| Ausbeute | 67% | 72% | *75%* | *72%* |

### 2) Heteroleptische Iridium-Komplexe:

### Variante A:

### Schritt 1:

Siehe Variante D, Schritt 1

### Schritt 2:

Das so erhaltene rohe Chloro-Dimer der Formel [Ir(L)₂Cl]₂ wird in einem Gemisch aus 75 ml 2-Ethoxyethanol und 25 ml Wasser suspendiert, mit 13 mmol des Co-Liganden CL bzw. der Co-Liganden-Verbindung CL und 15 mmol Natriumcarbonat versetzt. Nach 20 h unter Rückfluss gibt man weitere 75 ml Wasser tropfenweise zu, saugt nach Erkalten vom Feststoff ab, wäscht diesen dreimal mit je 50 ml Wasser und dreimal mit je 50 ml Methanol und trocknet diesen im Vakuum. Der trockene Feststoff wird in einem kontinuierlichen Heißextraktor auf einem 3-5 cm hohen Alox-Bett (Aluminiumoxid, basisch Aktivitätsstufe 1) platziert und dann mit dem angegebenen Extraktionsmittel (Vorlagemenge ca. 500 ml; das Extraktionsmittel wird so gewählt, dass der Komplex darin in der Hitze gut und in der Kälte schlecht löslich ist, besonders geeignete Extraktionsmittel sind Kohlenwasserstoffe wie Toluol, Xylole, Mesitylen, Naphthalin, o-Dichlorbenzol, Tetrahydrofuran, Dichlormethan, 1,2-Dichlorethan, 1,1,2,2-Tetrachlorethan, Chloroform, Tetrachlorkohlenstoff) extrahiert. Nach beendeter Extraktion wird das Extraktionsmittel im Vakuum auf wenige Millilter eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit Methanol gewaschen und getrocknet. Nach Trocknen wird die Reinheit des Metall-Komplexes mittels NMR und / oder HPLC bestimmt. Liegt die Reinheit unter 99.5 % wird der Heißextraktionsschritt wiederholt, ist eine Reinheit von 99.5 - 99.9 % erreicht, wird der Metallkomplex getempert oder sublimiert. Neben dem Heißextraktionsverfahren zur Reinigung kann die Reinigung auch chromatographisch an Kieselgel oder Alox erfolgen. Das Tempern erfolgt im Hochvakuum (p ca. 10⁻⁶ mbar) im Temperaturbereich von ca. 200 - 300 °C. Die Sublimation erfolgt im Hochvakuum (p ca. 10⁻⁶ mbar) im Temperaturbereich von ca. 300 - 400 °C, wobei die Sublimation bevorzugt in Form einer fraktionierten Sublimation durchgeführt wird.

| **Bsp.** | **Ligand L** | **Co-Ligand CL** | **Ir-Komplex** | **Aus beute** |
|---|---|---|---|---|
| | | | Reaktionstemperatur / Reaktionszeit / Suspensionsmittel / Extraktionsmittel / getempert bzw. sublimiert | |
| Ir(L47)₂(CL1) | L47 | 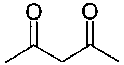 | 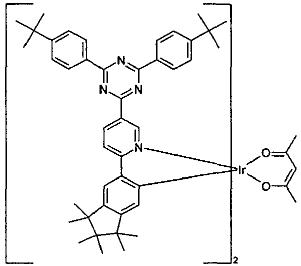 | 28% |
| | | [123-54-6] CL1 | 270 °C / 60 h / Methanol / Toluol / getempert | |

### Variante B:

Zu einer Mischung aus 10 mmol Iridium-bis(methanol)-bis[CL]-trifluormethansulfonat, 10 mmol Ligand L und 12 mmol Lutidin [108-48-5] werden 200 ml 2-Ethoxyethanol zugegeben und bei 100 °C für 72 h gerührt. Das Lösemittel wird im Vakuum entfernt und der Rückstand per Säulenchromatographie gereinigt.

| **Bsp.** | **Ligand L** | **Iridium- Precursor Ir(CL)₂(OMe)₂⁺ CF₃SO₃⁻** | **Ir-Komplex** | **Aus beute** |
|---|---|---|---|---|
| Ir(CL2)₂(L47) | L47 | 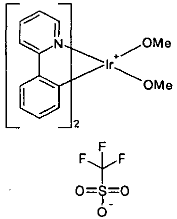 | 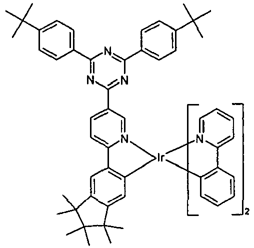 | 18% |
| | | [1215692-14-0] | | |
| Ir(CL3)₂(L47) | L47 | 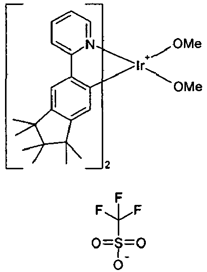 | 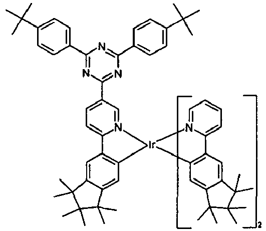 | 16% |
| | | Synthese siehe WO 2014/023377 | | |

### Device-Beispiele

### Beispiel 1: Photolumineszenz in Lösung

Die erfindungsgemäßen Komplexe können in Toluol gelöst werden. Die Kenndaten von Photolumineszenzspektren toluolischer Lösungen der Komplexe aus

Tabelle 1 sind in Tabelle 2 aufgeführt. Dabei werden Lösungen mit einer Konzentration von etwa 1 mg/ml verwendet und die optische Anregung im lokalen Absorptionsmaximum durchgeführt (bei ca. 450 nm).

**Tabelle 1: Strukturen in Photolumineszenz untersuchter erfindungsgemäßer Komplexe sowie zugehöriger Vergleichskomplexe (die Zahlen in eckigen Klammern geben die entsprechende CAS-Nummer an; die Synthese von Komplexen ohne CAS-Nummer ist in den beigefügten Patenten beschrieben)**

| | |
|---|---|
| 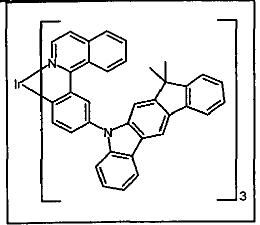 | 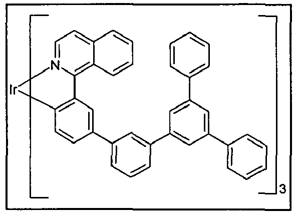 |
| [1346011-00-4] | WO 2011/032626 |
| Ref1 | Ref2 |
| 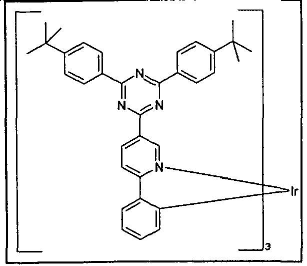 | |
| WO 2008/78800 | |
| Ref3 | |
| 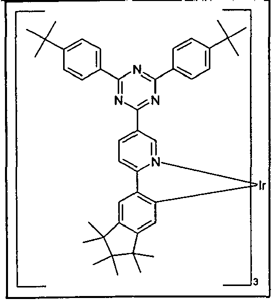 | 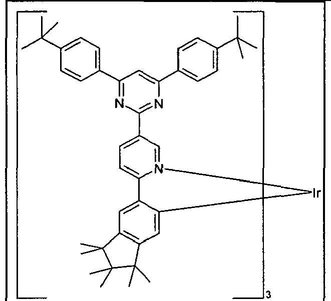 |
| Ir(L47)₃ | Ir(L96)₃ |
| 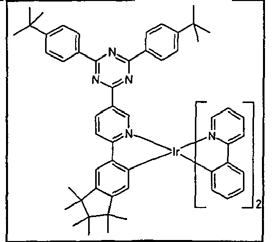 | 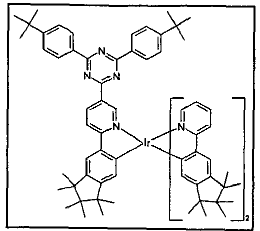 |
| Ir(CL2)₂(L47) | Ir(CL3)₂(L47) |
| 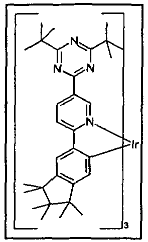 | 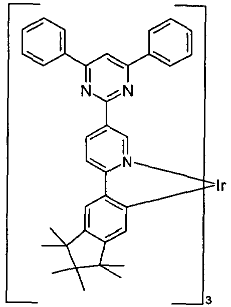 |
| Ir(L15)₃ | Ir(L95)₃ |
| 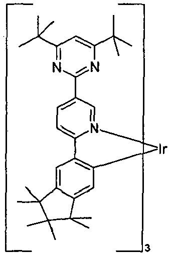 | 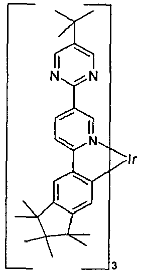 |
| Ir(L93)₃ | Ir(L1001)₃ |
| 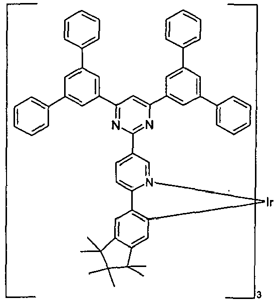 | 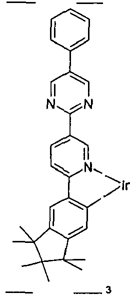 |
| Ir(L1002)₃ | Ir(L1000)₃ |
| 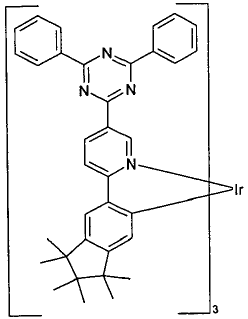 | 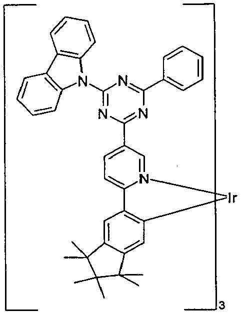 |
| Ir(L17)₃ | Ir(L67)₃ |
| 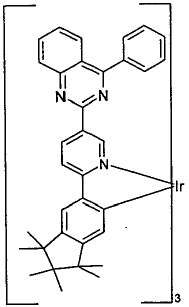 | 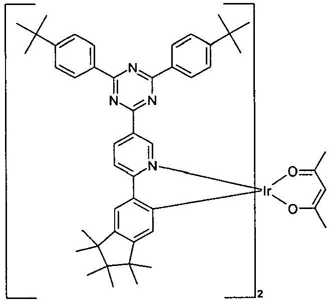 |
| Ir(L1006)₃ | Ir(L47)₂(CL1) |
| 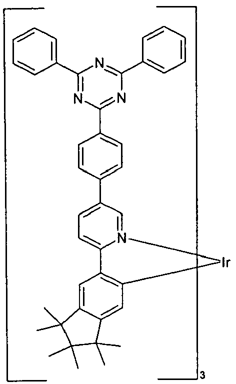 | 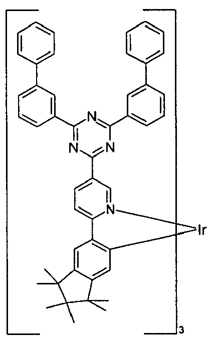 |
| Ir(L1009)₃ | Ir(74)₃ |
| 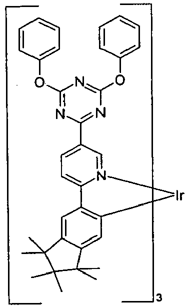 | 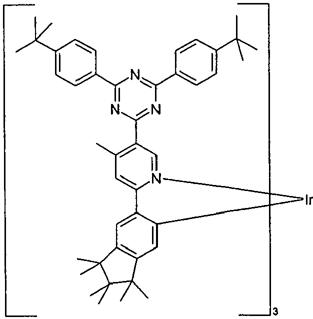 |
| Ir(34)₃ | Ir(L166)₃ |
| 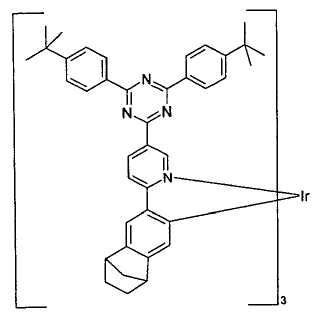 | 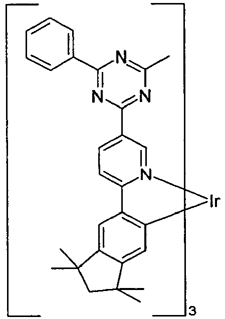 |
| Ir(L128)₃ | Ir(L100)₃ |
| 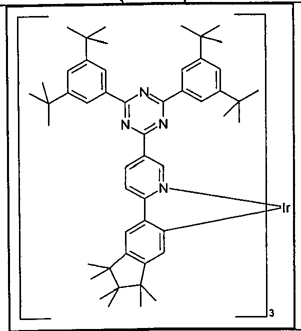 | |
| Ir(L223)₃ | |

**Tabelle 2: Photolumineszenz-Kenndaten**

| Emitter | Emission max. (nm) | FWHM (nm) | PLQE (%) |
|---|---|---|---|
| | | | |
| Ref1 | 618 | 83 | 67 |
| Ref2 | 621 | 82 | 69 |
| Ir(L47)₃ | 619 | 48 | 80 |
| Ir(L96)₃ | 586 | 43 | 88 |
| Ir(C2)₂(47) | 622 | 79 | 72 |
| Ir(CL3)₂(L47) | 635 | 86 | 61 |
| Ref3 | 596 | 65 | 82 |
| Ir(L15)₃ | 602 | 49 | 83 |
| Ir(L100)₃ | 609 | 49 | 80 |
| Ir(L95)₃ | 592 | 47 | 87 |
| Ir(L93)₃ | 567 | 45 | 87 |
| Ir(L1001)₃ | 565 | 46 | 83 |
| Ir(L1002)₃ | 594 | 48 | 86 |
| Ir(1000)₃ | 574 | 50 | 86 |
| Ir(L17)₃ | 624 | 47 | 81 |
| Ir(L67) ₃ | 633 | 53 | 76 |
| Ir(L1006)₃ | 623 | 52 | 78 |
| Ir(L47)₂(CL1) | 622 | 49 | 81 |
| Ir(L1009)₃ | 604 | 55 | 77 |
| Ir(74)₃ | 623 | 48 | 80 |
| Ir(L34) ₃ | 607 | 51 | 85 |
| Ir(L128)₃ | 619 | 47 | 81 |
| Ir(L166) ₃ | 617 | 64 | 84 |
| Ir(L223)₃ | 608 | 60 | 85 |

### Beispiel 2: Herstellung der OLEDs

Die erfindungsgemäßen Komplexe können aus Lösung verarbeitet werden und führen gegenüber vakuumprozessierten OLEDs zu wesentlich einfacher herstellbaren OLEDs mit dennoch guten Eigenschaften. Die Herstellung vollständig lösungsbasierter OLEDs ist in der Literatur bereits vielfach beschrieben, z.B. in WO 2004/037887. Die Herstellung vakuumbasierter OLEDs ist ebenfalls vielfach vorbeschrieben, u.a. in WO 2004/058911. In den im Folgenden diskutierten Beispielen werden lösungsbasiert und vakuumbasiert aufgebrachte Schichten innerhalb einer OLED kombiniert, so dass die Prozessierung bis einschließlich zur Emissionsschicht aus Lösung und in den darauffolgenden Schichten (Lochblockierschicht und Elektronentransportschicht) aus dem Vakuum erfolgt. Die vorbeschriebenen allgemeinen Verfahren werden dafür wie folgt auf die hier beschriebenen Gegebenheiten (Schichtdickenvariation, Materialien) angepasst und kombiniert. Der generelle Aufbau ist wie folgt: Substrat / ITO (50 nm) / Lochinjektionsschicht(HIL) / Lochtransportschicht (HTL) / Emissionsschicht (EML) / Lochblockierschicht (HBL) / Elektronentransportschicht (ETL) / Kathode (Aluminium, 100nm). Als Substrat dienen Glasplättchen, die mit strukturiertem ITO (Indium Zinn Oxid) der Dicke 50 nm beschichtet sind. Zur besseren Prozessierung werden diese mit PEDOT:PSS beschichtet (Poly(3,4-ethylendioxy-2,5-thiophen) : Polystyrolsulfonat, bezogen von Heraeus Precious Metals GmbH & Co. KG, Deutschland). PEDOT:PSS wird an Luft aus Wasser aufgeschleudert und nachfolgend an Luft bei 180 °C für 10 Minuten ausgeheizt, um Restwasser zu entfernen. Auf diese beschichteten Glasplättchen werden die Interlayer sowie die Emissionsschicht aufgebracht. Die verwendete Lochtransportschicht ist vernetzbar. Es wird ein Polymer gemäß der nachfolgenden abgebildeten Strukturen verwendet, das gemäß WO 2010/097155 bzw. WO 2013/156130 synthetisiert werden kann:

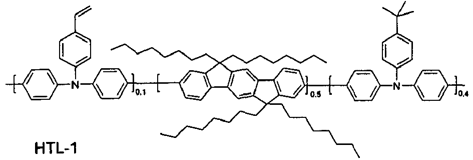

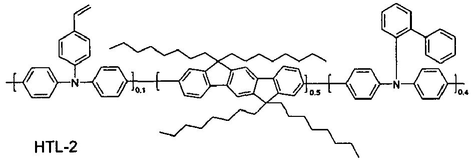

Das Lochtransport-Polymer wird in Toluol gelöst. Der typische Feststoffgehalt solcher Lösungen liegt bei ca. 5 g/l, wenn, wie hier, die für eine Device typische Schichtdicke von 20 nm mittels Spincoating erzielt werden soll. Die Schichten werden in einer Inertgasatmosphäre, im vorliegenden Fall Argon, aufgeschleudert und 60 Minuten bei 180 °C ausgeheizt.

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin aufreten können Mischungen aus mehreren Matrixmaterialien sowie Co-Dotanden. Eine Angabe wie TMM-A (92%) : Dotand (8%) bedeutet hierbei, dass das Material TMM-A in einem Gewichtsanteil von 92% und Dotand in einem Gewichtsanteil von 8% in der Emissionsschicht vorliegt. Die Mischung für die Emissionsschicht wird in Toluol oder ggf. Chlorbenzol gelöst. Der typische Feststoffgehalt solcher Lösungen liegt bei ca. 18 g/l, wenn, wie hier, die für eine Device typische Schichtdicke von 60 nm mittels Spincoating erzielt werden soll. Die Schichten werden in einer Inertgasatmosphäre, im vorliegenden Fall Argon, aufgeschleudert und 10 Minuten bei 160 °C ausgeheizt. Die im vorliegenden Fall verwendeten Materialien sind in Tabelle 3 gezeigt.

**Tabelle 3: Verwendete EML-Materialien**

| | | |
|---|---|---|
| 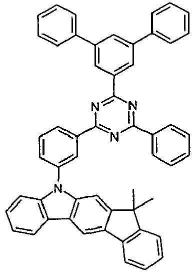 | 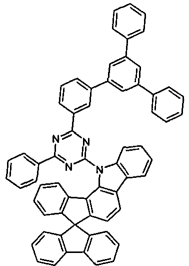 | 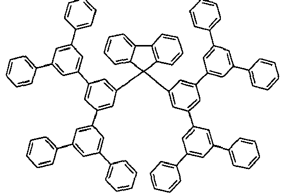 |
| A-1 | A-2 | B-1 |
| 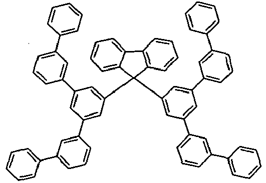 | 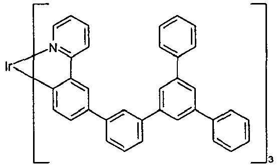 | 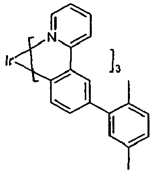 |
| B-2 | C-1 | C-2 |

Die Materialien für die Lochblockierschicht und Elektronentransportschicht werden in einer Vakuumkammer thermisch aufgedampft. Dabei kann z.B. die Elektronentransportschicht aus mehr als einem Material bestehen, die einander durch Co-Verdampfung in einem bestimmten Volumenanteil beigemischt werden. Eine Angabe wie ETM1:ETM2 (50%:50%) bedeutet hierbei, dass die Materialien ETM1 und ETM2 in einem Volumenanteil von je 50% in der Schicht vorliegen. Die im vorliegenden Fall verwendeten Materialien sind in Tabelle 4 gezeigt.

**Tabelle 4: Verwendete HBL- und ETL-Materialien**

| | |
|---|---|
| 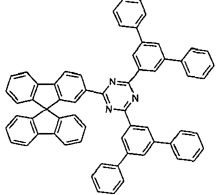 | 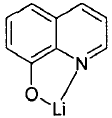 |
| ETM1 | ETM2 |

Die Kathode wird durch die thermische Verdampfung einer 100 nm Aluminiumschicht gebildet. Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'schen Abstrahlcharakteristik sowie die (Betriebs-)Lebensdauer bestimmt. Aus den IUL-Kennlinien werden Kennzahlen bestimmt wie die Betriebsspannung (in V) und die Effizienz (cd/A) bei einer bestimmten Helligkeit. Die Elektrolumineszenzspektren werden bei einer Leuchtdichte von 1000 cd/m² gemessen und daraus die CIE 1931 x und y Farbkoordinaten berechnet. Die EML-Mischungen und Aufbauten der untersuchten OLED-Bauteile sind in Tabelle 5 und Tabelle 6 dargestellt. Die zugehörigen Ergebnisse finden sich in Tabelle 7.

**Tabelle 5: EML-Mischungen der untersuchten OLED-Bauteile**

| Bsp. | Matrix A | | Co-Matrix B | | Co-Dotand C | | Dotand D | |
|---|---|---|---|---|---|---|---|---|
| | material | % | material | % | material | % | material | % |
| V-1 | A-1 | 30 | B-1 | 34 | C-1 | 30 | Ref2 | 6 |
| V-2 | A-2 | 30 | B-2 | 34 | C-1 | 30 | Ref2 | 6 |
| E-1 | A-2 | 30 | B-1 | 34 | C-1 | 30 | Ir(L96)₃ | 6 |
| E-2 | A-2 | 30 | B-2 | 34 | C-1 | 30 | Ir(L47)₃ | 6 |
| V-3 | A-2 | 39 | B-2 | 45 | C-2 | 10 | Ref1 | 6 |
| E-3 | A-2 | 39 | B-2 | 45 | C-2 | 10 | Ir(L47)₃ | 6 |
| V-4 | A-2 | 40 | B-2 | 45 | --- | --- | Ref1 | 15 |
| E-4 | A-2 | 40 | B-2 | 45 | --- | --- | Ir(L47)₃ | 15 |
| V-5 | A-1 | 40 | B-1 | 54 | --- | --- | Ref2 | 6 |
| E-5 | A-2 | 40 | B-1 | 54 | --- | --- | Ir(L96)₃ | 6 |
| V-6 | A-2 | 40 | B-2 | 55 | --- | --- | Ref3 | 5 |
| E-6 | A-2 | 40 | B-2 | 55 | --- | --- | Ir(L47)₃ | 5 |
| V-7 | A-2 | 30 | B-2 | 36 | C-1 | 30 | Ref3 | 4 |
| E-7 | A-2 | 30 | B-2 | 36 | C-1 | 30 | Ir(L47)₃ | 4 |
| E-8 | A-2 | 20 | B-2 | 70 | --- | --- | Ir(L15)₃ | 10 |
| E-9 | A-2 | 30 | B-2 | 49 | C-1 | 15 | Ir(L15)₃ | 6 |
| E-10 | A-2 | 39 | B-2 | 45 | C-1 | 10 | Ir(L93)₃ | 6 |
| E-11 | A-2 | 30 | B-2 | 49 | C-2 | 15 | Ir(L1001)₃ | 6 |
| E-12 | A-2 | 30 | B-1 | 34 | C-1 | 30 | Ir(L1002)₃ | 6 |
| E-13 | A-2 | 30 | B-2 | 36 | C-1 | 30 | Ir(L67)₃ | 4 |
| E-14 | A-2 | 40 | B-2 | 56 | --- | --- | Ir(L1006)₃ | 4 |
| E-15 | A-2 | 20 | B-2 | 70 | --- | --- | Ir(L47)₂(CL1) | 10 |
| E-16 | A-1 | 30 | B-1 | 34 | C-1 | 30 | Ir(L74)₃ | 6 |
| E-17 | A-2 | 30 | B-2 | 34 | C-1 | 30 | Ir(L166)₃ | 6 |
| E-1 8 | A-2 | 30 | B-2 | 49 | C-1 | 15 | Ir(L128)₃ | 6 |
| E-19 | A-2 | 39 | B-2 | 45 | C-1 | 10 | Ir(L100)₃ | 6 |
| E-20 | A-2 | 40 | B-2 | 45 | --- | --- | Ir(L223)₃ | 15 |

**Tabelle 6: Aufbau der untersuchten OLED-Bauteile**

| Bsp. | HIL (Dicke) | HTL (Dicke) | EML-Dicke | HBL (Dicke) | ETL (Dicke) |
|---|---|---|---|---|---|
| V-1 | PEDOT (60nm) | HTL1 (20nm) | 60nm | ETM-1 (10nm) | ETM-1 (50%) : ETM-2 (50%) (40nm) |
| V-2 | PEDOT (60nm) | HTL2 (20nm) | 60nm | ETM-1 (10nm) | ETM-1 (50%) : ETM-2 (50%) (40nm) |
| E-1 | PEDOT (60nm) | HTL2 (20nm) | 60nm | ETM-1 (10nm) | ETM-1 (50%) : ETM-2 (50%) (40nm) |
| E-2 | PEDOT (60nm) | HTL2 (20nm) | 60nm | ETM-1 (10nm) | ETM-1 (50%) : ETM-2 (50%) (40nm) |
| V-3 | PEDOT (60nm) | HTL2 (20nm) | 60nm | ETM-1 (10nm) | ETM-1 (50%): ETM-2 (50%) (40nm) |
| E-3 | PEDOT (60nm) | HTL2 (20nm) | 60nm | ETM-1 (10nm) | ETM-1 (50%) : ETM-2 (50%) (40nm) |
| V-4 | PEDOT (60nm) | HTL2 (20nm) | 60nm | ETM-1 (10nm) | ETM-1 (50%) : ETM-2 (50%) (40nm) |
| E-4 | PEDOT (60nm) | HTL2 (20nm) | 60nm | ETM-1 (10nm) | ETM-1 (50%) : ETM-2 (50%) (40nm) |
| V-5 | PEDOT (80nm) | HTL1 (20nm) | 60nm | ETM-1 (10nm) | ETM-1 (50%): ETM-2 (50%) (40nm) |
| E-5 | PEDOT (60nm) | HTL2 (20nm) | 60nm | ETM-1 (10nm) | ETM-1(50%) : ETM-2 (50%) (40nm) |
| V-6 | PEDOT (60nm) | HTL2 (20nm) | 60nm | ETM-1 (10nm) | ETM-1 (50%) : ETM-2 (50%) (40nm) |
| E-6 | PEDOT (60nm) | HTL2 (20nm) | 60nm | ETM-1 (10nm) | ETM-1 (50%) : ETM-2 (50%) (40nm) |
| V-7 | PEDOT (60nm) | HTL2 (20nm) | 60nm | ETM-1 (10nm) | ETM-1(50%) : ETM-2 (50%) (40nm) |
| E-7 | PEDOT (60nm) | HTL2 (20nm) | 60nm | ETM-1 (10nm) | ETM-1(50%) : ETM-2 (50%) (40nm) |
| E-8 | PEDOT (60nm) | HTL2 (20nm) | 60nm | ETM-1 (10nm) | ETM-1(50%) : ETM-2 (50%) (40nm) |
| E-9 | PEDOT (60nm) | HTL2 (20nm) | 60nm | ETM-1 (10nm) | ETM-1 (50%): ETM-2 (50%) (40nm) |
| E-10 | PEDOT (60nm) | HTL1 (20nm) | 60nm | ETM-1 (10nm) | ETM-1 (50%) : ETM-2 (50%) (40nm) |
| E-11 | PEDOT (60nm) | HTL2 (20nm) | 60nm | ETM-1 (10nm) | ETM-1(50%) : ETM-2 (50%) (40nm) |
| E-12 | PEDOT (60nm) | HTL2 (20nm) | 60nm | ETM-1 (10nm) | ETM-1 (50%) : ETM-2 (50%) (40nm) |
| E-13 | PEDOT (60nm) | HTL2 (20nm) | 60nm | ETM-1 (10nm) | ETM-1 (50%) : ETM-2 (50%) (40nm) |
| E-14 | PEDOT (60nm) | HTL2 (20nm) | 60nm | ETM-1 (10nm) | ETM-1 (50%) : ETM-2 (50%) (40nm) |
| E-15 | PEDOT (60nm) | HTL2 (20nm) | 60nm | ETM-1 (10nm) | ETM-1 (50%) : ETM-2 (50%) (40nm) |
| E-16 | PEDOT (60nm) | HTL1 (20nm) | 60nm | ETM-1 (10nm) | ETM-1 (50%) : ETM-2 (50%) (40nm) |
| E-17 | PEDOT (60nm) | HTL2 (20nm) | 60nm | ETM-1 (10nm) | ETM-1 (50%) : ETM-2 (50%) (40nm) |
| E-18 | PEDOT (60nm) | HTL2 (20nm) | 60nm | ETM-1 (10nm) | ETM-1(50%) : ETM-2 (50%) (40nm) |
| E-19 | PEDOT (60nm) | HTL2 (20nm) | 60nm | ETM-1 (10nm) | ETM-1(50%) : ETM-2 (50%) (40nm) |
| E-20 | PEDOT (60nm) | HTL2 (20nm) | 60nm | ETM-1 (10nm) | ETM-1(50%) : ETM-2 (50%) (40nm) |

**Tabelle 7: Ergebnisse lösungsprozessierter OLEDs (bei einer Helligkeit von 1000cd/m² gemessen)**

| Bsp. | EffL [cd/A] | U [V] | CIE x | CIE y |
|---|---|---|---|---|
| V-1 | 13.1 | 5.7 | 0.66 | 0.34 |
| V-2 | 12.7 | 6.6 | 0.65 | 0.35 |
| E-1 | 36.7 | 7.4 | 0.58 | 0.42 |
| E-2 | 17.1 | 6.7 | 0.66 | 0.34 |
| V-3 | 12.9 | 6.8 | 0.65 | 0.34 |
| E-3 | 16.8 | 6.5 | 0.66 | 0.34 |
| V-4 | 10.3 | 6.5 | 0.68 | 0.32 |
| E-4 | 13.5 | 6.2 | 0.68 | 0.32 |
| V-5 | 8.1 | 6.8 | 0.68 | 0.32 |
| E-5 | 21.8 | 7.1 | 0.59 | 0.41 |
| V-6 | 15.0 | 6.7 | 0.62 | 0.38 |
| E-6 | 13.1 | 6.4 | 0.67 | 0.33 |
| V-7 | 26.9 | 6.6 | 0.61 | 0.39 |
| E-7 | 18.7 | 6.5 | 0.65 | 0.35 |
| E-8 | 15.4 | 8.2 | 0.65 | 0.35 |
| E-9 | 26.0 | 6.7 | 0.63 | 0.37 |
| E-10 | 49.2 | 6.3 | 0.46 | 0.53 |
| E-11 | 50.8 | 6.2 | 0.46 | 0.53 |
| E-12 | 34.4 | 7.3 | 0.60 | 0.40 |
| E-13 | 8.1 | 7.7 | 0.69 | 0.30 |
| E-14 | 9.2 | 7.6 | 0.69 | 0.31 |
| E-15 | 8.5 | 7.6 | 0.69 | 0.31 |
| E-16 | 14.5 | 6.9 | 0.67 | 0.33 |
| E-17 | 17.5 | 7.3 | 0.66 | 0.34 |
| E-18 | 16.9 | 6.8 | 0.66 | 0.34 |
| E-19 | 21.1 | 6.6 | 0.65 | 0.35 |
| E-20 | 17.0 | 6.7 | 0.66 | 0.34 |

## Patentansprüche

1. Verbindung gemäß Formel (1),
[Ir(L)ₙ(L')ₘ] Formel (1)
wobei die Verbindung eine Teilstruktur Ir(L)ₙ der Formel (2) enthält: 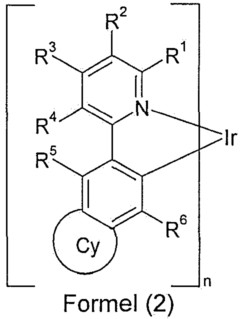 wobei für die verwendeten Symbole und Indizes gilt:
der Rest R² ist eine Gruppe der Formel -(Ar)ₚ-HetAr;
HetAr ist eine Gruppe gemäß Formel (3), 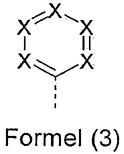 wobei die gestrichelte Bindung die Bindung an Ar bzw. für p = 0 die Bindung an die Pyridingruppe des Liganden andeutet;
X ist bei jedem Auftreten gleich oder verschieden CR oder N, mit der Maßgabe, dass mindestens eine und höchstens drei Gruppen X für N stehen;
Ar ist bei jedem Auftreten gleich oder verschieden ein aromatisches oder heteroaromatisches Ringsystem mit 5 bis 30 aromatischen Ringatomen, das mit einem oder mehreren Resten R substituiert sein kann;
p ist bei jedem Auftreten gleich oder verschieden 0 oder 1;
Cy steht bei jedem Auftreten gleich oder verschieden für eine Gruppe der Formel (4), (5), (6), (7), (8), (9) oder (10), 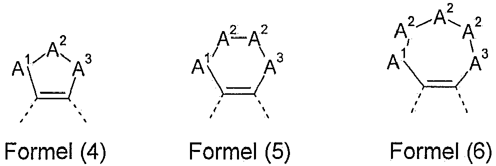 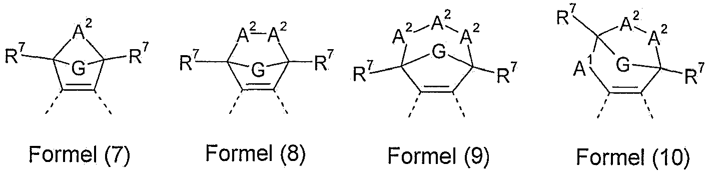
wobei die gestrichelten Bindungen die Verknüpfung der beiden Kohlenstoffatome im Liganden andeuten und weiterhin gilt:
A¹, A³ ist gleich oder verschieden bei jedem Auftreten C(R⁸)₂, O, S, NR⁸ oder C(=O);
A² ist C(R⁷)₂, O, S, NR⁸ oder C(=O);
G ist eine Alkylengruppe mit 1, 2 oder 3 C-Atomen, welche mit einem oder mehreren Resten R⁹ substituiert sein kann, -CR⁹=CR⁹- oder eine ortho-verknüpfte Arylen- oder Heteroarylengruppe mit 5 bis 14 aromatischen Ringatomen, welche durch einen oder mehrere Reste R⁹ substituiert sein kann; mit der Maßgabe, dass in diesen Gruppen nicht zwei Heteroatome direkt aneinander gebunden sind und nicht zwei Gruppen C=O direkt aneinander gebunden sind;
R, R¹, R³, R⁴, R⁵, R⁶, R⁷ ist bei jedem Auftreten gleich oder verschieden H, D, F, Cl, Br, I, N(R⁹)₂, CN, Si(R⁹)₃, B(OR⁹)₂, C(=O)R⁹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere nicht benachbarte CH₂-Gruppen durch R⁹C=CR⁹, Si(R⁹)₂, C=O, NR⁹, O, S oder CONR⁹ ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann; dabei können zwei benachbarte Reste R auch miteinander ein aliphatisches, aromatisches oder heteroaromatisches Ringsystem bilden; weiterhin können die Reste R⁴ und R⁵ auch miteinander ein aliphatisches, aromatisches oder heteroaromatisches Ringsystem bilden; weiterhin können die Reste R³ und R⁴ miteinander ein aliphatisches, aromatisches oder heteroaromatisches Ringsystem bilden, wenn die Gruppe R² für eine Gruppe der Formel -(Ar)ₚ-HetAr steht;
R⁸ ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils mit einem oder mehreren Resten R⁹ substituiert sein kann, wobei eine oder mehrere nicht benachbarte CH₂-Gruppen durch R⁹C=CR⁹, C≡C, Si(R⁹)₂, C=O, NR⁹, O, S oder CONR⁹ ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste R⁹ substituiert sein kann, oder eine Aryloxy- oder Heteroaryloxygruppe mit 5 bis 24 aromatischen Ringatomen, die durch einen oder mehrere Reste R⁹ substituiert sein kann, oder eine Aralkyl- oder Heteroaralkylgruppe mit 5 bis 24 aromatischen Ringatomen, die durch einen oder mehrere Reste R⁹ substituiert sein kann; dabei können zwei Reste R⁸, welche an dasselbe Kohlenstoffatom gebunden sind, miteinander ein aliphatisches oder aromatisches Ringsystem bilden und so ein Spirosystem aufspannen; weiterhin kann R⁸ mit einem benachbarten Rest R⁷ ein aliphatisches Ringsystem bilden;
R⁹ ist bei jedem Auftreten gleich oder verschieden H, D, F oder ein aliphatischer, aromatischer und/oder heteroaromatischer organischer Rest mit 1 bis 20 C-Atomen, insbesondere ein Kohlenwasserstoffrest, in dem auch ein oder mehrere H-Atome durch D oder F ersetzt sein können; dabei können zwei oder mehrere Substituenten R⁹ auch miteinander ein aliphatisches oder aromatisches Ringsystem bilden;
L' ist gleich oder verschieden bei jedem Auftreten ein mono- oder bidentater Ligand;
n ist 1, 2 oder 3;
m ist 0, 1, 2, 3 oder 4.

2. Verbindung nach Anspruch 1, **dadurch gekennzeichnet, dass** n = 3 ist oder dass n = 2 und m = 1 ist, wobei L' ein monoanionischer bidentater Ligand ist, der über ein Kohlenstoffatom und ein Stickstoffatom, ein Kohlenstoffatom und ein Sauerstoffatom, zwei Sauerstoffatome, zwei Stickstoffatome oder ein Sauerstoff- und ein Stickstoffatom an das Iridium koordiniert, oder dass n = 1 und m = 2 ist und L' gleich oder verschieden bei jedem Auftreten ein monoanionischer bidentater Ligand ist, der über ein Kohlenstoffatom und ein Stickstoffatom oder ein Kohlenstoffatom und ein Sauerstoffatom an das Iridium koordiniert.

3. Verbindung nach Anspruch 1 oder 2, **dadurch gekennzeichnet, dass** p = 0 ist oder dass p = 1 ist und Ar gleich oder verschieden bei jedem Auftreten ausgewählt ist aus einem aromatischen oder heteroaromatischen Ringsystem mit 6 bis 18 aromatischen Ringatomen, welches mit einem oder mehreren Resten R substituiert sein kann.

4. Verbindung nach einem oder mehreren der Ansprüche 1 bis 3, **dadurch gekennzeichnet, dass** HetAr ausgewählt ist aus den Formeln (3-1) bis (3-10), 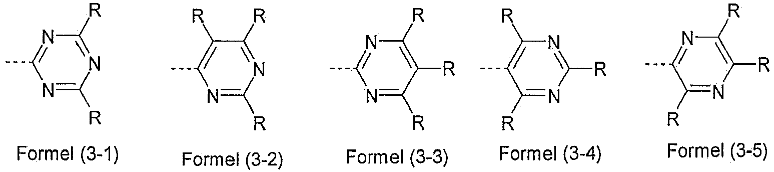 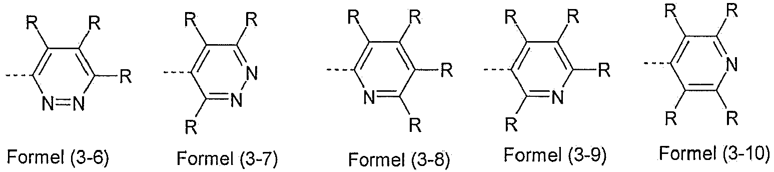 wobei die gestrichelte Bindung die Bindung an Ar oder für p = 0 an den Pyridinring darstellt und R die in Anspruch 1 genannten Bedeutungen aufweist.

5. Verbindung nach einem oder mehreren der Ansprüche 1 bis 4, **dadurch gekennzeichnet, dass** R gleich oder verschieden bei jedem Auftreten H oder ein aromatisches oder heteroaromatisches Ringsystem mit 6 bis 24 aromatischen Ringatomen ist, das durch einen oder mehrere Reste R⁹ substituiert sein kann.

6. Verbindung nach einem oder mehreren der Ansprüche 1 bis 5, **dadurch gekennzeichnet, dass** Cy ausgewählt ist aus den Strukturen den Formeln (4-A) bis (4-F), (5-A) bis (5-F), (6-A) bis (6-E), (7-A) bis (7-C), (8-A), (9-A) oder (10-A), 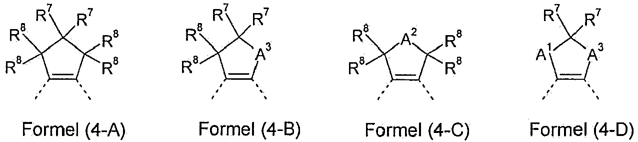 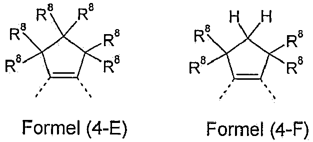 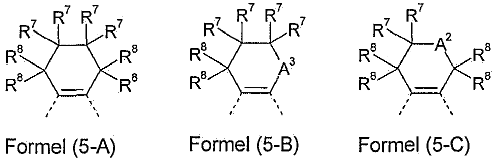 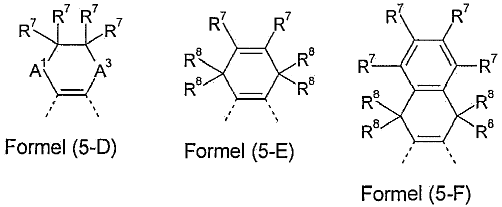 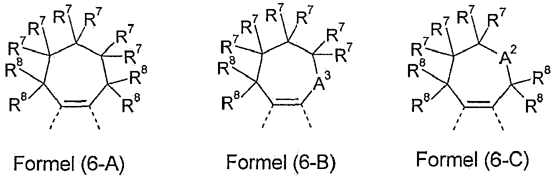 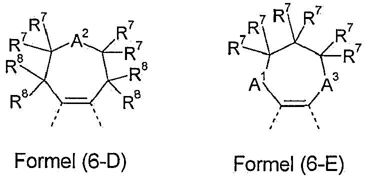 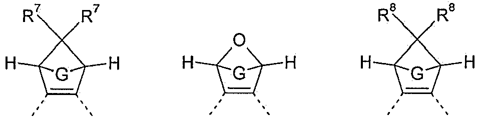 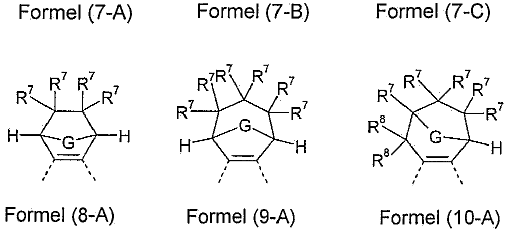 wobei R⁷ und R⁸ die in Anspruch 1 genannten Bedeutungen aufweisen und A¹, A² und A³ gleich oder verschieden bei jedem Auftreten für O oder NR⁸ steht.

7. Verbindung nach einem oder mehreren der Ansprüche 1 bis 6, **dadurch gekennzeichnet, dass** R⁸ gleich oder verschieden bei jedem Auftreten für F, eine geradkettige Alkylgruppe mit 1 bis 10 C-Atomen oder eine verzweigte oder cyclische Alkylgruppe mit 3 bis 10 C-Atomen, wobei jeweils eine oder mehrere nicht benachbarte CH₂-Gruppen durch R⁹C=CR⁹ ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R⁹ substituiert sein kann, steht; dabei können zwei Reste R⁸, welche an dasselbe Kohlenstoffatom gebunden sind, miteinander ein aliphatisches oder aromatisches Ringsystem bilden und so ein Spirosystem aufspannen; weiterhin kann R⁸ mit einem benachbarten Rest R⁷ ein aliphatisches Ringsystem bilden.

8. Verbindung nach einem oder mehreren der Ansprüche 1 bis 7, **dadurch gekennzeichnet, dass** R¹ und R³ bis R⁶ bei jedem Auftreten gleich oder verschieden ausgewählt sind aus der Gruppe bestehend aus H, D, F, N(R⁹)₂, CN, Si(R⁹)₃, C(=O)R⁹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R⁹ substituiert sein kann, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R⁹ substituiert sein kann; dabei können die Reste R⁴ und R⁵ bis auch miteinander ein aliphatisches oder aromatisches Ringsystem bilden.

9. Verbindung nach einem oder mehreren der Ansprüche 1 bis 8, **dadurch gekennzeichnet, dass** alle Substituenten R¹ und R³ bis R⁶ für H stehen.

10. Verfahren zur Herstellung einer Verbindung nach einem oder mehreren der Ansprüche 1 bis 9 durch Umsetzung der freien Liganden L und gegebenenfalls L' mit einer Iridiumverbindung.

11. Verbindung gemäß Formel (44), 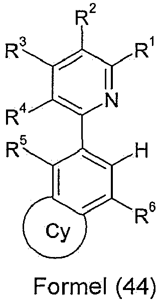 wobei die verwendeten Symbole die in Anspruch 1 genannten Bedeutungen aufweisen.

12. Formulierung, enthaltend mindestens eine Verbindung nach einem oder mehreren der Ansprüche 1 bis 9 oder 11 und mindestens ein Lösemittel und/oder eine weitere organische oder anorganische Verbindung.

13. Verwendung einer Verbindung nach einem oder mehreren der Ansprüche 1 bis 9 oder 11 in einer elektronischen Vorrichtung oder zur Erzeugung von Singulett-Sauerstoff, in der Photokatalyse oder in Sauerstoffsensoren.

14. Elektronische Vorrichtung enthaltend mindestens eine Verbindung nach einem oder mehreren der Ansprüche 1 bis 9 oder 11.

15. Elektronische Vorrichtung nach Anspruch 14, wobei es sich um eine organische Elektrolumineszenzvorrichtung handelt, **dadurch gekennzeichnet, dass** die Verbindung nach einem oder mehreren der Ansprüche 1 bis 9 als emittierende Verbindung in einer oder mehreren emittierenden Schichten eingesetzt wird oder dass die Verbindung nach Anspruch 11 in einer emittierenden Schicht oder in einer Lochblockierschicht oder in einer Elektronentransportschicht eingesetzt wird.

## Claims

1. Compound of the formula (1),
[Ir(L)ₙ(L')ₘ] formula (1)
where the compound contains a moiety Ir(L)ₙ of the formula (2): 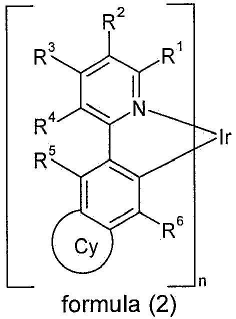 where the following applies to the symbols and indices used:
the radical R² is a group of the formula -(Ar)ₚ-HetAr;
HetAr is a group of the formula (3), 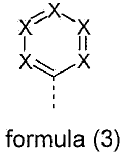 where the dashed bond indicates the bond to Ar or, for p = 0, the bond to the pyridine group of the ligand;
X is on each occurrence, identically or differently, CR or N, with the proviso that at least one and at most three groups X stand for N;
Ar is on each occurrence, identically or differently, an aromatic or heteroaromatic ring system having 5 to 30 aromatic ring atoms, which may be substituted by one or more radicals R;
p is on each occurrence, identically or differently, 0 or 1;
Cy stands on each occurrence, identically or differently, for a group of the formula (4), (5), (6), (7), (8), (9) or (10), 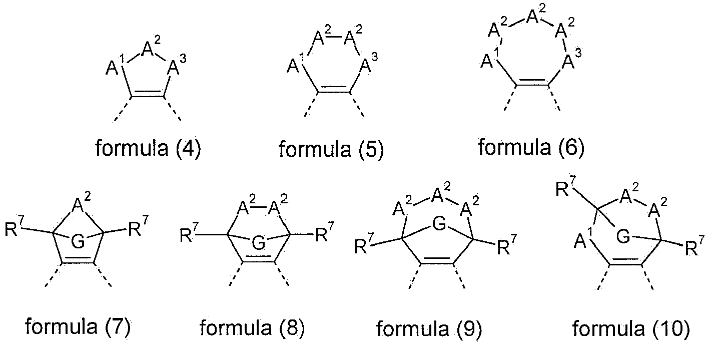
where the dashed bonds indicate the linking of the two carbon atoms in the ligand and furthermore:
A¹, A³ are, identically or differently on each occurrence, C(R⁸)₂, O, S, NR⁸ or C(=O);
A² is C(R⁷)₂, O, S, NR⁸ or C(=O);
G is an alkylene group having 1, 2 or 3 C atoms, which may be substituted by one or more radicals R⁹, or is -CR⁹=CR⁹- or an ortholinked arylene or heteroarylene group having 5 to 14 aromatic ring atoms, which may be substituted by one or more radicals R⁹; with the proviso that two heteroatoms in these groups are not bonded directly to one another and two groups C=O are not bonded directly to one another;
R, R¹, R³, R⁴, R⁵, R⁶, R⁷ are on each occurrence, identically or differently, H, D, F, Cl, Br, I, N(R⁹)₂, CN, Si(R⁹)₃, B(OR⁹)₂, C(=O)R⁹, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals R⁹, where one or more non-adjacent CH₂ groups may be replaced by R⁹C=CR⁹, Si(R⁹)₂, C=O, NR⁹, O, S or CONR⁹ and where one or more H atoms may be replaced by D, F or CN, or an aromatic or heteroaromatic ring system having 5 to 60 aromatic ring atoms, which may in each case be substituted by one or more radicals R⁹, or an aryloxy or heteroaryloxy group having 5 to 60 aromatic ring atoms, which may be substituted by one or more radicals R⁹, or a diarylamino group, diheteroarylamino group or arylheteroarylamino group having 10 to 40 aromatic ring atoms, which may be substituted by one or more radicals R⁹; two adjacent radicals R may also form an aliphatic, aromatic or heteroaromatic ring system with one another; furthermore, the radicals R⁴ and R⁵ may also form an aliphatic, aromatic or heteroaromatic ring system with one another; furthermore, the radicals R³ and R⁴ may form an aliphatic, aromatic or heteroaromatic ring system with one another if the group R² stands for a group of the formula -(Ar)ₚ-HetAr;
R⁸ is, identically or differently on each occurrence, F, a straight-chain alkyl or alkoxy group having 1 to 10 C atoms, a branched or cyclic alkyl or alkoxy group having 3 to 10 C atoms, which may in each case be substituted by one or more radicals R⁹, where one or more non-adjacent CH₂ groups may be replaced by R⁹C=CR⁹, C≡C, Si(R⁹)₂, C=O, NR⁹, O, S or CONR⁹ and where one or more H atoms may be replaced by D or F, or an aromatic or heteroaromatic ring system having 5 to 24 aromatic ring atoms, which may in each case be substituted by one or more radicals R⁹, or an aryloxy or heteroaryloxy group having 5 to 24 aromatic ring atoms, which may be substituted by one or more radicals R⁹, or an aralkyl or heteroaralkyl group having 5 to 24 aromatic ring atoms, which may be substituted by one or more radicals R⁹; two radicals R⁸ which are bonded to the same carbon atom may form an aliphatic or aromatic ring system with one another and thus form a spiro system; furthermore, R⁸ may form an aliphatic ring system with an adjacent radical R⁷;
R⁹ is on each occurrence, identically or differently, H, D, F or an aliphatic, aromatic and/or heteroaromatic organic radical having 1 to 20 C atoms, in particular a hydrocarbon radical, in which, in addition, one or more H atoms may be replaced by D or F; two or more substituents R⁹ may also form an aliphatic or aromatic ring system with one another;
L' is, identically or differently on each occurrence, a mono- or bidentate ligand;
n is 1, 2 or 3;
m is 0, 1, 2, 3 or 4.

2. Compound according to Claim 1, **characterised in that** n = 3 or **in that** n = 2 and m = 1, where L' is a monoanionic bidentate ligand which is coordinated to the iridium via one carbon atom and one nitrogen atom, one carbon atom and one oxygen atom, two oxygen atoms, two nitrogen atoms or one oxygen atom and one nitrogen atom, or **in that** n = 1 and m = 2 and L' is, identically or differently on each occurrence, a monoanionic bidentate ligand which is coordinated to the iridium via one carbon atom and one nitrogen atom or one carbon atom and one oxygen atom.

3. Compound according to Claim 1 or 2, **characterised in that** p = 0 or **in that** p = 1 and Ar is selected, identically or differently on each occurrence, from an aromatic or heteroaromatic ring system having 6 to 18 aromatic ring atoms, which may be substituted by one or more radicals R.

4. Compound according to one or more of Claims 1 to 3, **characterised in that** HetAr is selected from the formulae (3-1) to (3-10), 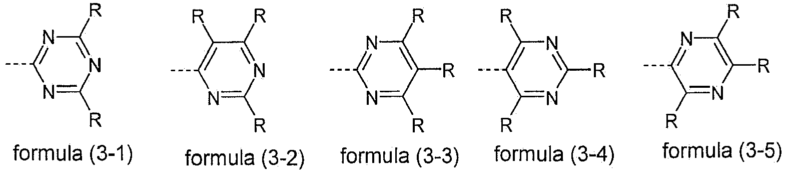 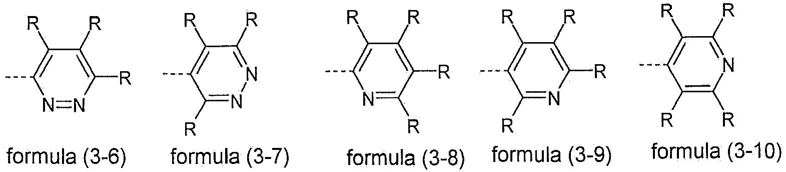 where the dashed bond represents the bond to Ar or, for p = 0, to the pyridine ring and R has the meanings given in Claim 1.

5. Compound according to one or more of Claims 1 to 4, **characterised in that** R is, identically or differently on each occurrence, H or an aromatic or heteroaromatic ring system having 6 to 24 aromatic ring atoms, which may be substituted by one or more radicals R⁹.

6. Compound according to one or more of Claims 1 to 5, **characterised in that** Cy is selected from the structures of the formulae (4-A) to (4-F), (5-A) to (5-F), (6-A) to (6-E), (7-A) to (7-C), (8-A), (9-A) or (10-A), 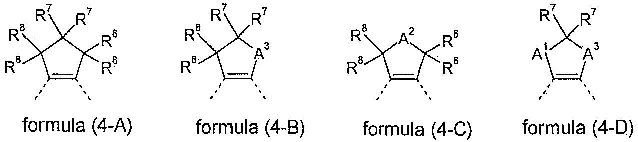 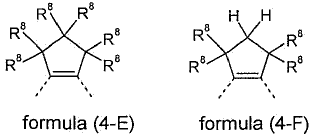 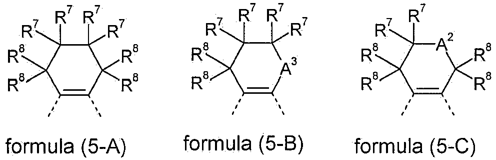 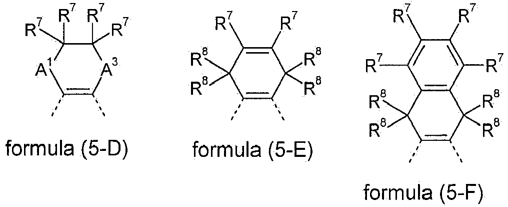 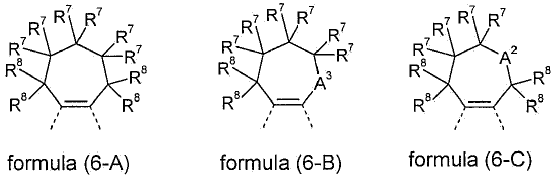 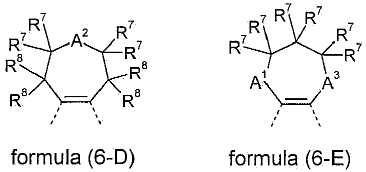 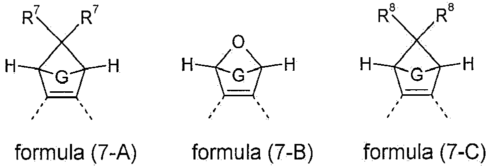 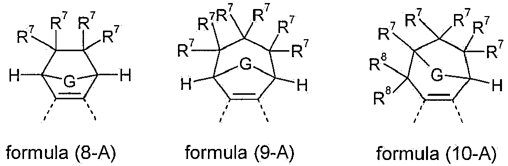 where R⁷ and R⁸ have the meanings given in Claim 1 and A¹, A² and A³ stand, identically or differently on each occurrence, for O or NR⁸.

7. Compound according to one or more of Claims 1 to 6, **characterised in that** R⁸ stands, identically or differently on each occurrence, for F, a straight-chain alkyl group having 1 to 10 C atoms or a branched or cyclic alkyl group having 3 to 10 C atoms, where in each case one or more non-adjacent CH₂ groups may be replaced by R⁹C=CR⁹ and one or more H atoms may be replaced by D or F, or an aromatic or heteroaromatic ring system having 5 to 14 aromatic ring atoms, which may in each case be substituted by one or more radicals R⁹; two radicals R⁸ which are bonded to the same carbon atom may form an aliphatic or aromatic ring system with one another and thus form a spiro system; furthermore, R⁸ may form an aliphatic ring system with an adjacent radical R⁷.

8. Compound according to one or more of Claims 1 to 7, **characterised in that** R¹ and R³ to R⁶ are selected on each occurrence, identically or differently, from the group consisting of H, D, F, N(R⁹)₂, CN, Si(R⁹)₃, C(=O)R⁹, a straight-chain alkyl group having 1 to 10 C atoms or an alkenyl group having 2 to 10 C atoms or a branched or cyclic alkyl group having 3 to 10 C atoms, which may in each case be substituted by one or more radicals R⁹, where one or more H atoms may be replaced by D or F, or an aromatic or heteroaromatic ring system having 5 to 24 aromatic ring atoms, which may in each case be substituted by one or more radicals R⁹; the radicals R⁴ and R⁵ may also form an aliphatic or aromatic ring system with one another.

9. Compound according to one or more of Claims 1 to 8, **characterised in that** all substituents R¹ and R³ to R⁶ stand for H.

10. Process for the preparation of a compound according to one or more of Claims 1 to 9 by reaction of the free ligands L and optionally L' with an iridium compound.

11. Compound of the formula (44), 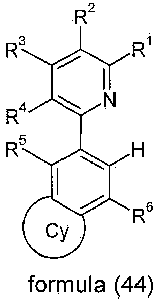 where the symbols used have the meanings given in Claim 1.

12. Formulation comprising at least one compound according to one or more of Claims 1 to 9 or 11 and at least one solvent and/or a further organic or inorganic compound.

13. Use of a compound according to one or more of Claims 1 to 9 or 11 in an electronic device or for the generation of singlet oxygen, in photocatalysis or in oxygen sensors.

14. Electronic device containing at least one compound according to one or more of Claims 1 to 9 or 11.

15. Electronic device according to Claim 14, which is an organic electroluminescent device, **characterised in that** the compound according to one or more of Claims 1 to 9 is employed as emitting compound in one or more emitting layers or **in that** the compound according to Claim 11 is employed in an emitting layer or in a hole-blocking layer or in an electron-transport layer.

## Revendications

1. Composé de la formule (1) :
[Ir(L)ₙ(L')ₘ] formule (1)
dans laquelle le composé contient une moitié Ir(L)ₙ de la formule (2) : 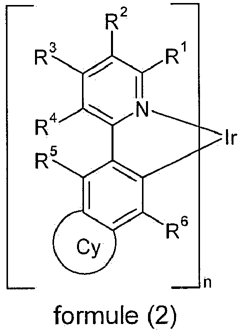 dans laquelle ce qui suit s'applique aux symboles et aux indices qui sont utilisés :
le radical R² est un groupe de la formule -(Ar)ₚ-HetAr ;
HetAr est un groupe de la formule (3) : 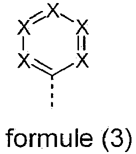 dans laquelle la liaison en pointillés indique la liaison sur Ar ou, pour p = 0, la liaison sur le groupe pyridine du ligand ;
X est pour chaque occurrence, de manière identique ou différente, CR ou N, étant entendu qu'au moins un groupe X et au plus trois groupes X représente(nt) N ;
Ar est pour chaque occurrence, de manière identique ou différente, un système de cycle aromatique ou hétéroaromatique qui comporte de 5 à 30 atomes de cycle aromatique, lequel peut être substitué par un radical ou par plusieurs radicaux R ;
p est pour chaque occurrence, de manière identique ou différente, 0 ou 1 ;
Cy représente pour chaque occurrence, de manière identique ou différente, un groupe de la formule (4), (5), (6), (7), (8), (9) ou (10) : 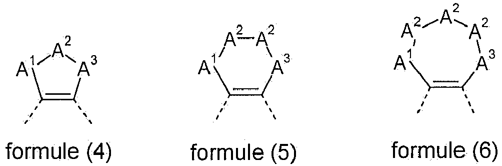 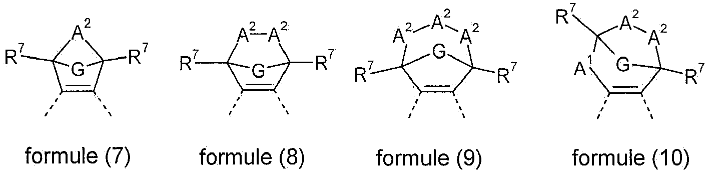
dans lesquelles les liaisons en pointillés représentent le lien des deux atomes de carbone dans le ligand et qui plus est :
A¹, A³ sont, de manière identique ou différente pour chaque occurrence, C(R⁸)₂, O, S, NR⁸ ou C(=O) ;
A² est C(R⁷)₂, O, S, NR⁸ ou C(=O) ;
G est un groupe alkylène qui comporte 1, 2 ou 3 atome(s) de C, lequel peut être substitué par un radical ou par plusieurs radicaux R⁹, ou est -CR⁹=CR⁹- ou un groupe arylène ou hétéroarylène ortho-lié qui comporte de 5 à 14 atomes de cycle aromatique, lequel peut être substitué par un radical ou par plusieurs radicaux R⁹ ; étant entendu que deux hétéroatomes dans ces groupes ne sont pas liés directement l'un à l'autre et que deux groupes C=O ne sont pas liés directement l'un à l'autre ;
R, R¹, R³, R⁴, R⁵, R⁶, R⁷ sont pour chaque occurrence, de manière identique ou différente, H, D, F, Cl, Br, I, N(R⁹)₂, CN, Si(R⁹)₃, B(OR⁹)₂, C(=O)R⁹, un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux R⁹, où un ou plusieurs groupe(s) CH₂ non adjacents peut/peuvent être remplacé(s) par R⁹C=CR⁹, Si(R⁹)₂, C=O, NR⁹, O, S ou CONR⁹ et où un ou plusieurs atome(s) de H peut/ peuvent être remplacé(s) par D, F ou CN, ou un système de cycle aromatique ou hétéroaromatique qui comporte de 5 à 60 atomes de cycle aromatique, lequel peut dans chaque cas être substitué par un radical ou par plusieurs radicaux R⁹, ou un groupe aryloxy ou hétéroaryloxy qui comporte de 5 à 60 atomes de cycle aromatique, lequel peut être substitué par un radical ou par plusieurs radicaux R⁹, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux R⁹ ; deux radicaux R adjacents peuvent également former un système de cycle aliphatique, aromatique ou hétéroaromatique l'un avec l'autre ; qui plus est, les radicaux R⁴ et R⁵ peuvent également former un système de cycle aliphatique, aromatique ou hétéroaromatique l'un avec l'autre ; qui plus est, les radicaux R³ et R⁴ peuvent également former un système de cycle aliphatique, aromatique ou hétéroaromatique l'un avec l'autre si le groupe R² représente un groupe de la formule -(Ar)ₚ-HetAr ;
R⁸ est, de manière identique ou différente pour chaque occurrence, F, un groupe alkyle ou alcoxy en chaîne droite qui comporte de 1 à 10 atome(s) de C, un groupe alkyle ou alcoxy ramifié ou cyclique qui comporte de 3 à 10 atomes de C, lequel peut dans chaque cas être substitué par un radical ou par plusieurs radicaux R⁹, où un ou plusieurs groupe(s) CH₂ non adjacents peut/peuvent être remplacé(s) par R⁹C=CR⁹, C≡C, Si(R⁹)₂, C=O, NR⁹, O, S ou CONR⁹ et où un ou plusieurs atome(s) de H peut/peuvent être remplacé(s) par D ou F, ou un système de cycle aromatique ou hétéroaromatique qui comporte de 5 à 24 atomes de cycle aromatique, lequel peut dans chaque cas être substitué par un radical ou par plusieurs radicaux R⁹, ou un groupe aryloxy ou hétéroaryloxy qui comporte de 5 à 24 atomes de cycle aromatique, lequel peut être substitué par un radical ou par plusieurs radicaux R⁹, ou un groupe aralkyle ou hétéroaralkyle qui comporte de 5 à 24 atomes de cycle aromatique, lequel peut être substitué par un radical ou par plusieurs radicaux R⁹ ; deux radicaux R⁸ qui sont liés au même atome de carbone peuvent former un système de cycle aliphatique ou aromatique l'un avec l'autre et peuvent ainsi former un système spiro ; qui plus est, R⁸ peut former un système de cycle aliphatique avec un radical R⁷ adjacent ;
R⁹ est pour chaque occurrence, de manière identique ou différente, H, D, F ou un radical organique aliphatique, aromatique et/ou hétéroaromatique qui comporte de 1 à 20 atome(s) de C, en particulier un radical hydrocarbone, où, en outre, un ou plusieurs atome(s) de H peut/peuvent être remplacé(s) par D ou F ; deux substituants R⁹ ou plus peuvent également former un système de cycle aliphatique ou aromatique l'un avec l'autre ou les uns avec les autres ; L' est, de manière identique ou différente pour chaque occurrence, un ligand mono- ou bidenté ;
n est 1, 2 ou 3 ;
m est 0, 1, 2, 3 ou 4.

2. Composé selon la revendication 1, **caractérisé en ce que** n = 3 ou **en ce que** n = 2 et m = 1, où L' est un ligand bidenté monoanionique qui est coordonné sur l'iridium via un atome de carbone et un atome d'azote, un atome de carbone et un atome d'oxygène, deux atomes d'oxygène, deux atomes d'azote ou un atome d'oxygène et un atome d'azote, ou **en ce que** n = 1 et m = 2 et L' est, de manière identique ou différente pour chaque occurrence, un ligand bidenté monoanionique qui est coordonné sur l'iridium via un atome de carbone et un atome d'azote ou un atome de carbone et un atome d'oxygène.

3. Composé selon la revendication 1 ou 2, **caractérisé en ce que** p = 0 ou **en ce que** p = 1 et Ar est sélectionné, de manière identique ou différente pour chaque occurrence, parmi un système de cycle aromatique ou hétéroaromatique qui comporte de 6 à 18 atomes de cycle aromatique, lequel peut être substitué par un radical ou par plusieurs radicaux R.

4. Composé selon une ou plusieurs des revendications 1 à 3, **caractérisé en ce que** HetAr est sélectionné parmi les formules (3-1) à (3-10) : 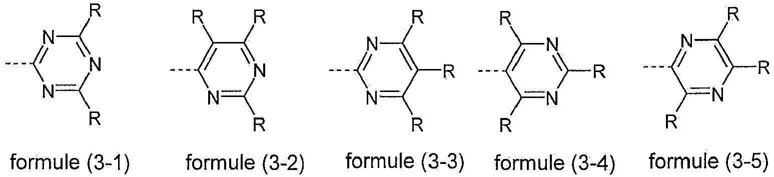 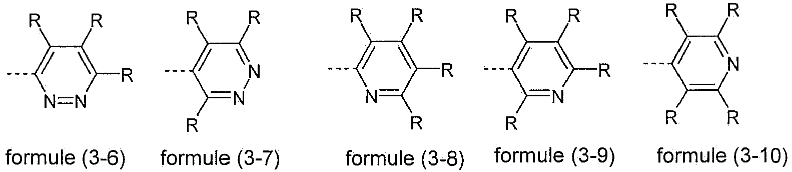 dans lesquelles la liaison en pointillés représente la liaison sur Ar ou, pour p = 0, sur le cycle pyridine et R présente les significations qui ont été données selon la revendication 1.

5. Composé selon une ou plusieurs des revendications 1 à 4, **caractérisé en ce que** R est, de manière identique ou différente pour chaque occurrence, H ou un système de cycle aromatique ou hétéroaromatique qui comporte de 6 à 24 atomes de cycle aromatique, lequel peut être substitué par un radical ou par plusieurs radicaux R⁹.

6. Composé selon une ou plusieurs des revendications 1 à 5, **caractérisé en ce que** Cy est sélectionné parmi les structures des formules (4-A) à (4-F), (5-A) à (5-F), (6-A) à (6-E), (7-A) à (7-C), (8-A), (9-A) ou (10-A) : 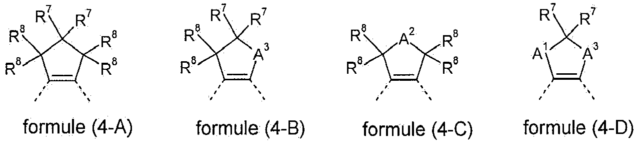 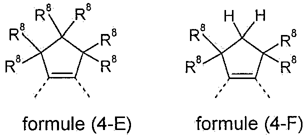 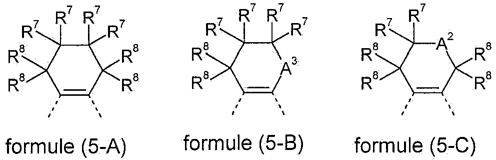 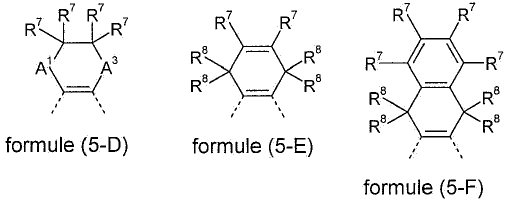 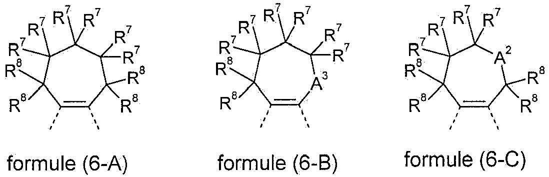 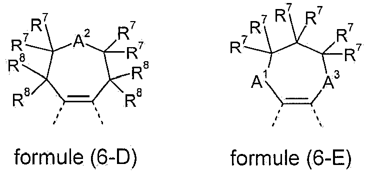 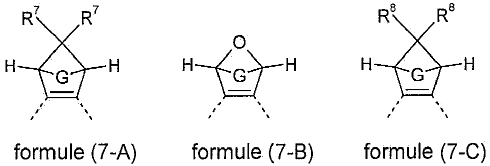 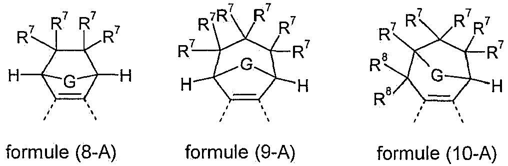 dans lesquelles R⁷ et R⁸ présentent les significations qui ont été données selon la revendication 1 et A¹, A² et A³ représentent, de manière identique ou différente pour chaque occurrence, O ou NR⁸.

7. Composé selon une ou plusieurs des revendications 1 à 6, **caractérisé en ce que** R⁸ représente, de manière identique ou différente pour chaque occurrence, F, un groupe alkyle en chaîne droite qui comporte de 1 à 10 atome(s) de C ou un groupe alkyle ramifié ou cyclique qui comporte de 3 à 10 atomes de C, où dans chaque cas, un ou plusieurs groupe(s) CH₂ non adjacents peut/peuvent être remplacé(s) par R⁹C=CR⁹ et un ou plusieurs atome(s) de H peut/peuvent être remplacé(s) par D ou F, ou un système de cycle aromatique ou hétéroaromatique qui comporte de 5 à 14 atomes de cycle aromatique, lequel peut dans chaque cas être substitué par un radical ou par plusieurs radicaux R⁹ ; deux radicaux R⁸ qui sont liés au même atome de carbone peuvent former un système de cycle aliphatique ou aromatique l'un avec l'autre et peuvent ainsi former un système spiro ; qui plus est, R⁸ peut former un système de cycle aliphatique avec un radical R⁷ adjacent.

8. Composé selon une ou plusieurs des revendications 1 à 7, **caractérisé en ce que** R¹ et R³ à R⁶ sont sélectionnés pour chaque occurrence, de manière identique ou différente, parmi le groupe qui est constitué par H, D, F, N(R⁹)₂, CN, Si(R⁹)₃, C(=O)R⁹, un groupe alkyle en chaîne droite qui comporte de 1 à 10 atome(s) de C ou un groupe alkényle qui comporte de 2 à 10 atomes de C ou un groupe alkyle ramifié ou cyclique qui comporte de 3 à 10 atomes de C, lequel peut dans chaque cas être substitué par un radical ou par plusieurs radicaux R⁹, où un ou plusieurs atome(s) de H peut/peuvent être remplacé(s) par D ou F, ou un système de cycle aromatique ou hétéroaromatique qui comporte de 5 à 24 atomes de cycle aromatique, lequel peut dans chaque cas être substitué par un radical ou par plusieurs radicaux R⁹ ; les radicaux R⁴ et R⁵ peuvent également former un système de cycle aliphatique ou aromatique l'un avec l'autre.

9. Composé selon une ou plusieurs des revendications 1 à 8, **caractérisé en ce que** tous les substituants R¹ et R³ à R⁶ représentent H.

10. Procédé pour la préparation d'un composé selon une ou plusieurs des revendications 1 à 9 par réaction des ligands libres L et en option, de L' avec un composé d'iridium.

11. Composé de la formule (44) : 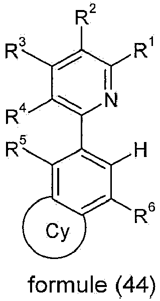 dans laquelle les symboles qui sont utilisés présentent les significations qui ont été données selon la revendication 1.

12. Formulation comprenant au moins un composé selon une ou plusieurs des revendications 1 à 9 ou 11 et au moins un solvant et/ou un autre composé organique ou inorganique.

13. Utilisation d'un composé selon une ou plusieurs des revendications 1 à 9 ou 11 dans un dispositif électronique ou pour la génération d'un oxygène singulet, lors d'une photocatalyse ou dans des capteurs d'oxygène.

14. Dispositif électronique contenant au moins un composé selon une ou plusieurs des revendications 1 à 9 ou 11.

15. Dispositif électronique selon la revendication 14, lequel est un dispositif électroluminescent organique, **caractérisé en ce que** le composé selon une ou plusieurs des revendications 1 à 9 est utilisé en tant que composé d'émission dans une ou plusieurs couche(s) d'émission ou **en ce que** le composé selon la revendication 11 est utilisé dans une couche d'émission ou dans une couche de blocage de trous ou dans une couche de transport d'électrons.
